# EUROPEAN PATENT APPLICATION

(11) **EP 4 644 992 A2**
(43) Date of publication of application: **05.11.2025**
(21) Application number: 25173075.0
(22) Date of filing: 29.04.2025
(51) Int. Cl.: G03F 7/004, G03F 7/09, G03F 7/11

(54) **COMPOSITION FOR FORMING ADHESIVE FILM, PATTERNING PROCESS, AND METHOD FOR FORMING ADHESIVE FILM**

(30) Priority: 02.05.2024 JP 2024074698
(71) Applicant: Shin-Etsu Chemical Co., Ltd., Tokyo 100-0005 (JP)
(72) Inventor: Watanabe, Mamoru, Niigata (JP); Miyazaki, Rin, Niigata (JP); Imata, Tomohiro, Niigata (JP); Tachibana, Seiichiro, Niigata (JP)
(74) Representative: Schicker, Silvia

(57) **Abstract**

The present invention is a composition for forming an adhesive film includes: (A) a resin containing a repeating unit represented by the following general formula (1) and a repeating unit having an organic sulfonyl anion structure; and (B) an organic solvent. The present invention provides: a composition for forming an adhesive film that exhibits favorable application performance even on a hydrophobic underlayer film and at the same time, yields an adhesive film having favorable pattern collapse prevention performance and ability to remove a residual resist at a bottom of a pattern; a patterning process using the composition; and a method for forming the adhesive film, in a fine patterning process of a multilayer resist method in a manufacturing process of a semiconductor apparatus.

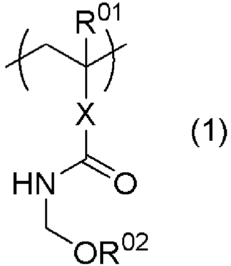

## Description

### TECHNICAL FIELD

The present invention relates to: a composition for forming an adhesive film; a patterning process using the composition for forming an adhesive film; and a method for forming an adhesive film using the composition for forming an adhesive film.

### BACKGROUND ART

As higher integration and speed are achieved in LSI, miniaturization of a pattern dimension progresses rapidly. Along with this miniaturization, lithography techniques have achieved formation of a fine pattern by shortening a wavelength of a light source and appropriately selecting a resist composition corresponding thereto. A positive photoresist composition used in a single layer has been the key to this achievement. This single-layer positive photoresist composition contains a resist resin, which has a skeleton having etching resistance against dry etching with chlorine or fluorine gas plasma and a resist mechanism to cause dissolution of an exposed portion such that the exposed portion is dissolved to form a pattern and a substrate to be processed coated with the photoresist composition is processed by dry etching while using the remaining resist pattern as an etching mask.

However, miniaturing, that is, reducing pattern width while maintaining film thickness of a photoresist film for use results in reduced resolution performance of the photoresist film, and pattern development of the photoresist film with a developer leads to a so-called high aspect ratio, resulting in pattern collapse. Therefore, reduction of the film thickness of the photoresist film progresses along with the miniaturization.

Meanwhile, commonly used for processing a substrate to be processed is a method of processing the substrate to be processed by dry etching while using a photoresist film having a formed pattern as an etching mask. However, in reality, there is no dry etching method capable of securing complete etch selectivity between the photoresist film and the substrate to be processed. Hence, the photoresist film is also damaged and collapses during processing of the substrate to be processed, making it impossible to accurately transfer a resist pattern to the substrate to be processed. Accordingly, as miniaturization of a pattern has progressed, higher dry etching resistance has become necessary for a photoresist composition. Moreover, due to shortening of an exposure wavelength, a resin used in the photoresist composition has become necessary to absorb a smaller amount of light at the exposure wavelength. Therefore, along with the changes to i-line, KrF, and ArF, the resin also has been changed to a novolac resin, polyhydroxystyrene, and a resin having an aliphatic polycyclic skeleton. However, in reality, an etch rate has been increasing under the above-described dry etching conditions, and recent photoresist compositions having high resolution tend to have rather weak etching resistance.

Accordingly, a substrate to be processed should be processed by dry etching with a thinner photoresist film having weaker etching resistance, and it has become an urgent matter to secure a material and a process for this processing step.

One of methods to solve such problems is a multilayer resist method. This method includes: interposing a resist middle layer film having different etch selectivity from that of a photoresist film (i.e. a resist upper layer film) between the resist upper layer film and a substrate to be processed; giving a pattern in the resist upper layer film, followed by transferring the pattern to the resist middle layer film by dry etching while using the resist upper layer film pattern as a dry etching mask; and further transferring the pattern to the substrate to be processed by dry etching while using the resist middle layer film as a dry etching mask.

One of the multilayer resist methods is a three-layer resist method that can be performed by using a common resist composition used in a single-layer resist method. In this three-layer resist method, for example, an organic film of novolac or the like is deposited on a substrate to be processed as a resist underlayer film; a silicon-containing film is deposited thereon as a silicon-containing resist middle layer film; and a common organic photoresist film is formed thereon as a resist upper layer film. In a case of dry etching with fluorine gas plasma, the organic resist upper layer film can have good etch selectivity to the silicon-containing resist middle layer film and thus, a resist upper layer film pattern can be transferred to the silicon-containing resist middle layer film by using dry etching with the fluorine gas plasma. Furthermore, in a case of dry etching with an oxygen or hydrogen gas, the silicon-containing resist middle layer film can have good etch selectivity to the resist underlayer film and thus, the pattern in the silicon-containing resist middle layer film can be transferred to the resist underlayer film by etching with the oxygen or hydrogen gas. According to this method, even by using a photoresist composition which makes it difficult to form a pattern having film thickness sufficient for directly processing the substrate to be processed or a photoresist composition having dry etching resistance insufficient for processing the substrate, the pattern can be transferred to the silicon-containing film (silicon-containing resist middle layer film), and the pattern having dry etching resistance sufficient for processing can be formed in the organic film (resist underlayer film) of novolac or the like.

In recent years, as a powerful technique to take the place of a combination of ArF immersion lithography and multiple exposure process, vacuum ultraviolet (EUV) lithography with a wavelength of 13.5 nm is attracting attention. The use of this technique makes it possible to form a fine pattern with a half pitch of 25 nm or less in one exposure.

Meanwhile, in EUV lithography, higher sensitivity is strongly required for a resist material to compensate for insufficient output of a light source. However, increase in shot noise along with increasing sensitivity leads to increase in edge roughness (LER, LWR) of line patterns, and how to achieve both of higher sensitivity and low edge roughness is considered as one of important problems in EUV lithography.

As an attempt to increase sensitivity of a resist material and reduce the influence of shot noise, the use of a metal material in the resist material has recently been considered. A compound containing a metallic element such as barium, titanium, hafnium, zirconium, and tin has a higher absorbance of EUV light as compared with an organic material containing no metal, so that enhanced photosensitivity of a resist and suppression of the influence of shot noise can be expected. Furthermore, a metal-containing resist pattern in combination with a resist underlayer film made of a non-metal material is expected to achieve an etching process with high selectivity.

For example, a resist material with a metal salt or an organometallic complex added thereto (Patent Documents 1 and 2), and a non-chemically amplified resist material that uses nanoparticles of metal oxide (Patent Documents 3 and 4, Non Patent Document 1) have been considered. However, resolution of these metal-containing resists has not yet reached the level to be necessary for practical use, and further improvement in the resolution is required.

Furthermore, formation of a finer pattern is becoming possible due to the advent of ArF immersion lithography, EUV lithography, etc., while a small contact area of an ultrafine pattern quite easily causes collapse and prevention of pattern collapse is a very big problem. Meanwhile, a residual resist at a bottom of a pattern caused by insufficient output from a light source has come to adversely affect the process.

The difficulty in patterning increases due to the miniaturization. At the same time, as a structure of a semiconductor device becomes more complex, a manufacturing process thereof also becomes diverse, which leads to necessity to perform lithography on various underlayer films. For the purpose of pattern adhesion and removal of a residue at a bottom of a pattern, attempts have been made to form a resist adhesive film directly under a resist upper layer film. However, formation of the adhesive film itself is difficult especially when the underlayer film is highly hydrophobic.

In order to prevent pattern collapse, materials have been reported that improve adhesiveness to a resist upper layer film by using a resist underlayer film containing a polar functional group such as lactone and urea structures (Patent Documents 4 and 5); or examples of improvement of rectangularity of a resist pattern have been reported (Patent Documents 6 and 7). However, a film cannot be formed from these materials on a hydrophobic underlayer film, or even if a film can be formed, collapse prevention performance and ability to remove a residual resist at a bottom of a pattern are insufficient.

### CITATION LIST

### PATENT LITERATURE

Patent Document 1: JP 5708521 B2
Patent Document 2: JP 5708522 B2
Patent Document 3: US 9310684 B2
Patent Document 4: WO 2003/017002 A1
Patent Document 5: WO 2018/143359 A1
Patent Document 6: JP 2023-094359 A
Patent Document 7: JP 2024-027459 A

### NON PATENT LITERATURE

Non Patent Document 1: Proc. SPIE Vol. 7969, 796915 (2011)

### SUMMARY OF INVENTION

### TECHNICAL PROBLEM

The present invention has been made in view of the above circumstances, and aims to provide: a composition for forming an adhesive film provides an adhesive film that in a fine patterning process of a multilayer resist method in a manufacturing process of a semiconductor apparatus exhibits favorable application performance even on a hydrophobic underlayer film and at the same time, having favorable pattern collapse prevention performance and ability to remove a residual resist at a bottom of a pattern; a patterning process using the composition; and a method for forming the adhesive film.

### SOLUTION TO PROBLEM

To achieve the object, the present invention provides a composition for forming an adhesive film, including:
(A) a resin containing a repeating unit represented by the following general formula (1) and a repeating unit having an organic sulfonyl anion structure; and
(B) an organic solvent, 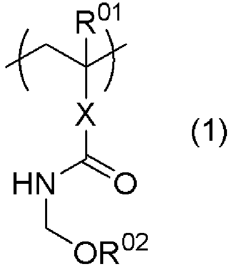 wherein X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.

With such composition for forming an adhesive film, it is possible to secure favorable application performance even on a hydrophobic underlayer film, and remove a residue at a bottom of a resist without increasing pattern roughness.

Further in the present invention, a proportion of the repeating unit represented by the general formula (1) is preferably 70 mol% or more and 99.9 mol% or less relative to whole repeating units in the resin (A).

Further in the present invention, a proportion of the repeating unit having the organic sulfonyl anion structure is preferably 0.1 mol% or more and 30 mol% or less relative to whole repeating units in the resin (A).

With such composition for forming an adhesive film, it is possible to secure favorable application performance on various underlayer films, and remove a residue at a bottom of a resist without increasing pattern roughness.

Further in the present invention, the resin (A) preferably has a weight average molecular weight of 1,000 to 70,000.

Such composition for forming an adhesive film has excellent film formability, and can reduce generation of a sublimate during heat curing, thereby preventing the sublimate from contaminating an apparatus.

Further in the present invention, the organic solvent (B) is preferably a mixture of one or more kinds of organic solvents having a boiling point of lower than 150°C and one or more kinds of organic solvents having a boiling point of 150°C or higher and lower than 220°C.

Such composition for forming an adhesive film has sufficient solubility in a solvent, such that occurrence of application defects can be reduced.

Additionally, the present invention preferably further includes at least one or more selected from (C) a thermal acid generator, (D) a surfactant, and (E) a crosslinking agent.

The presence/absence or selection of these various additives enables fine adjustment of performance including film formability, filling properties, optical properties, reduction of sublimates, etc. according to customer requirements, thereby offering practical advantages.

Additionally, the present invention provides a patterning process for forming a pattern in a substrate to be processed, including the steps of:
(I-1) applying the above-described composition for forming an adhesive film on the substrate to be processed and thereafter performing heat treatment to form an adhesive film;
(I-2) forming a resist upper layer film on the adhesive film using a photoresist material;
(I-3) forming a circuit pattern in the resist upper layer film by developing the resist upper layer film using a developer after pattern exposure;
(I-4) transferring a pattern to the adhesive film by dry etching while using the resist upper layer film having the formed circuit pattern as a mask; and
(I-5) processing the substrate to be processed while using the resist upper layer film and/or the adhesive film having the formed pattern as a mask to form a pattern in the substrate to be processed.

Additionally, the present invention provides a patterning process for forming a pattern in a substrate to be processed, including the steps of:
(II-1) forming a resist underlayer film on the substrate to be processed;
(II-2) forming a silicon-containing resist middle layer film on the resist underlayer film;
(II-3) applying the above-described composition for forming an adhesive film on the silicon-containing resist middle layer film and thereafter performing heat treatment to form an adhesive film;
(II-4) forming a resist upper layer film on the adhesive film using a photoresist material;
(II-5) forming a circuit pattern in the resist upper layer film by developing the resist upper layer film using a developer after pattern exposure;
(II-6) transferring a pattern to the adhesive film by dry etching while using the resist upper layer film having the formed circuit pattern as a mask;
(II-7) transferring a pattern to the silicon-containing resist middle layer film by dry etching while using the resist upper layer film and/or the adhesive film having the formed pattern as a mask;
(II-8) transferring a pattern to the resist underlayer film by dry etching while using the silicon-containing resist middle layer film having the transferred pattern as a mask; and
(II-9) processing the substrate to be processed while using the resist underlayer film having the transferred pattern as a mask to form a pattern in the substrate to be processed.

Additionally, the present invention provides a patterning process for forming a pattern in a substrate to be processed, including the steps of:
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the above-described composition for forming an adhesive film on the inorganic hard mask middle layer film and thereafter performing heat treatment to form an adhesive film;
(III-4) forming a resist upper layer film on the adhesive film using a photoresist material;
(III-5) forming a circuit pattern in the resist upper layer film by developing the resist upper layer film using a developer after pattern exposure;
(III-6) transferring a pattern to the adhesive film by dry etching while using the resist upper layer film having the formed circuit pattern as a mask;
(III-7) transferring a pattern to the inorganic hard mask middle layer film by dry etching while using the resist upper layer film and/or the adhesive film having the formed pattern as a mask;
(III-8) transferring a pattern to the resist underlayer film by dry etching while using the inorganic hard mask middle layer film having the transferred pattern as a mask; and
(III-9) processing the substrate to be processed while using the resist underlayer film having the transferred pattern as a mask to form a pattern in the substrate to be processed.

In this manner, the inventive composition for forming an adhesive film can suitably be used for various patterning processes such as a two-layer resist process, and a four-layer resist process in which the adhesive film is formed on a silicon-containing middle layer film (silicon-containing resist middle layer film, inorganic hard mask middle layer film). These patterning processes are suitable for photolithography of a resist upper layer film.

In this aspect, the inorganic hard mask middle layer film is preferably formed by a CVD or ALD method.

Further in the present invention, the circuit pattern is preferably formed in the resist upper layer film by using photolithography with a wavelength of 10 nm or more and 300 nm or less, direct drawing using an electron beam, nanoimprinting, or a combination thereof.

Further in the present invention, the photoresist material more preferably contains at least an organometallic compound and a solvent.

Further in the present invention, the developing is preferably performed by alkaline development or development with an organic solvent.

In the present invention, the use of the patterning process as described above enables favorable and efficient formation of a pattern.

Further in the present invention, the substrate to be processed is preferably a semiconductor apparatus substrate or the semiconductor apparatus substrate coated with any of a metal film, a metal carbide film, a metal oxide film, a metal nitride film, a metal oxycarbide film, and a metal oxynitride film.

In this aspect, the metal is preferably silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

The patterning process of the present invention is capable of processing the substrate to be processed as described above in the above-described manner to form a pattern.

Additionally, the present invention provides a method for forming an adhesive film to be used in a manufacturing process of a semiconductor apparatus, the method includes: spin-coating a substrate to be processed with the above-described composition for forming an adhesive film; and forming an adhesive film by heating the substrate coated with the composition for forming an adhesive film at a temperature of 100°C or higher and 300°C or lower for 10 to 600 seconds.

Additionally, the present invention provides a method for forming an adhesive film to be used in a manufacturing process of a semiconductor apparatus, the method includes: spin-coating a substrate to be processed with the above-described composition for forming an adhesive film; and forming an adhesive film by heating the substrate coated with the composition for forming an adhesive film under an atmosphere with an oxygen concentration of 0.1% or more and 21% or less.

Such method can facilitate a crosslinking reaction during forming an adhesive film and suppress mixing with a resist upper layer film at a higher level. Moreover, by appropriately controlling the temperature, time, and oxygen concentration of the heat treatment within the above range, it is possible to obtain a prevention effect on collapse of an adhesive film pattern appropriate for the intended use, as well as a property of adjusting a pattern profile of the resist upper layer film.

Additionally, the present invention provides a method for forming an adhesive film to be used in a manufacturing process of a semiconductor apparatus, the method includes: spin-coating a substrate to be processed with the above-described composition for forming an adhesive film; and forming an adhesive film by heating the substrate coated with the composition for forming an adhesive film under an atmosphere with an oxygen concentration of 0.0001% or more and less than 0.1%.

Such method is useful because it can facilitate a crosslinking reaction during forming an adhesive film and suppress intermixing with an upper layer film at a higher level with no deterioration of a substrate to be processed even when the substrate to be processed contains a material which becomes unstable during heating under an oxygen atmosphere.

### ADVANTAGEOUS EFFECTS OF INVENTION

As described above, the present invention can provide a composition for forming an adhesive film that has favorable application performance on various underlayer films. Moreover, this composition for forming an adhesive film enables to remove a residue at a bottom of a resist with no deterioration of roughness of a resist pattern, so that the composition is extremely useful for multilayer resist processes, for example, a four-layer resist process in which the adhesive film is formed on a silicon-containing resist middle layer film. Further, the inventive method for forming an adhesive film can form an adhesive film that sufficiently cures on a substrate to be processed and has high adhesiveness to a resist upper layer film. Yet further, the inventive patterning process can form a fine pattern in a substrate to be processed with high precision in a multilayer resist process.

### BRIEF DESCRIPTION OF DRAWINGS

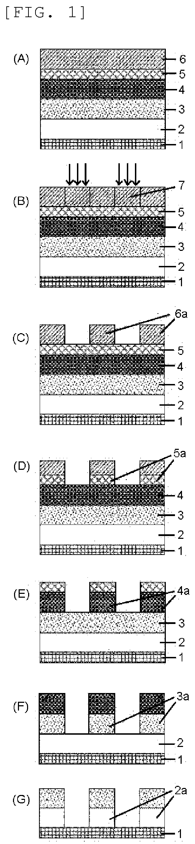

FIG. 1 is a diagram illustrating a patterning process with a four-layer resist process according to an embodiment of the present invention.

### DESCRIPTION OF EMBODIMENTS

In the present description, when an element is described as being "directly under" another element, the element is in direct contact with another element with no intervening element. On the contrary, when an element is described as being "under" another element, there may be an intervening element between them. Similarly, when an element is described as being "directly on" another element, the element is in direct contact with another element with no intervening element. When an element is described as being "on" another element, there may be an intervening element between them.

As described above, in a fine patterning process of a multilayer resist method in a manufacturing process of a semiconductor apparatus, there have been needs for a composition for forming an adhesive film that has favorable application performance on various underlayer films and enables to remove a residue at a bottom of a resist with no deterioration of roughness of a resist pattern, a patterning process using the composition, and a method for forming an adhesive film.

As a result of intensive investigation on the above problem, the present inventors have found that the above problem can be solved by a composition for forming an adhesive film including a resin having a particular structure, a patterning process using this composition for forming an adhesive film, and a method for forming an adhesive film using this composition for forming an adhesive film, and completed the present invention.

Thus, the present invention is a composition for forming an adhesive film, including:
(A) a resin containing a repeating unit represented by the following general formula (1) and a repeating unit having an organic sulfonyl anion structure; and
(B) an organic solvent, 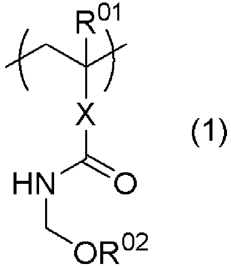
wherein X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.

Hereinafter, the present invention will be described in detail. However, the present invention is not limited thereto.

### [Composition for Forming Adhesive Film]

The present invention provides a composition for forming an adhesive film, including: (A) a resin containing a repeating unit represented by the following general formula (1) and a repeating unit having an organic sulfonyl anion structure; and (B) an organic solvent.

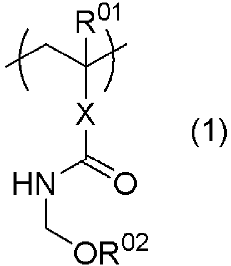

In the formula, X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.

Note that in the composition for forming an adhesive film of the present invention, the resin (A) can be used alone or in combination of two or more kinds thereof. Furthermore, the above-described composition for forming an adhesive film may include other components in addition to the above components (A) and (B). Hereinafter, each component will be described.

### [(A) Resin]

The resin (A) included in the composition for forming an adhesive film of the present invention contains a repeating unit represented by the following general formula (1) and a repeating unit having an organic sulfonyl anion structure.

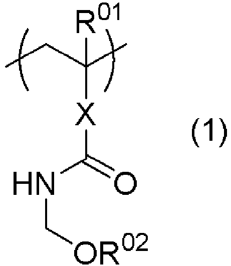

In the formula, X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.

The structural unit represented by the above general formula (1) functions as a crosslinking group and an adhesive group to an underlayer. A nitrogen-hydrogen bond serving as a hydrogen bond donor is contained, which efficiently forms a hydrogen bond even on a hydrophobic underlayer film, thereby suppressing occurrence of an application error. On the other hand, this structural unit itself has a crosslinking property, so that a curing property of a film will not be impaired even by introducing a large number of this structural units into the resin.

In the above general formula (1), X represents a single bond or an aromatic ring having 20 or less carbon atoms. X preferably represents a single bond, a benzene ring, or a naphthalene ring. The structure having a relatively small molecular weight as described above leads to the increased number of the hydrogen bond donors per unit molecular weight and excellent application performance on a hydrophobic surface.

In the above general formula (1), R⁰¹ represents a hydrogen atom or a methyl group. However, when X represents an aromatic ring, R⁰¹ preferably represents a hydrogen atom from the viewpoint of polymerization reactivity at the time of raw material synthesis. When X represents a single bond, the polymerization reactivity is sufficient at the time of raw material synthesis regardless of whether R⁰¹ represents a hydrogen atom or a methyl group, and selection of this structure enables to suitably control the polymerization reactivity.

In the above general formula (1), R⁰² represents a hydrogen atom or a monovalent alkyl group having 1 to 10 carbon atoms, and when R⁰² represents an alkyl group, a hydrogen atom constituting the alkyl group is optionally substituted with a hydroxy group. R⁰² preferably represents a hydrogen atom or a linear or branched alkyl group having 1 to 6 carbon atoms, and more preferably represents a hydrogen atom or a linear or branched alkyl group having 1 to 4 carbon atoms.

Specific examples of R⁰² in the above general formula (1) include a methyl group, an ethyl group, an n-propyl group, an isopropyl group, an n-butyl group, a sec-butyl group, a tert-butyl group, an n-pentyl group, a neopentyl group, an n-hexyl group, an n-heptyl group, an n-octyl group, an n-nonyl group, an n-decyl group, a cyclopentyl group, a cyclohexyl group, and organic groups in which a hydrogen atom constituting these alkyl groups is substituted with a hydroxy group.

In the above general formula (1), the OR⁰² structure undergoes an elimination reaction during baking to generate a carbocation. This carbocation reacts with other structures and is bonded thereto, thereby proceeding the crosslinking. By making R⁰² a structure having a small molecular weight, shrinking of a film during baking can be reduced, which in turn can prevent occurrence of an application error during baking. On the other hand, when R⁰² is a structure having a large molecular weight, a bulky structure of the resin leads to an increased viscosity of the resin during application, which can prevent occurrence of an application error during spin-drying. Form the viewpoint of easy occurrence of the application error during these spin-drying and baking, R⁰² preferably represents a hydrogen atom or a linear or branched alkyl group having 1 to 6 carbon atoms, and more preferably represents a hydrogen atom or a linear or branched alkyl group having 1 to 4 carbon atoms.

Specific examples of the repeating unit represented by the above general formula (1) preferably include the following structures. R⁰¹ is as defined above.

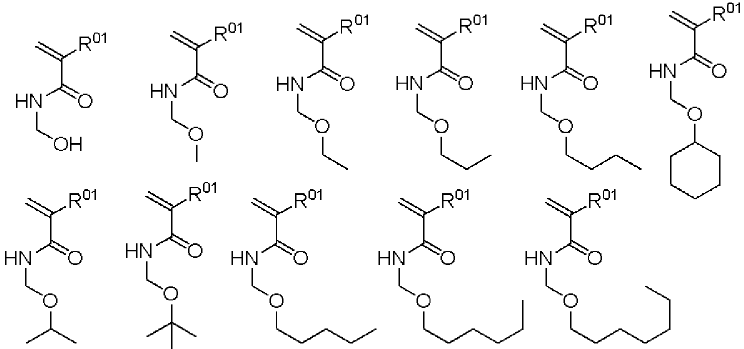

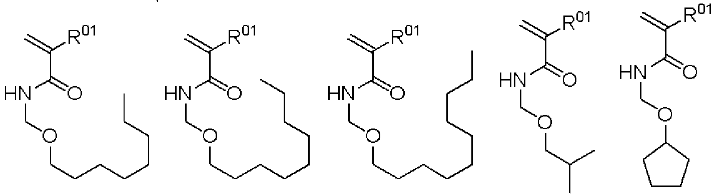

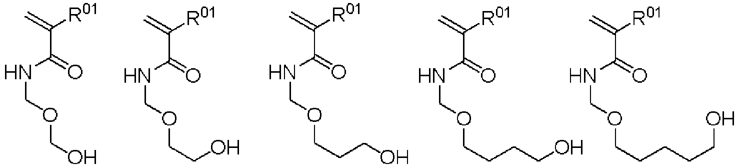

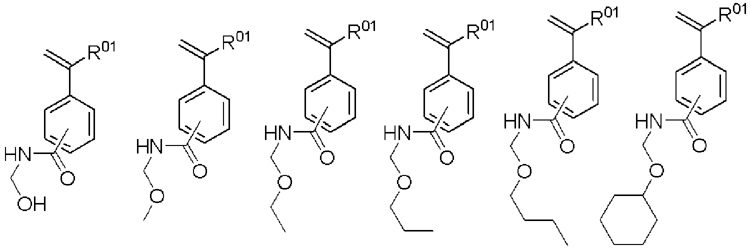

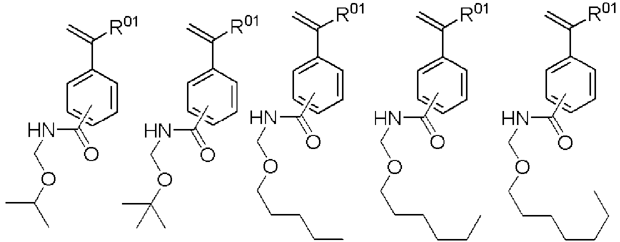

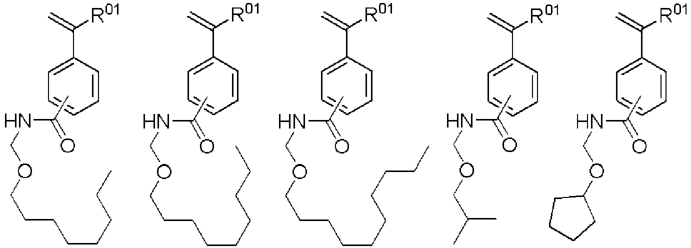

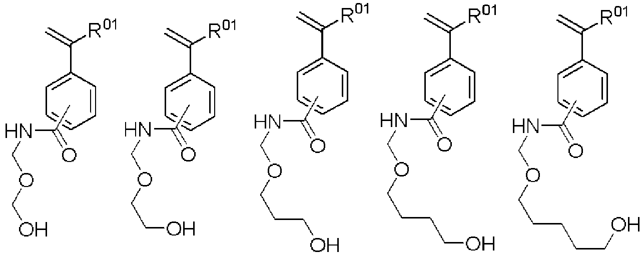

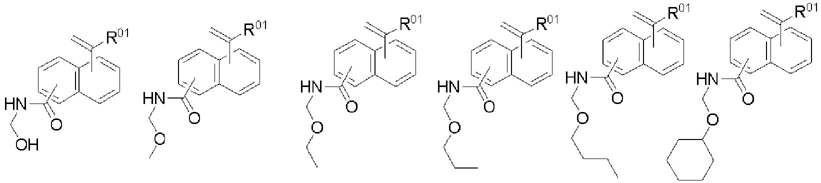

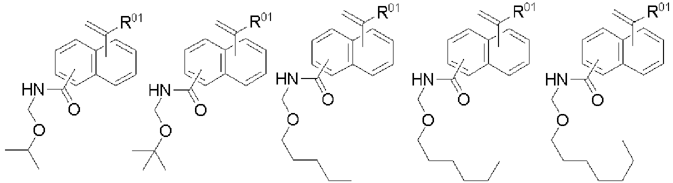

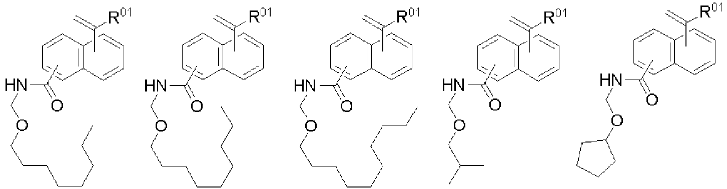

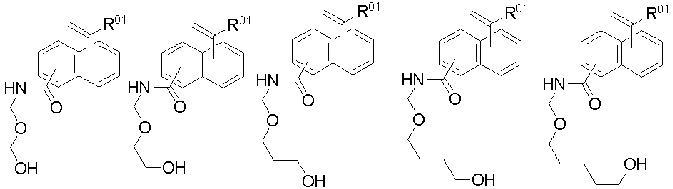

Moreover, since the resin has the organic sulfonyl anion structure, acid derived from the organic sulfonyl anion structure is generated on a surface of an underlayer film, which contributes to removing a residue at a bottom of a resist film. Meanwhile, diffusion length of this acid is extremely short because of its bond to the resin included in the composition for forming an adhesive film. The acid also has a small adverse effect on pattern roughness.

Moreover, as the structural unit having the organic sulfonyl anion structure, known ones can suitably be used. For example, those having the following structures can be used as an anion in a monomer from which the organic sulfonyl anion structure is derived, but the anion is not limited thereto. Note that in the following formulae, R^{A} each independently represents a hydrogen atom or a methyl group, and X^{BI} each independently represents an iodine atom, a bromine atom, or a fluorine atom.

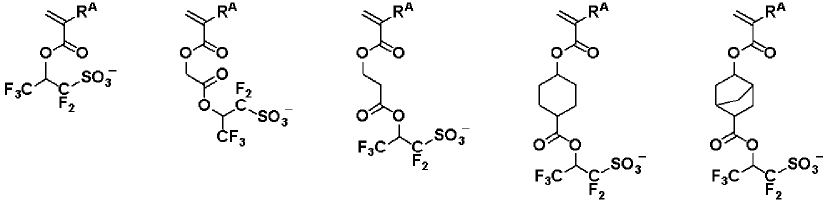

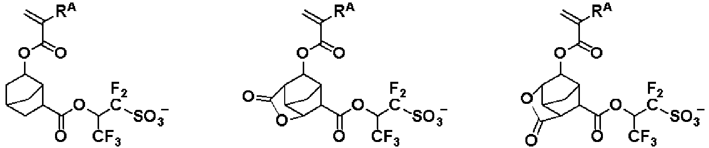

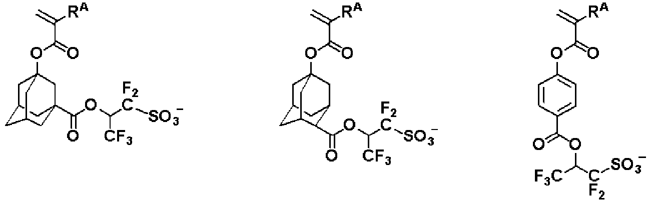

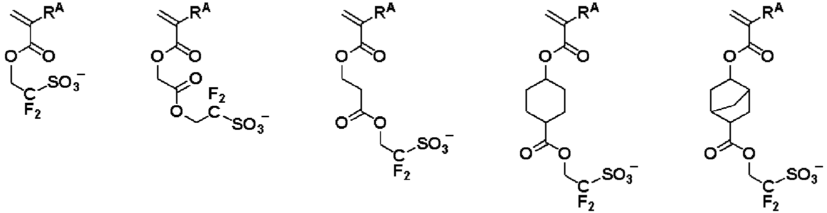

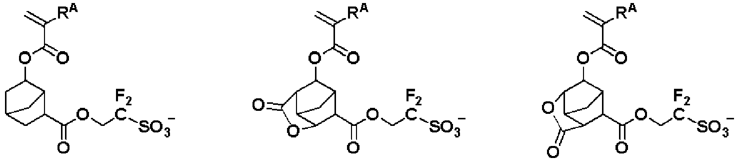

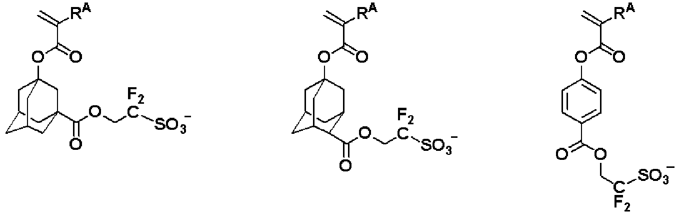

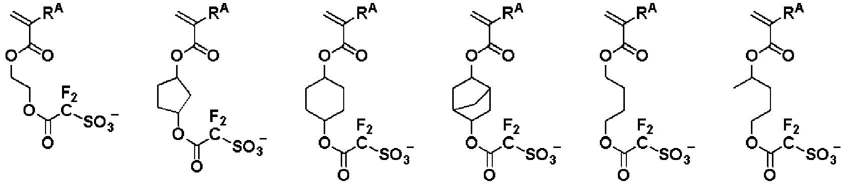

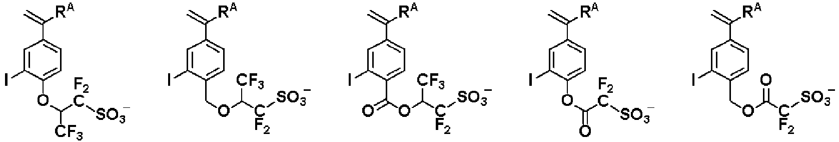

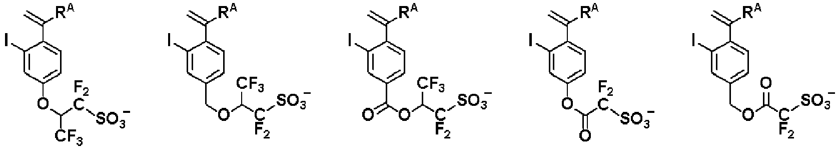

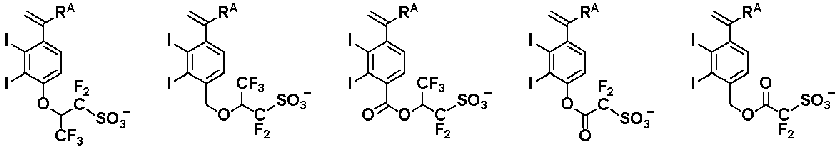

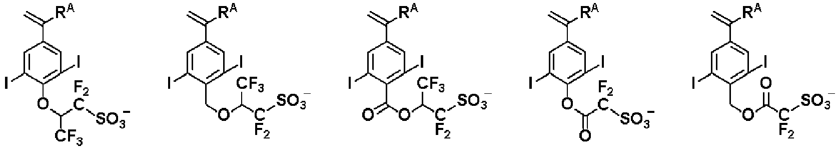

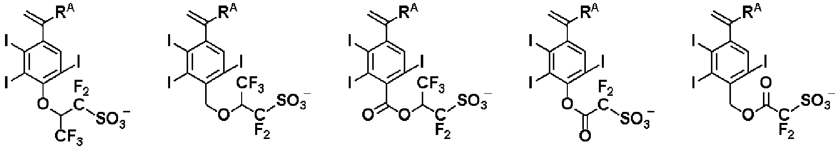

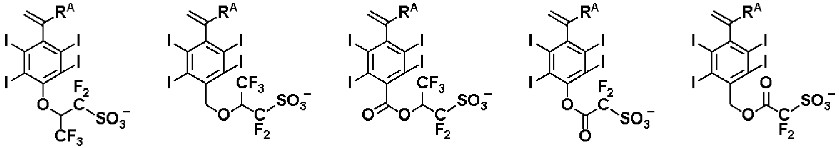

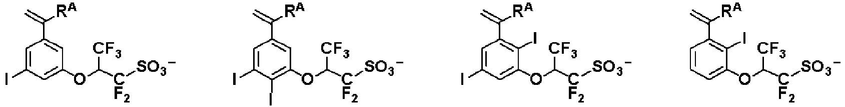

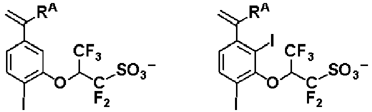

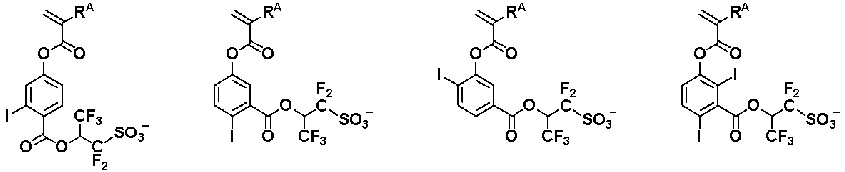

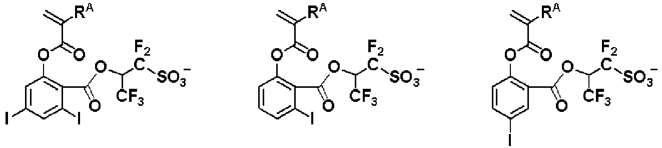

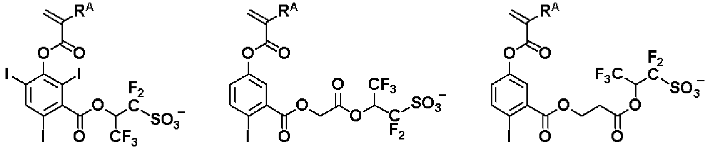

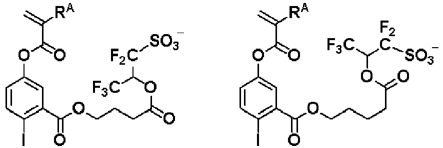

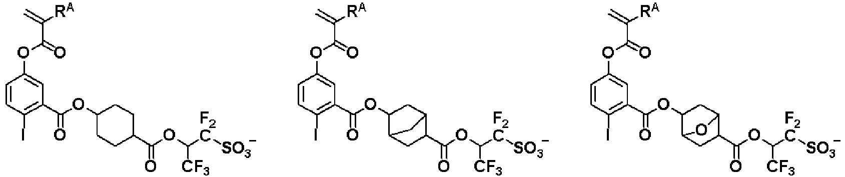

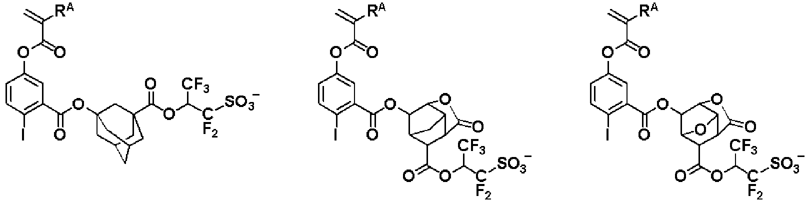

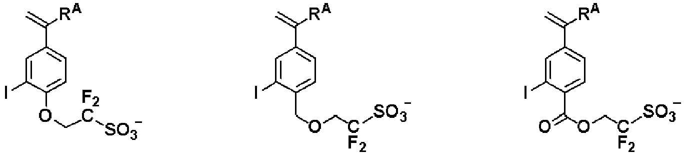

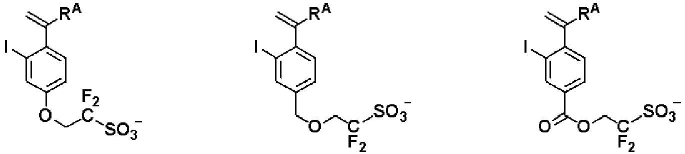

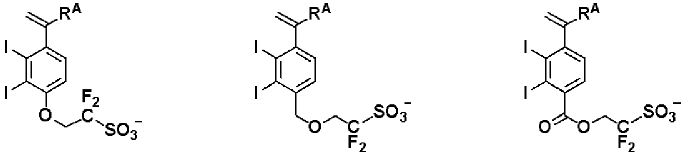

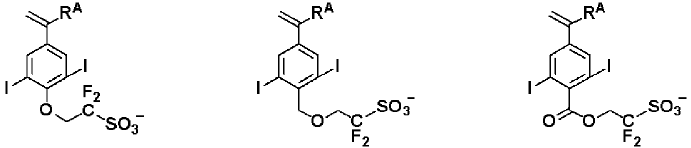

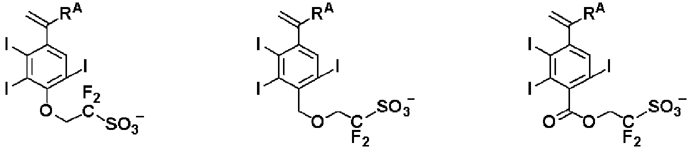

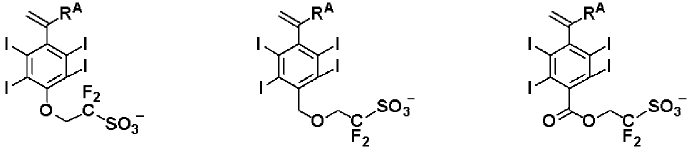

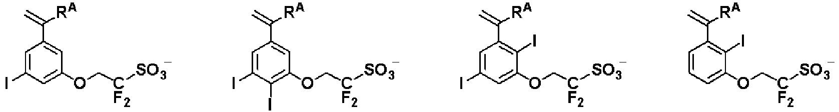

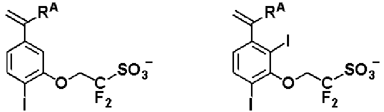

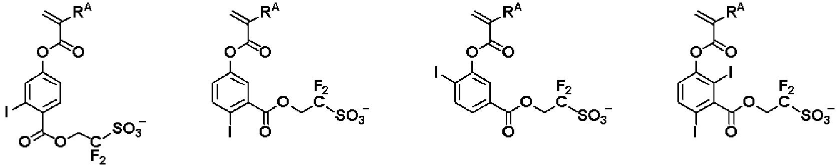

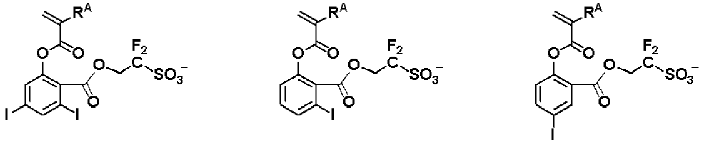

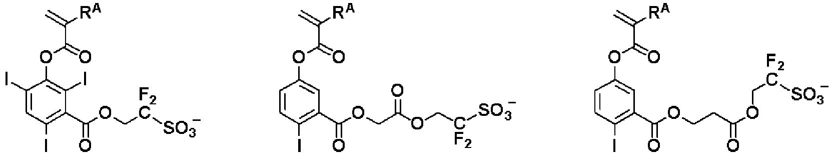

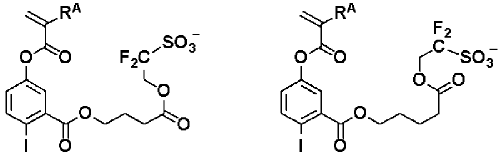

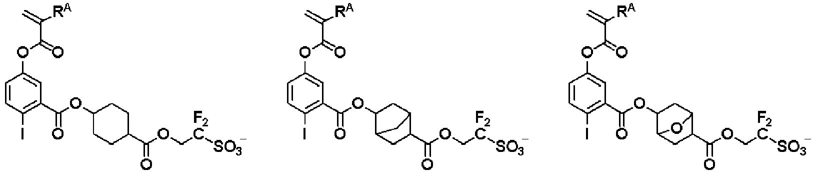

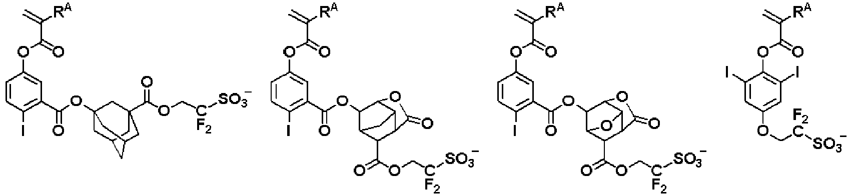

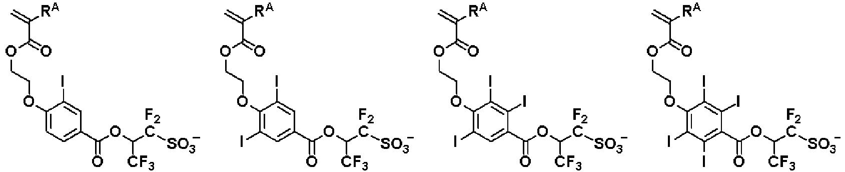

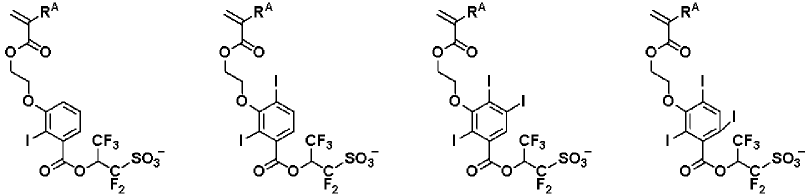

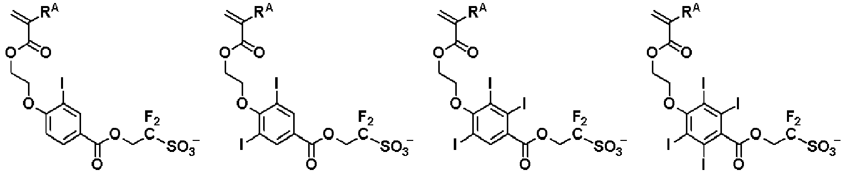

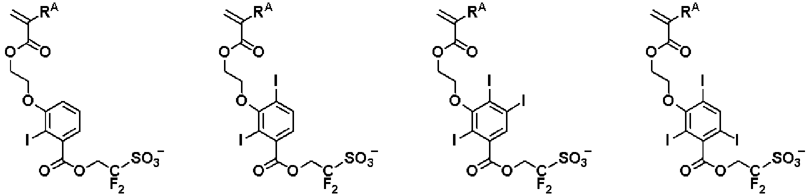

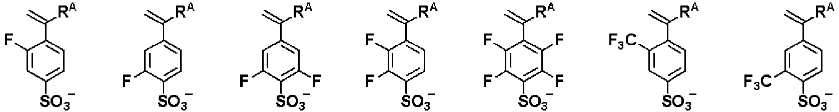

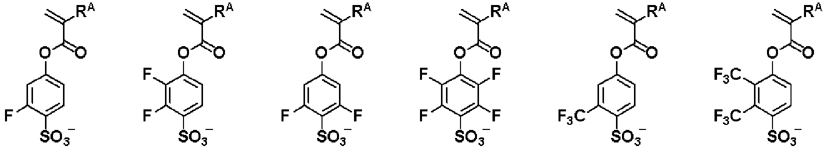

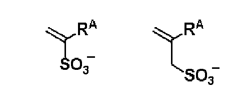

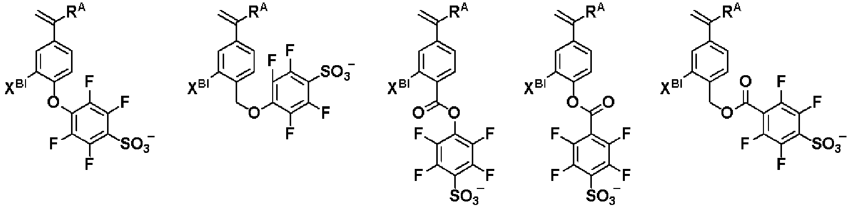

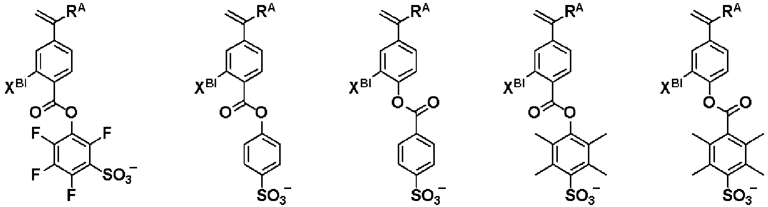

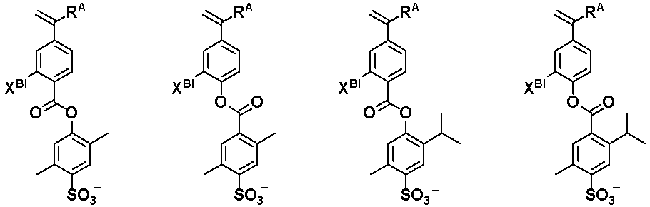

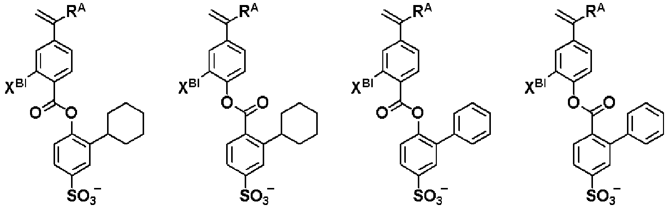

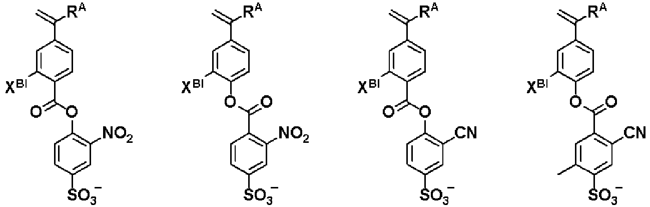

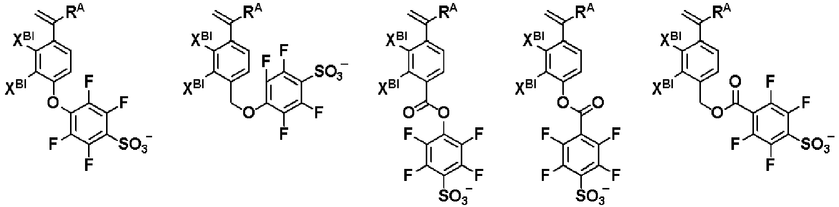

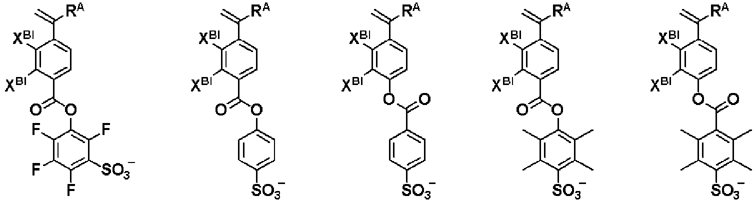

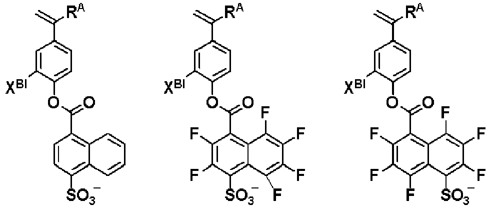

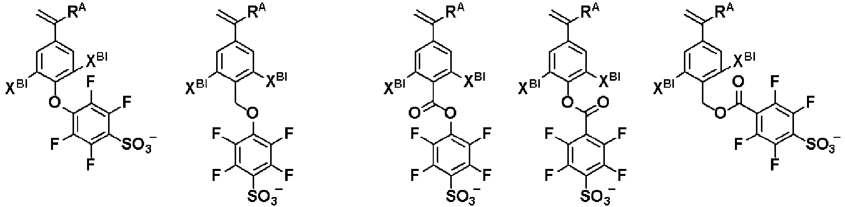

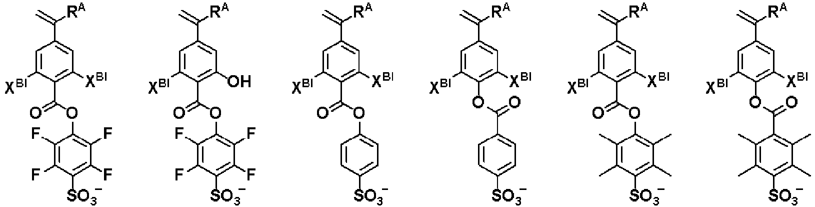

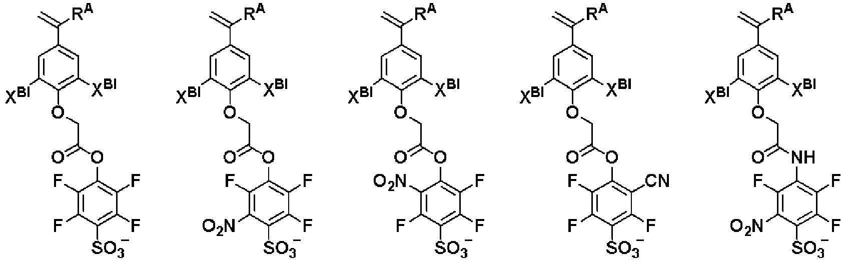

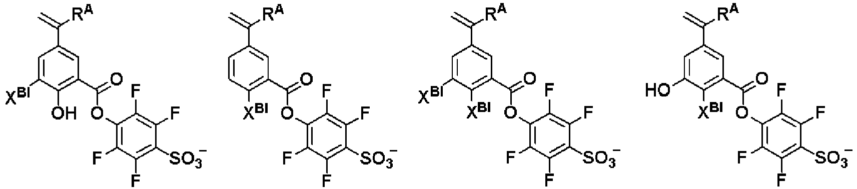

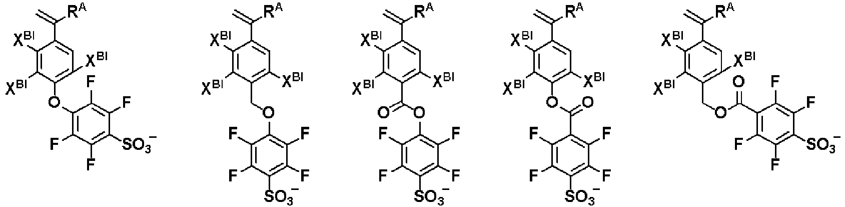

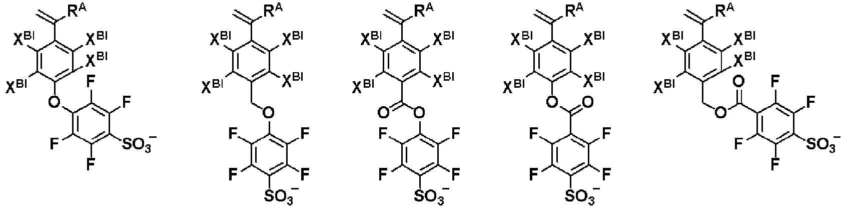

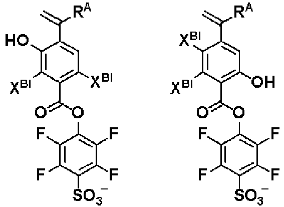

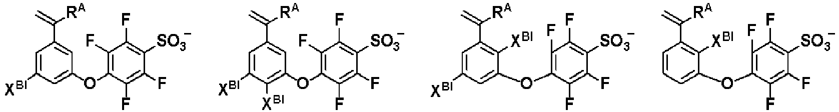

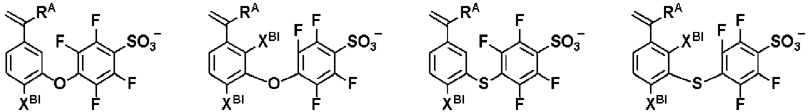

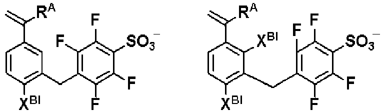

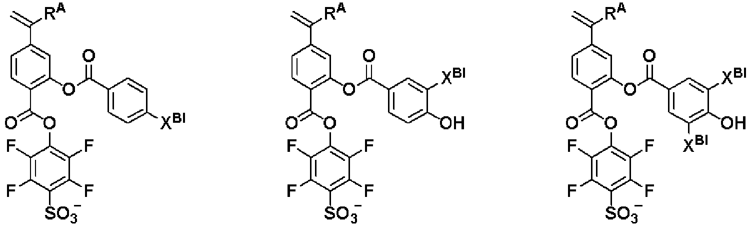

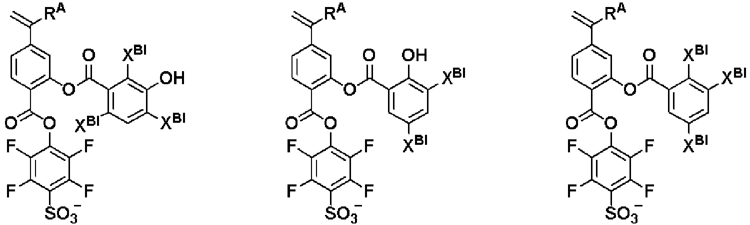

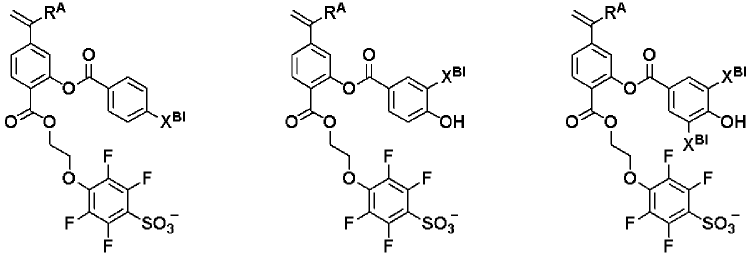

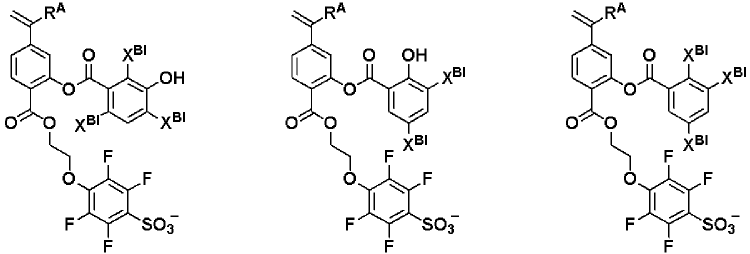

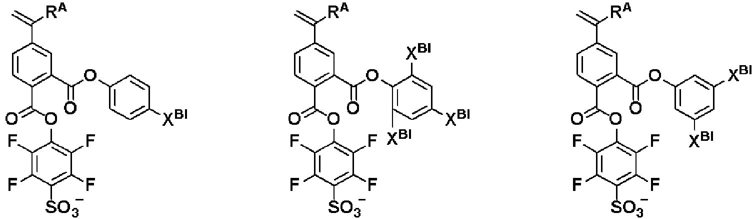

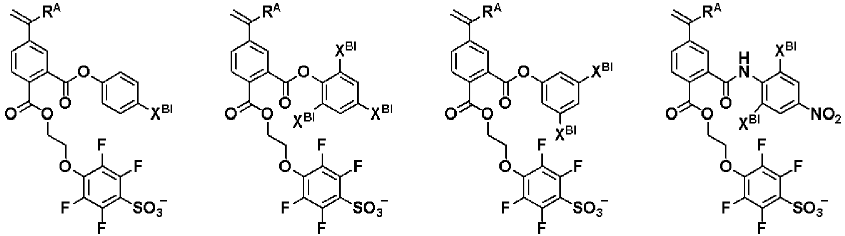

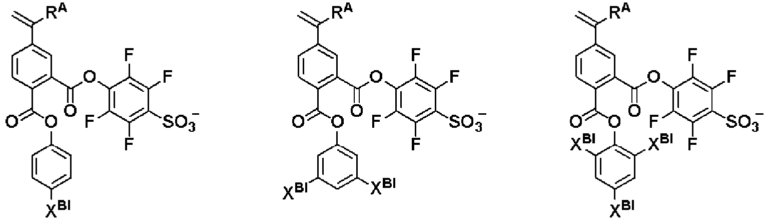

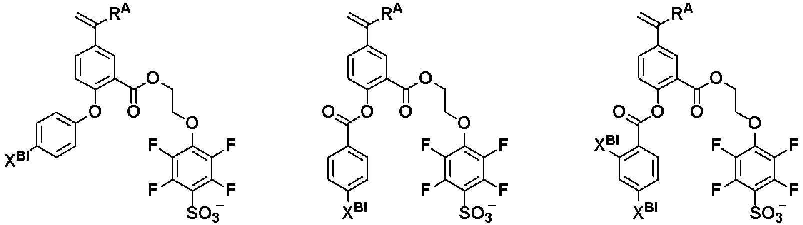

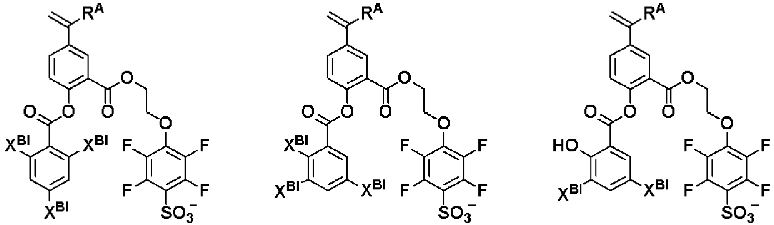

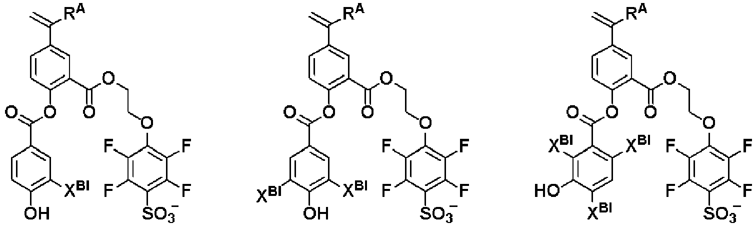

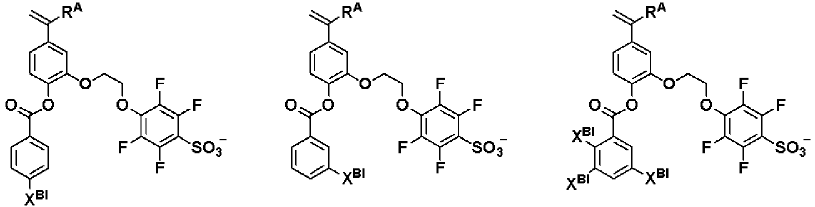

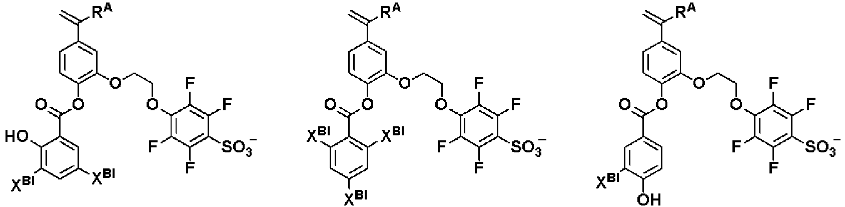

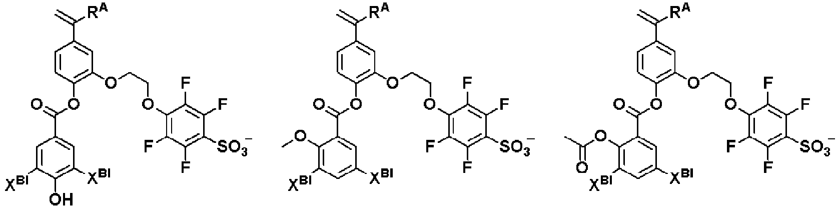

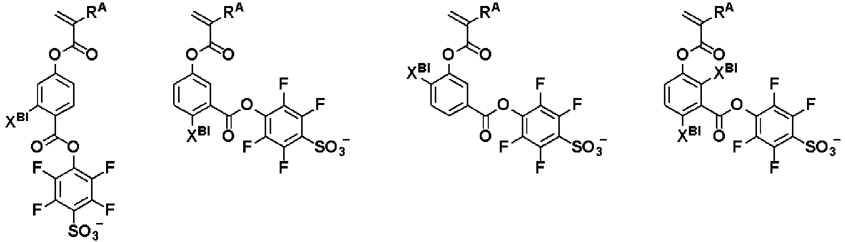

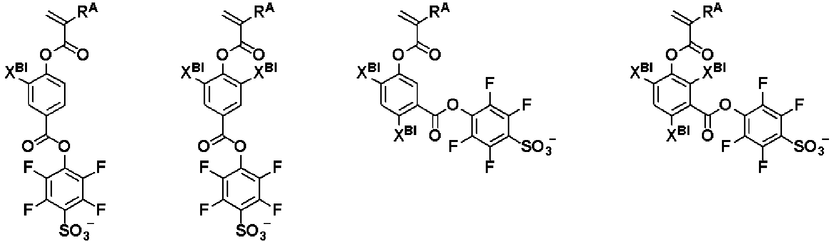

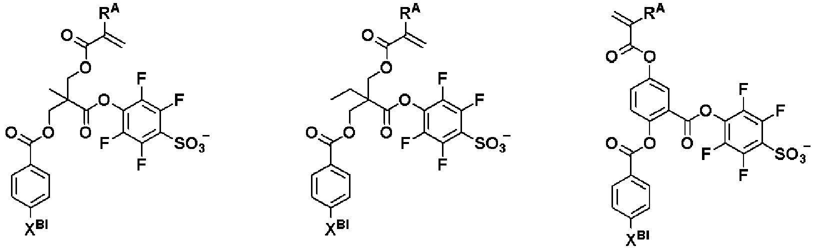

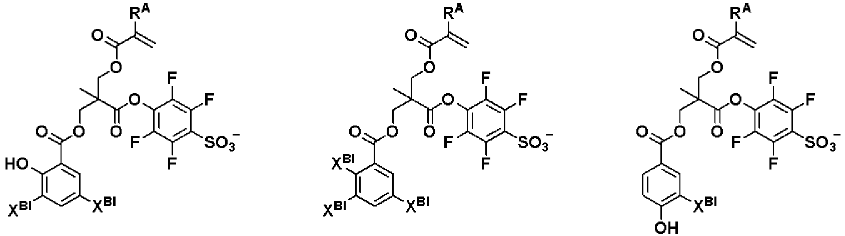

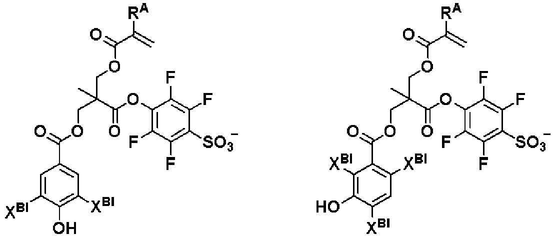

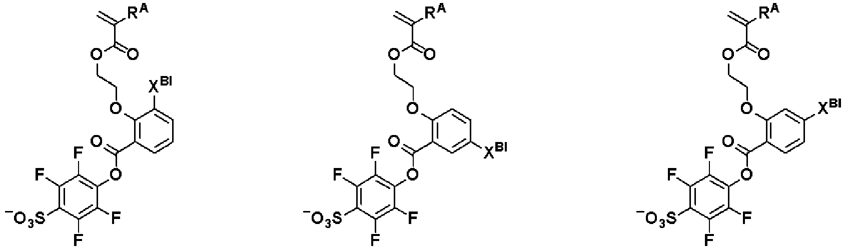

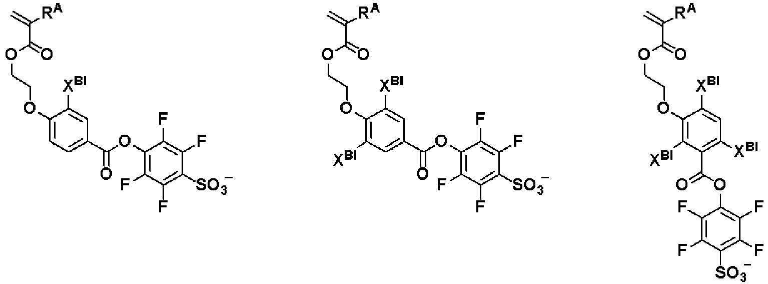

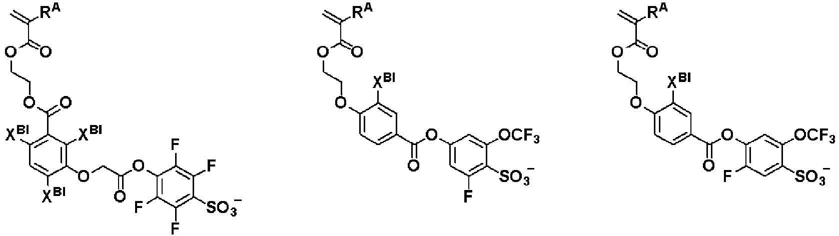

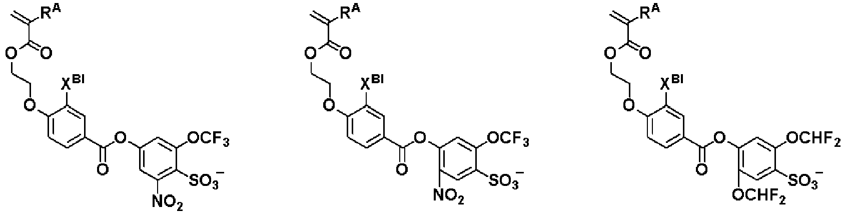

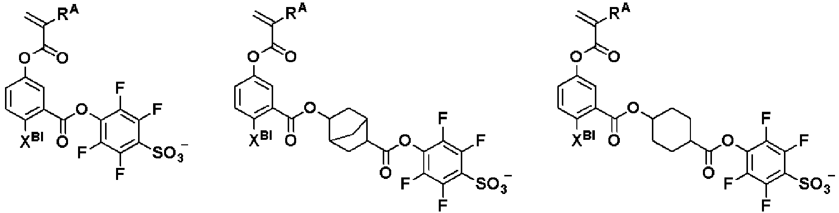

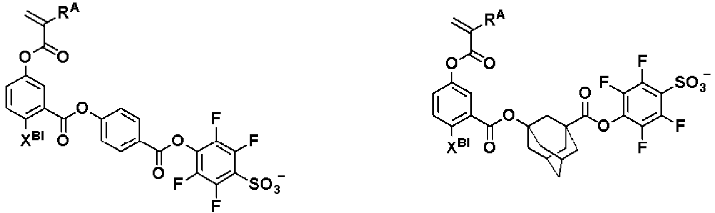

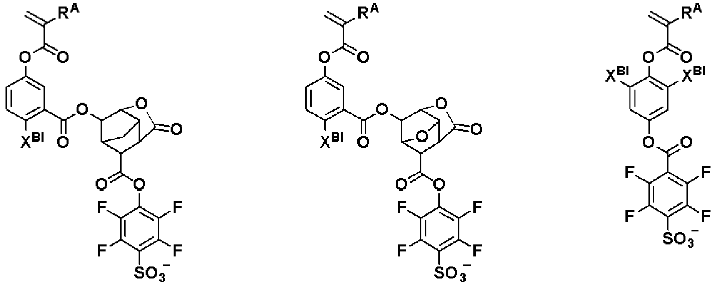

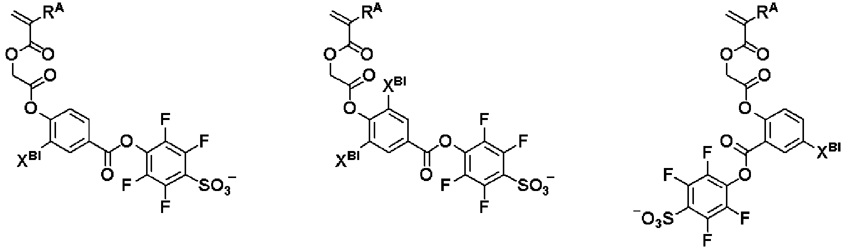

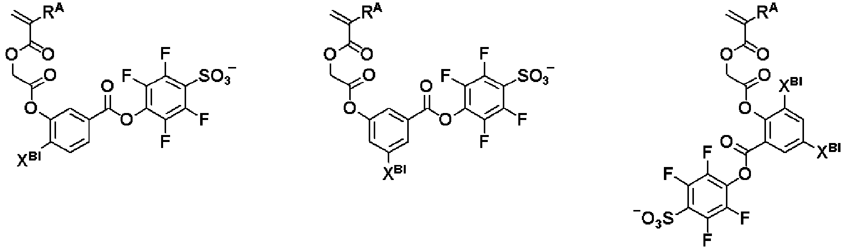

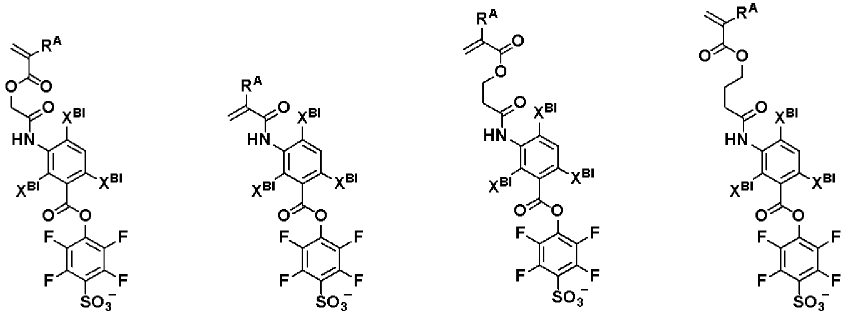

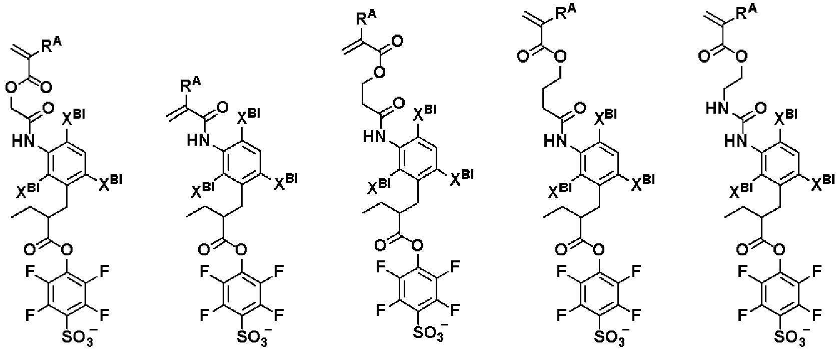

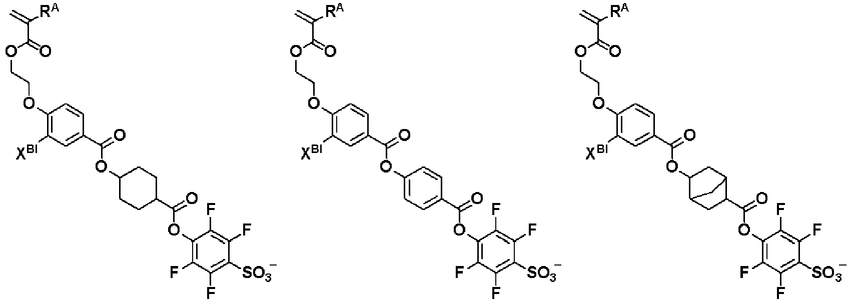

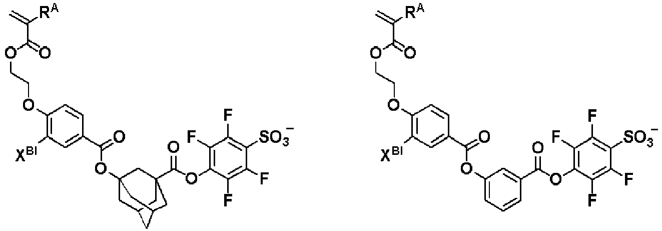

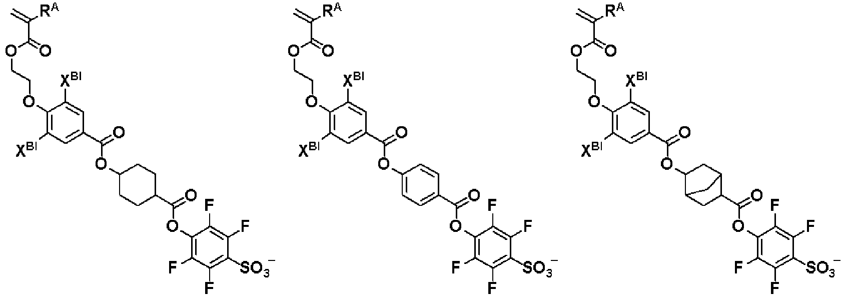

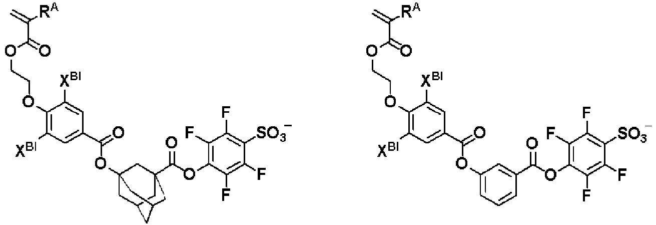

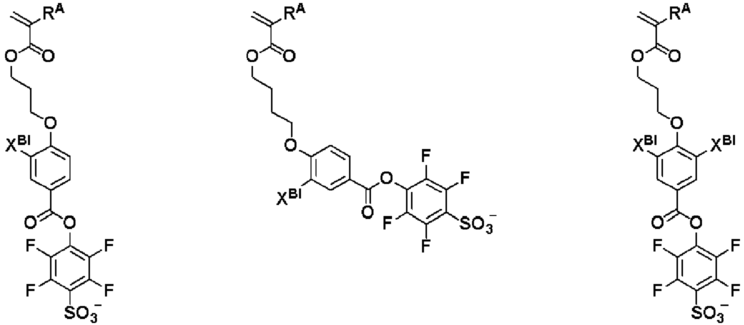

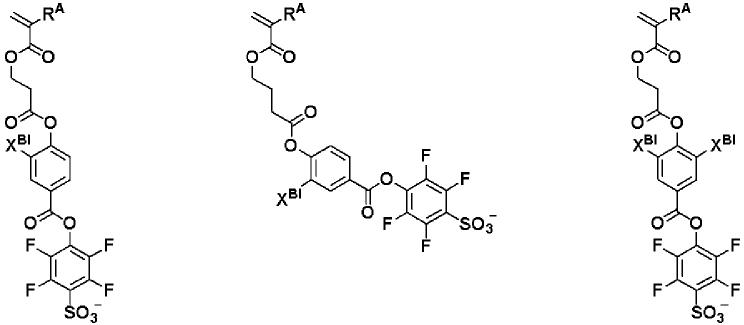

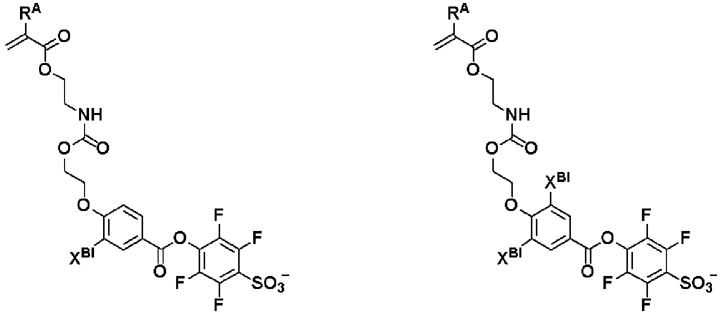

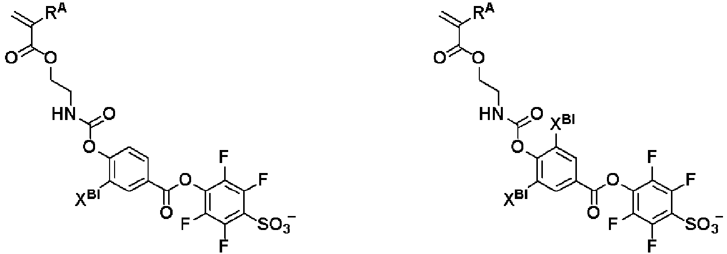

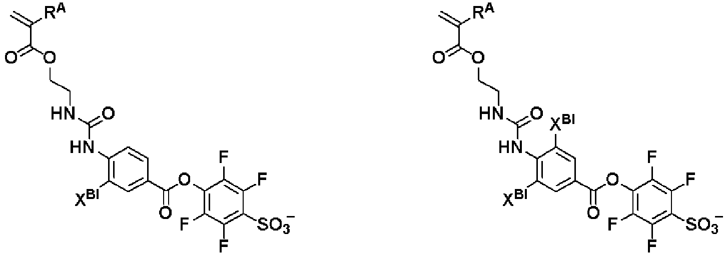

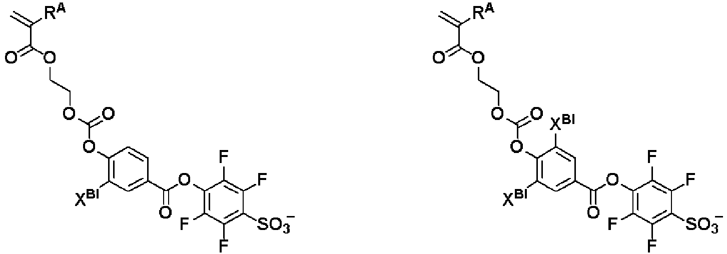

Moreover, a known ammonium cation, sulfonium cation, or iodonium cation can be used as a counter cation of the above anion. For example, those having the structures described in paragraphs [0043] to [0045] of JP 5415982 B2 and the structures shown below are usable, but the counter cation is not limited thereto.

The sulfonium cation is preferably the one represented by the following general formula (2). The iodonium cation is preferably the one represented by the following general formula (3).

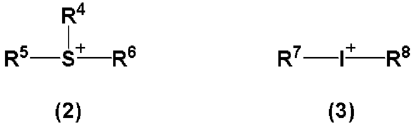

In the above general formulae (2) and (3), R⁴ to R⁸ each independently represents a halogen atom or a hydrocarbyl group having 1 to 20 carbon atoms and optionally containing a heteroatom.

Specific examples of the halogen atom represented by R⁴ to R⁸ include a fluorine atom, a chlorine atom, a bromine atom, an iodine atom, and the like.

The hydrocarbyl group having 1 to 20 carbon atoms represented by R⁴ to R⁸ may be saturated or unsaturated, and may be linear, branched, or cyclic. Specific examples thereof include: alkyl groups having 1 to 20 carbon atoms, such as a methyl group, an ethyl group, an n-propyl group, an isopropyl group, an n-butyl group, an isobutyl group, a sec-butyl group, a tert-butyl group, an n-pentyl group, an n-hexyl group, an n-octyl group, an n-nonyl group, an n-decyl group, an undecyl group, a dodecyl group, a tridecyl group, a tetradecyl group, a pentadecyl group, a heptadecyl group, an octadecyl group, a nonadecyl group, and an icosyl group; cyclic saturated hydrocarbyl groups having 3 to 20 carbon atoms, such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; alkenyl groups having 2 to 20 carbon atoms, such as a vinyl group, a propenyl group, a butenyl group, and a hexenyl group; alkynyl groups having 2 to 20 carbon atoms, such as an ethynyl group, a propynyl group, and a butynyl group; cyclic unsaturated hydrocarbyl groups having 3 to 20 carbon atoms, such as a cyclohexenyl group and a norbornenyl group; aryl groups having 6 to 20 carbon atoms, such as a phenyl group, a methylphenyl group, an ethylphenyl group, an n-propylphenyl group, an isopropylphenyl group, an n-butylphenyl group, an isobutylphenyl group, a sec-butylphenyl group, a tert-butylphenyl group, a naphthyl group, a methylnaphthyl group, an ethylnaphthyl group, an n-propylnaphthyl group, an isopropylnaphthyl group, an n-butylnaphthyl group, an isobutylnaphthyl group, a sec-butylnaphthyl group, and a tert-butylnaphthyl group; aralkyl groups having 7 to 20 carbon atoms, such as a benzyl group and a phenetyl group; combinations of these groups; and the like.

Additionally, some or all of hydrogen atoms of the hydrocarbyl group may be substituted with a group containing a heteroatom such as oxygen, sulfur, nitrogen, and halogen atoms, or a part of -CH₂- of the hydrocarbyl group may be substituted with a group containing a heteroatom such as oxygen, sulfur, and nitrogen atoms. As a result, a hydroxy group, a fluorine atom, a chlorine atom, a bromine atom, an iodine atom, a cyano group, a nitro group, a mercapto group, a carbonyl group, an ether bond, an ester bond, a sulfonic acid ester bond, a carbonate bond, a lactone ring, a sultone ring, a carboxylic acid anhydride (-C(=O)-O-C(=O)-), a haloalkyl group, and the like may be contained.

Moreover, R⁴ and R⁵ may bond together to form a ring with a sulfur atom bonded thereto. In this case, the ring preferably has any of the following structures.

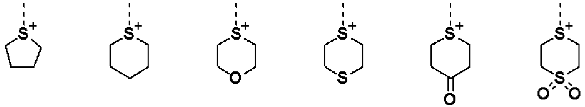

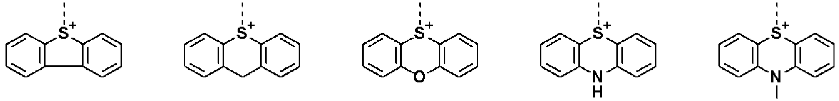

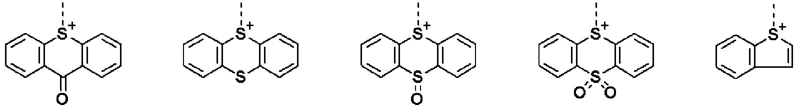

In the formulae, a dashed line represents a bonding arm.

Specific examples of the sulfonium cation represented by the above general formula (2) are shown below, but not limited thereto.

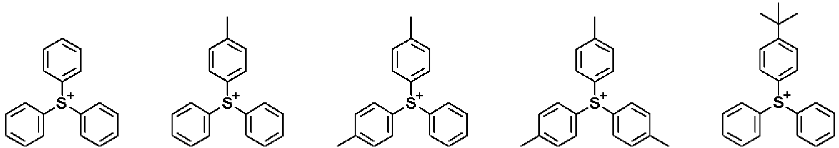

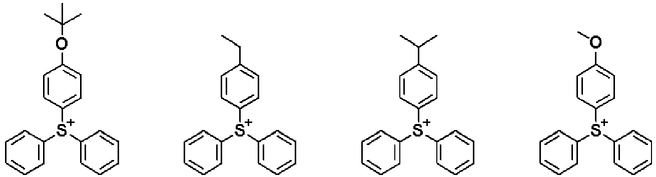

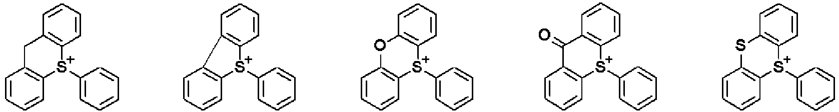

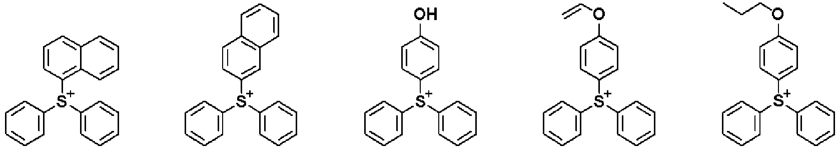

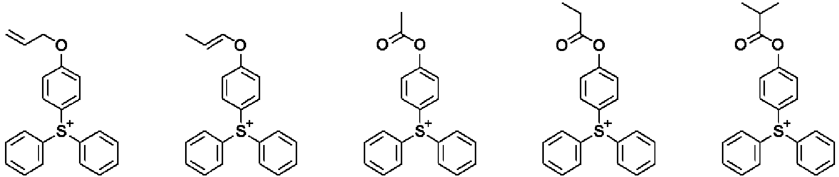

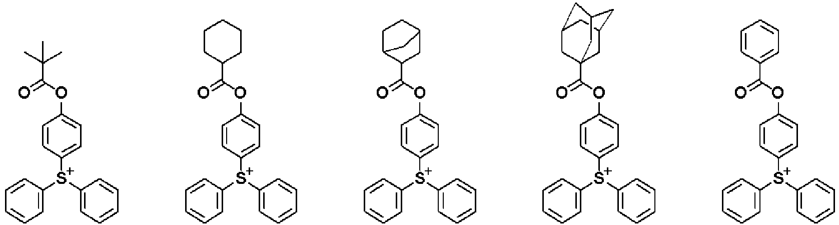

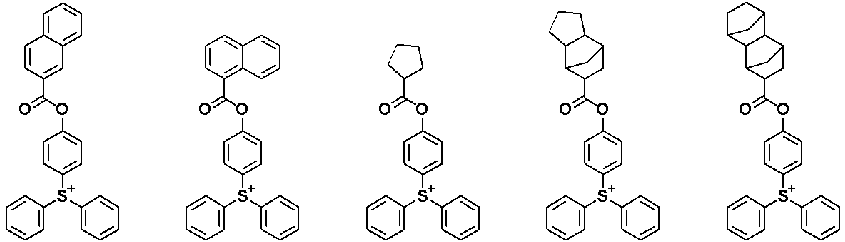

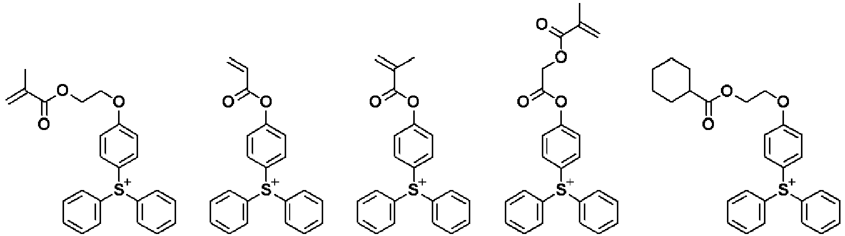

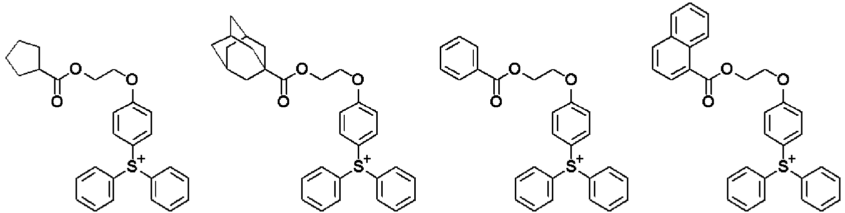

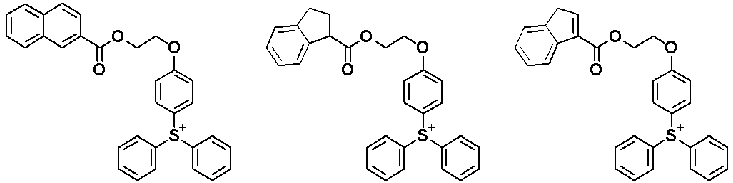

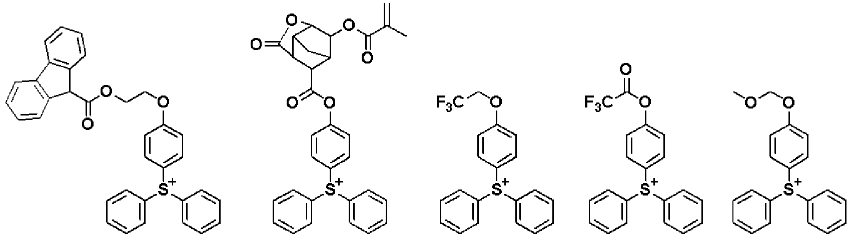

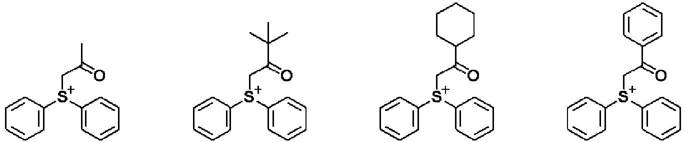

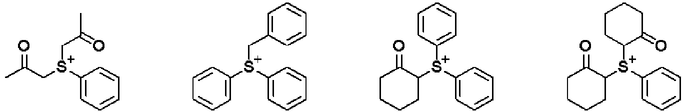

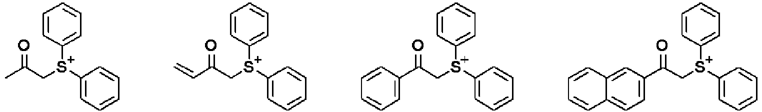

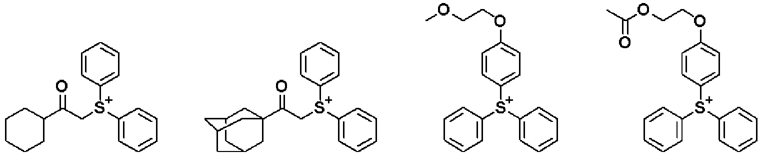

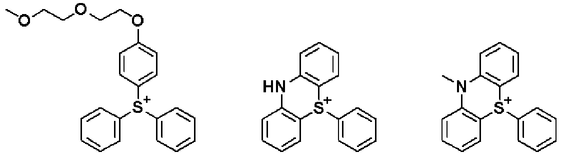

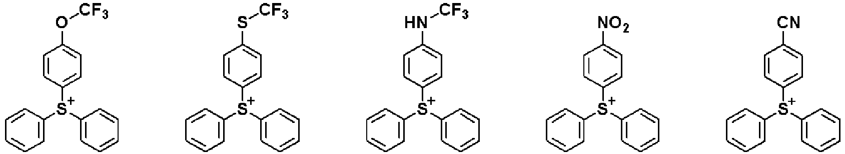

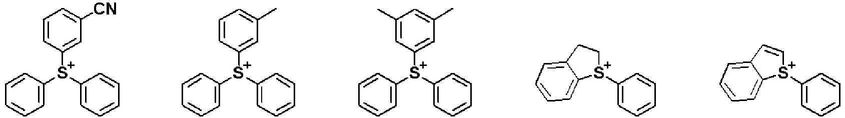

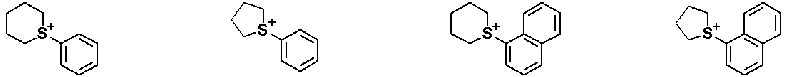

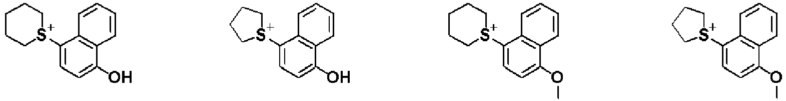

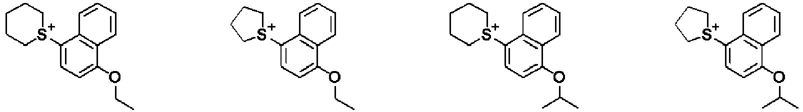

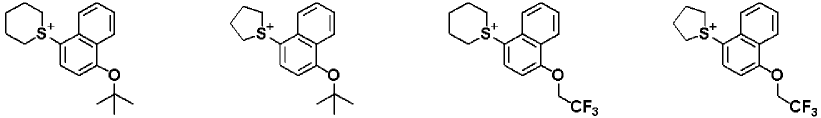

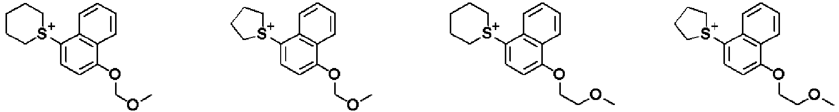

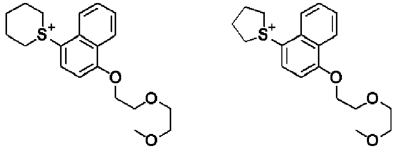

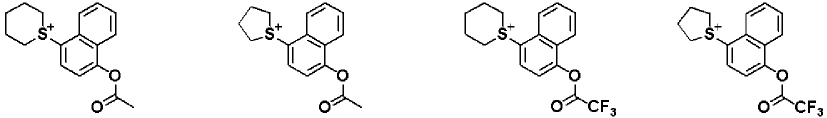

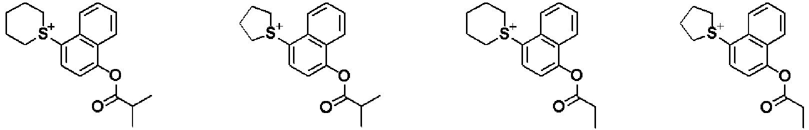

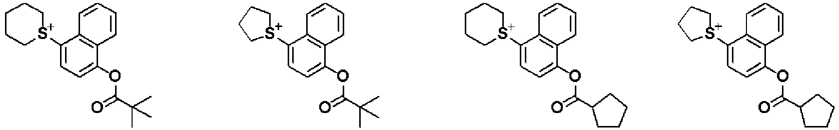

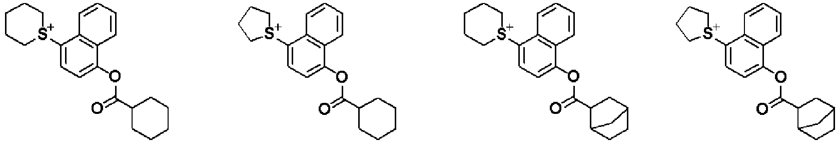

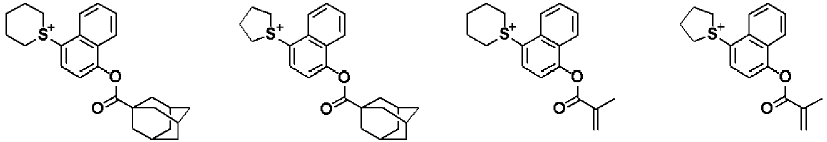

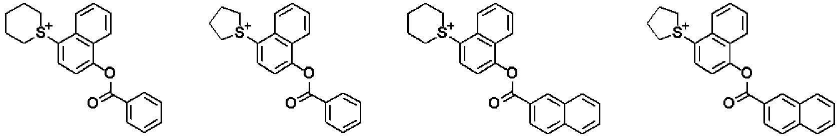

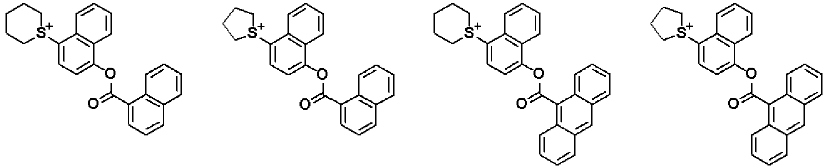

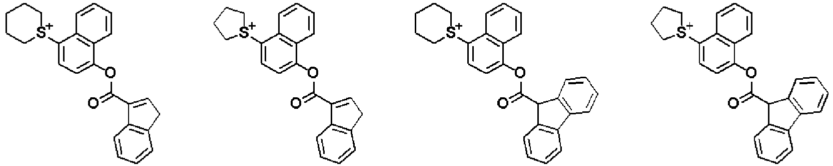

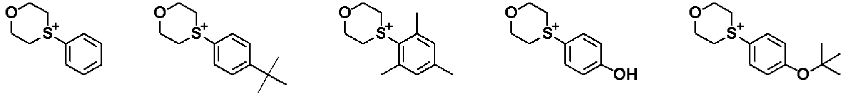

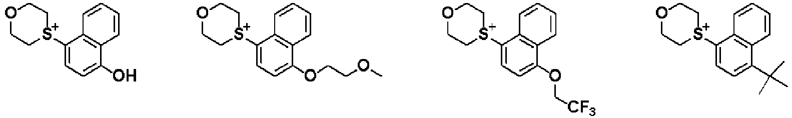

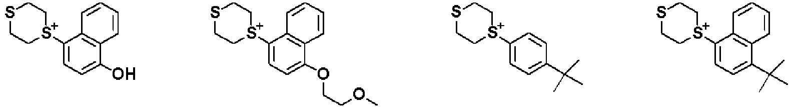

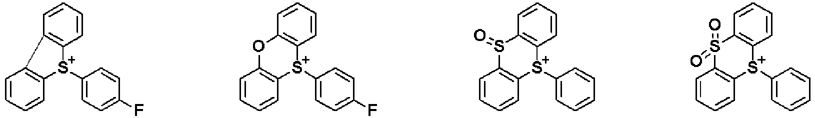

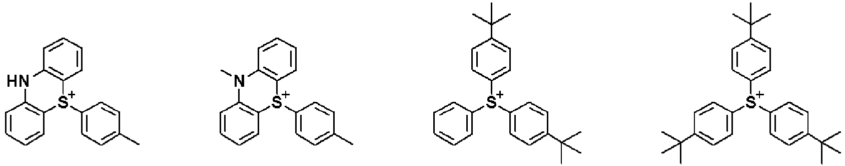

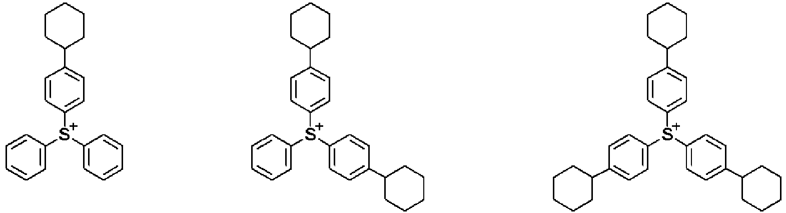

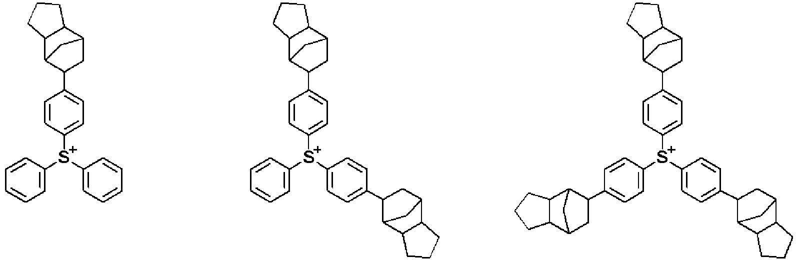

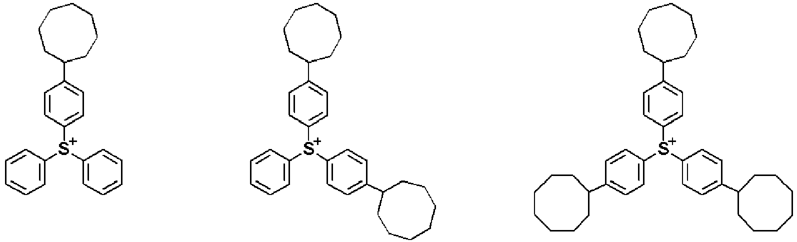

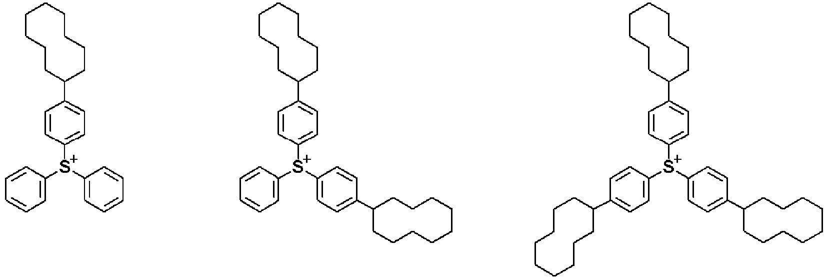

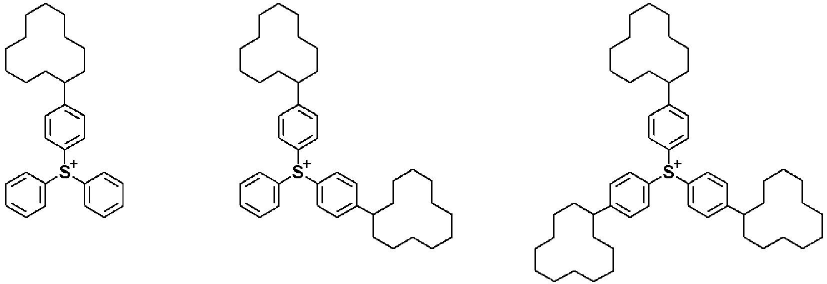

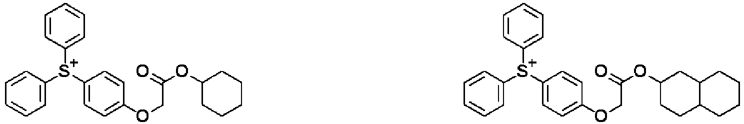

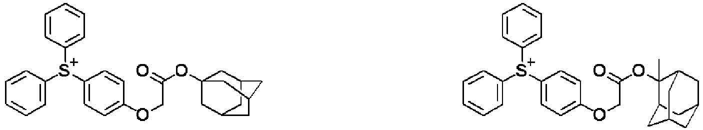

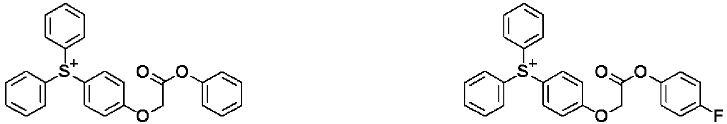

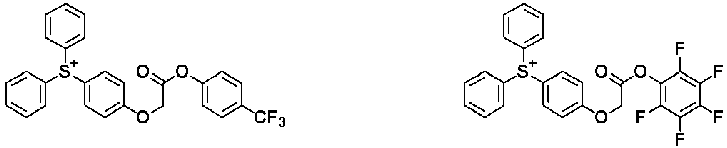

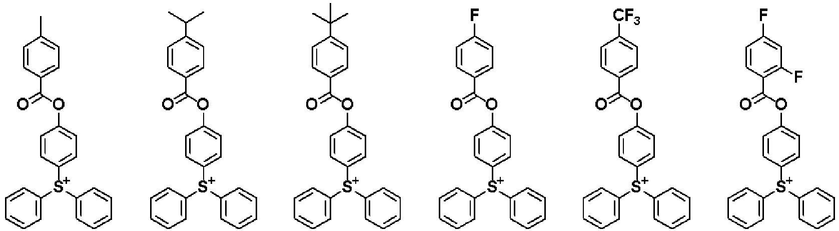

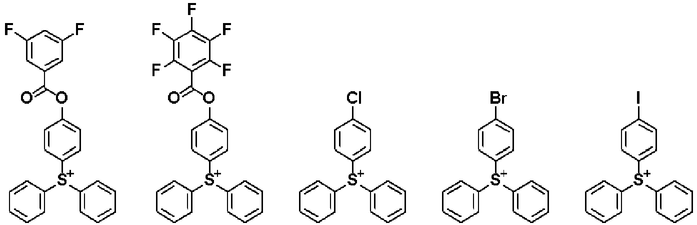

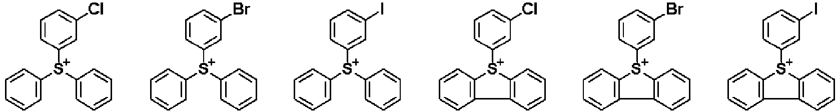

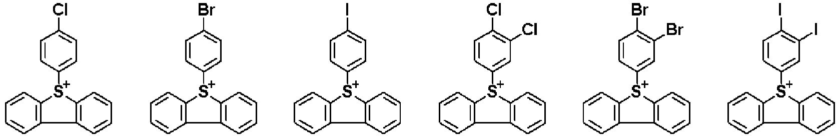

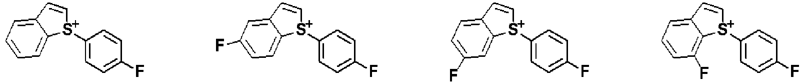

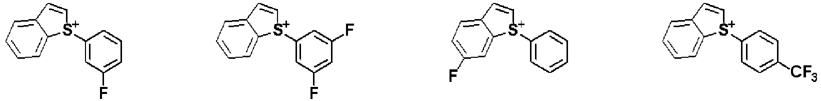

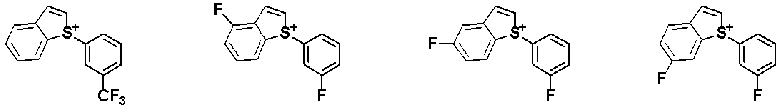

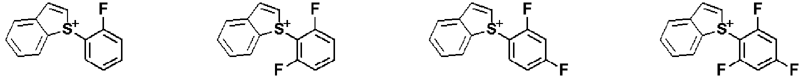

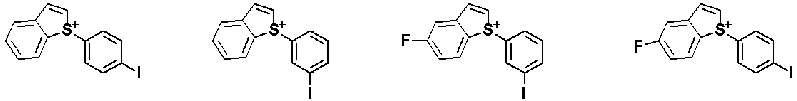

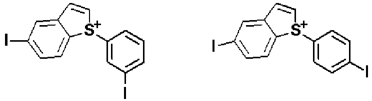

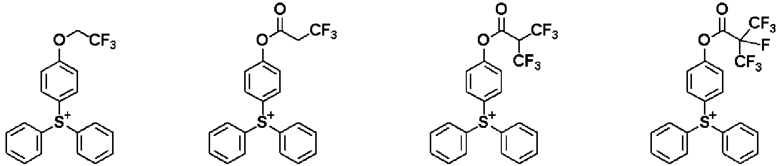

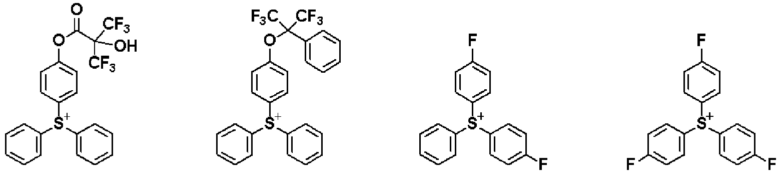

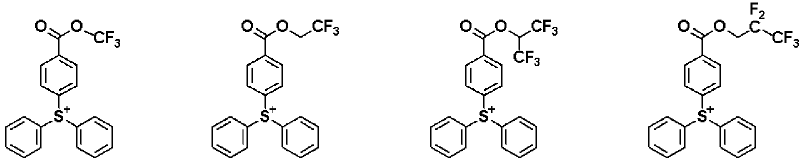

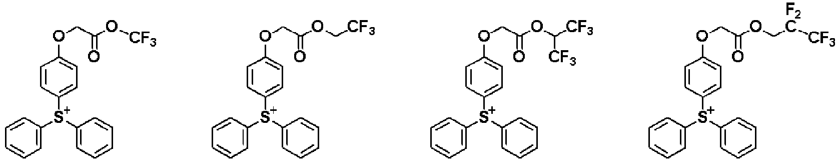

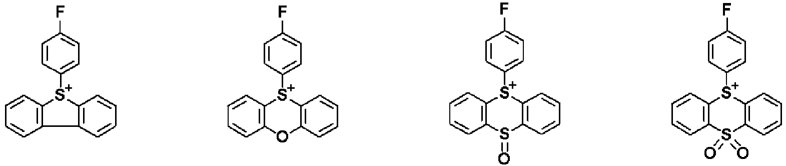

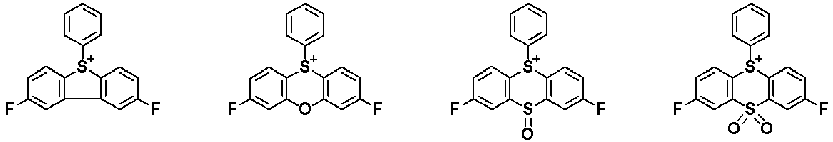

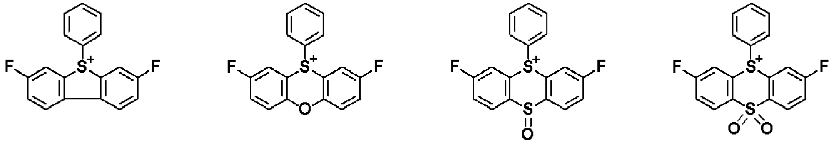

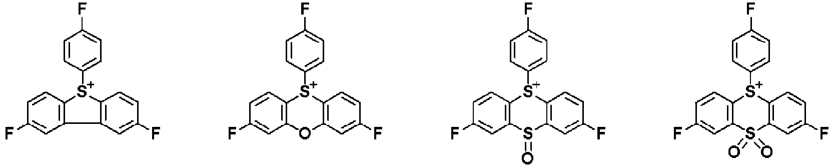

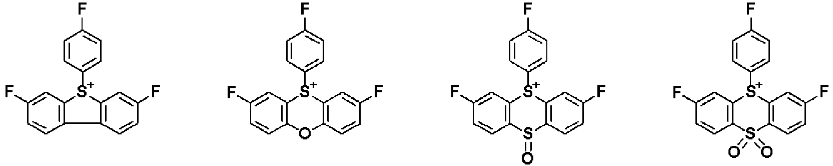

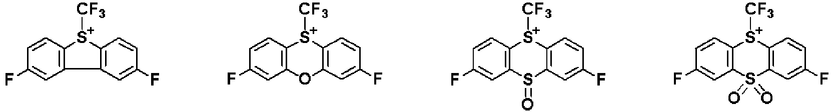

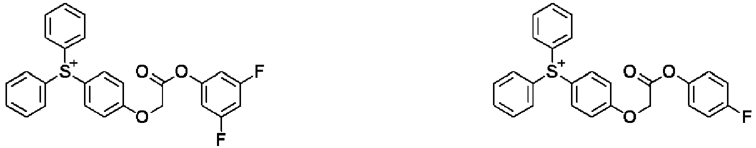

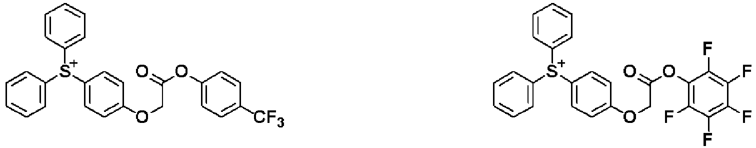

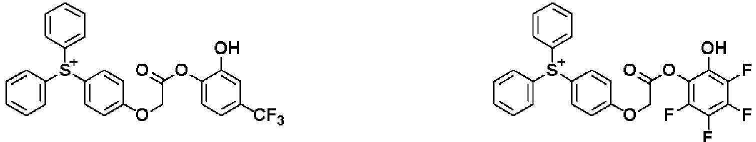

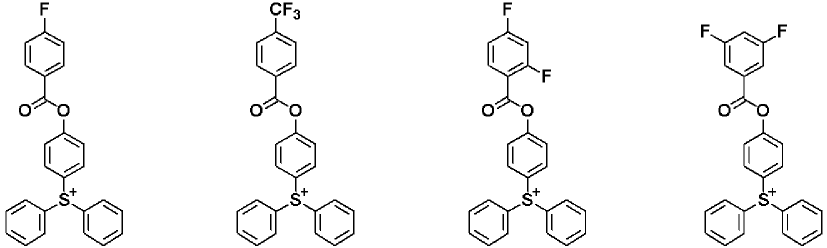

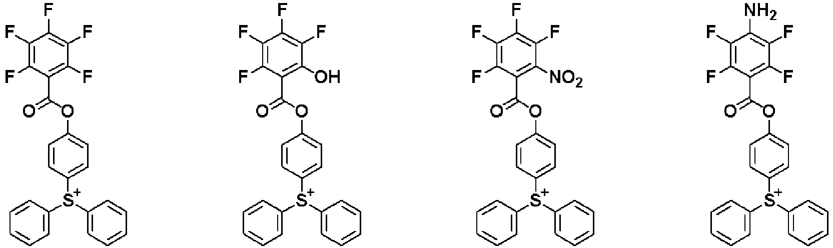

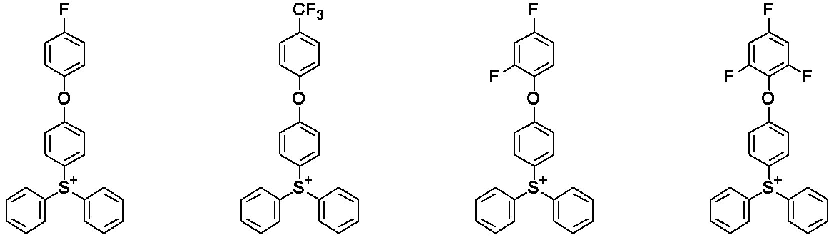

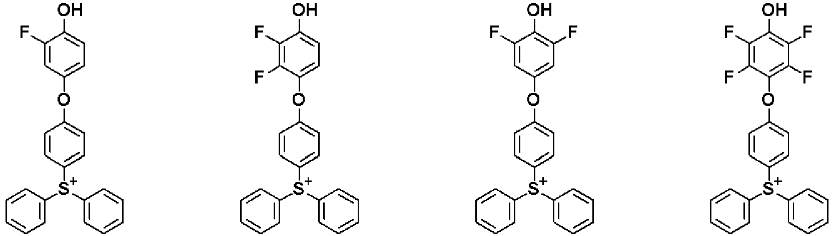

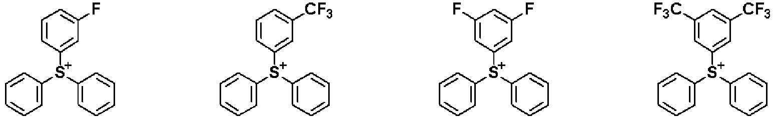

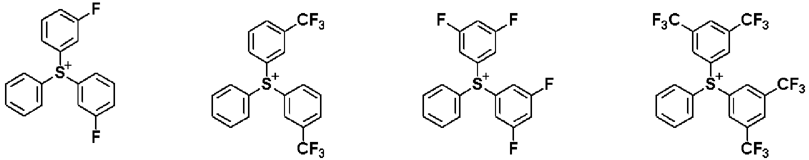

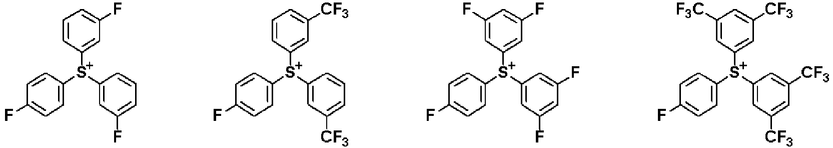

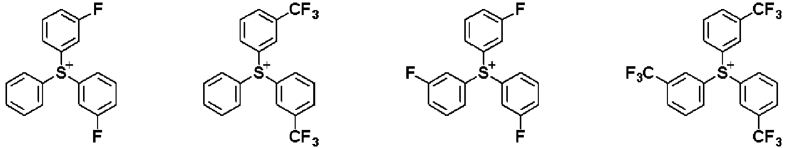

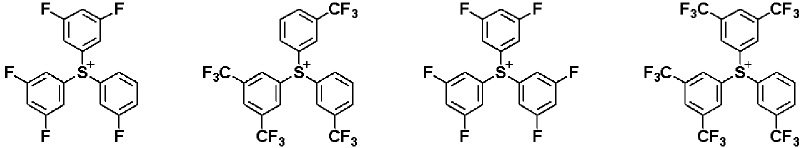

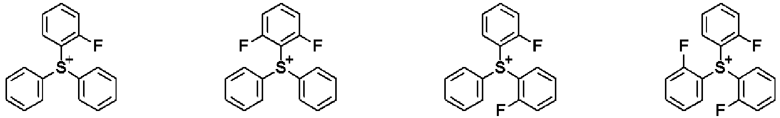

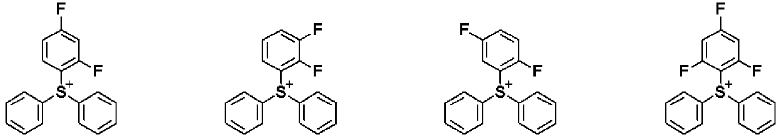

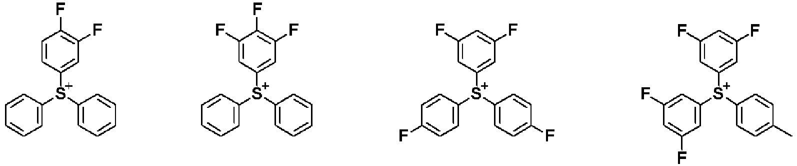

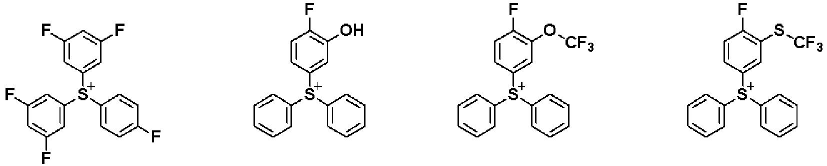

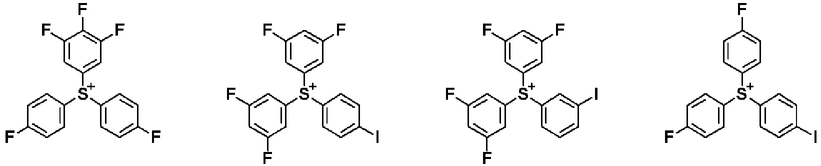

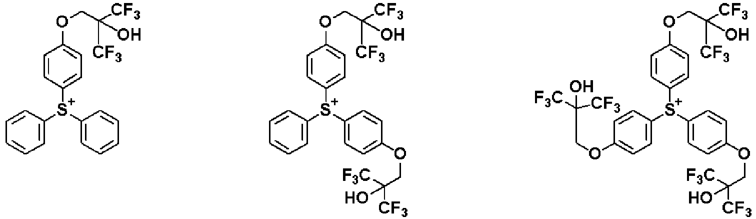

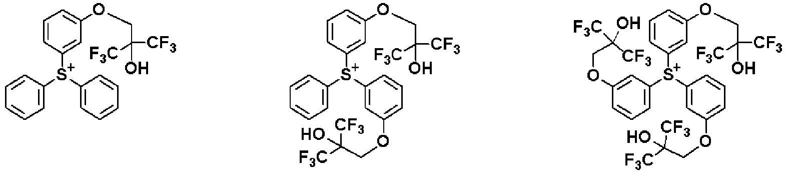

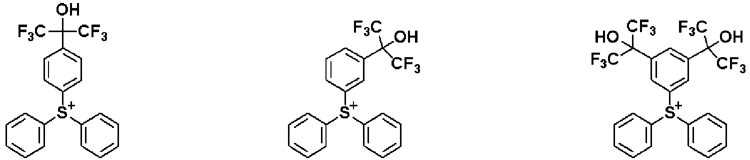

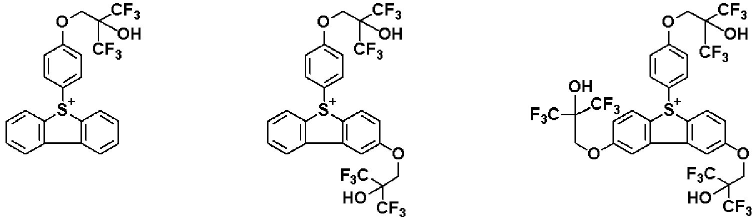

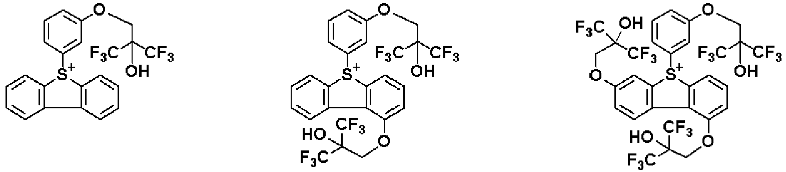

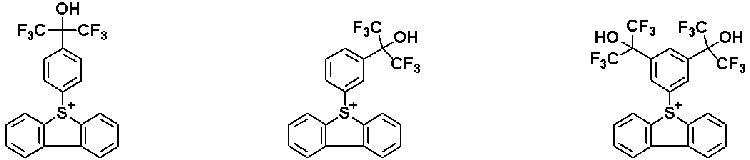

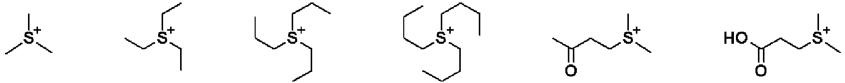

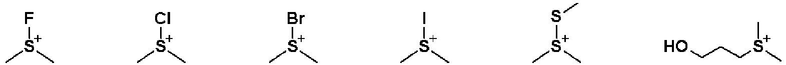

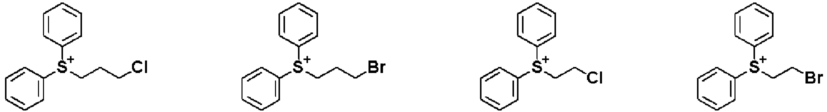

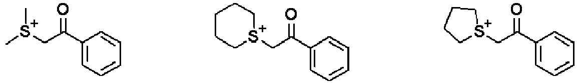

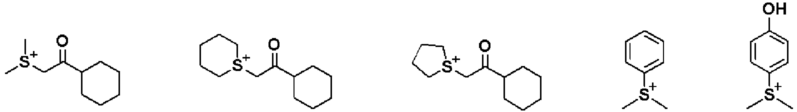

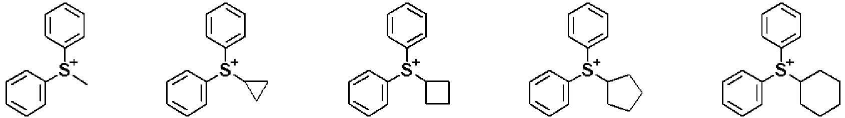

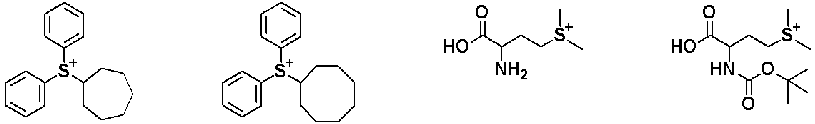

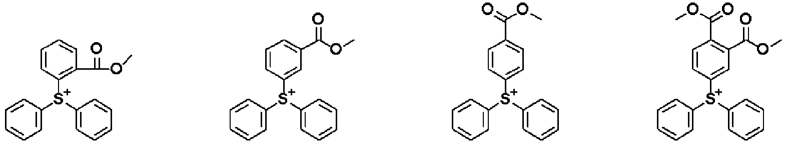

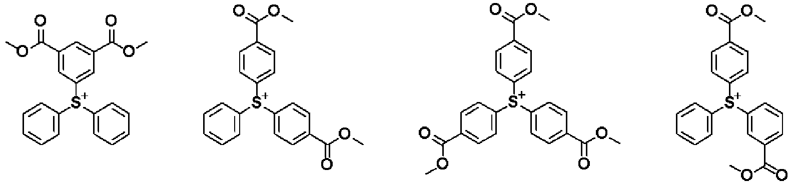

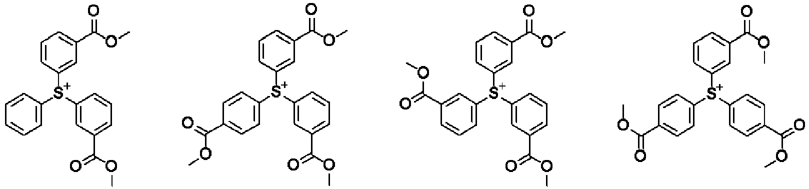

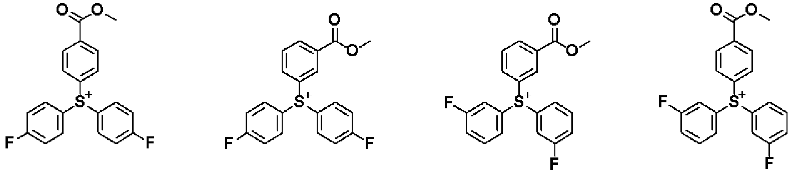

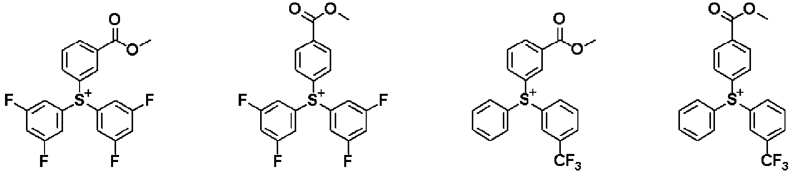

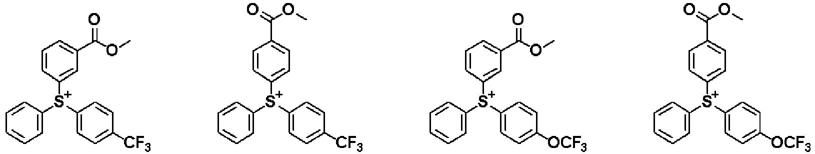

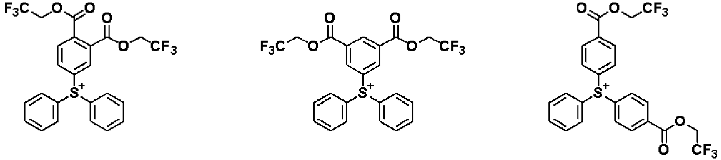

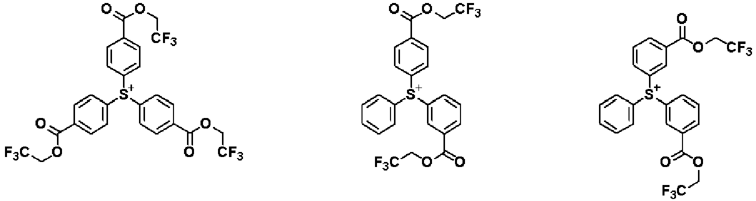

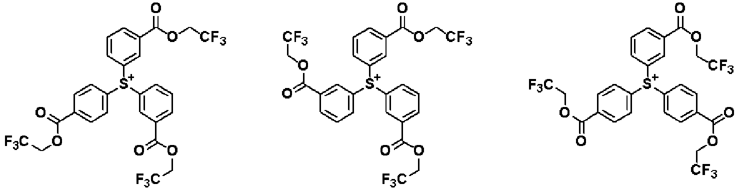

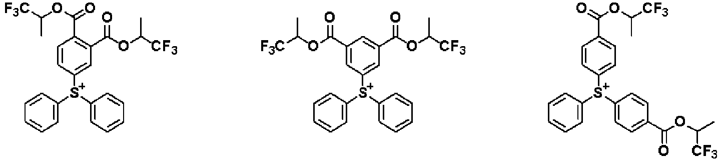

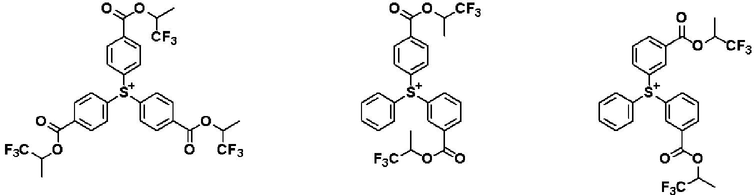

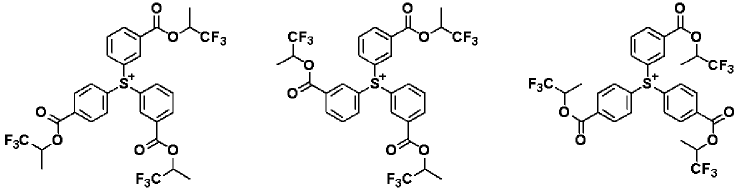

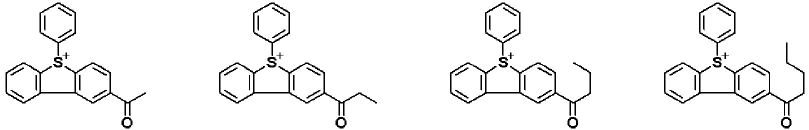

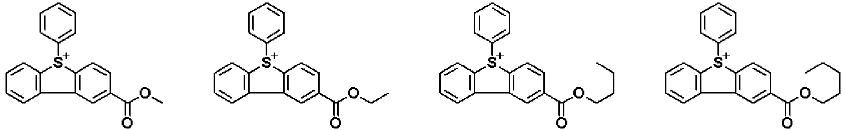

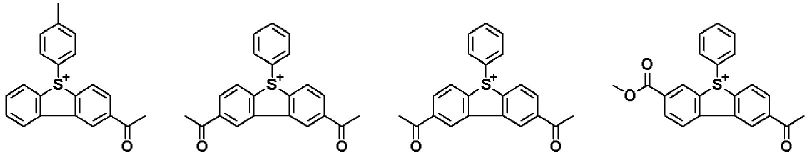

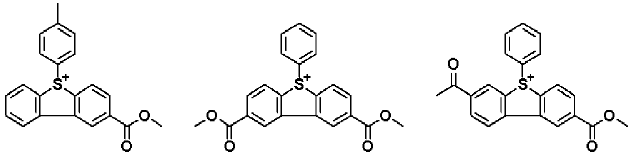

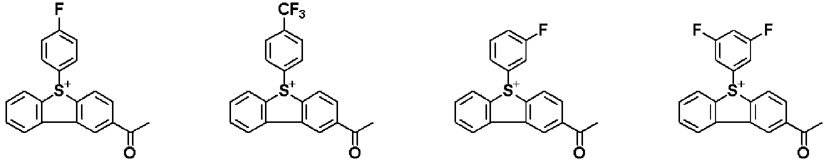

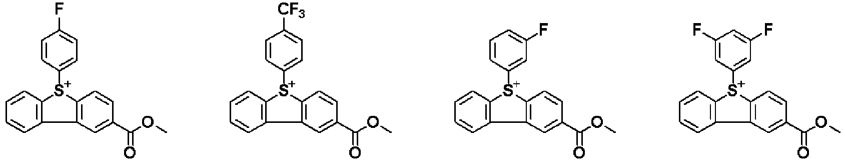

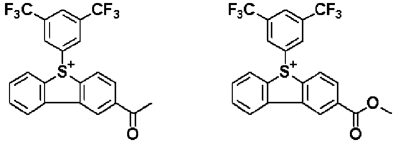

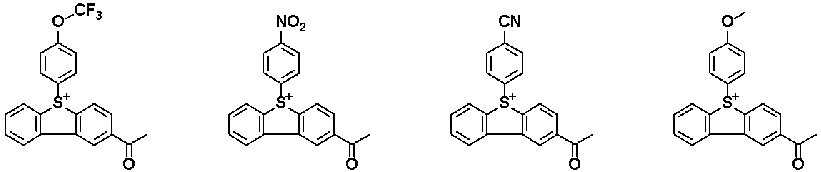

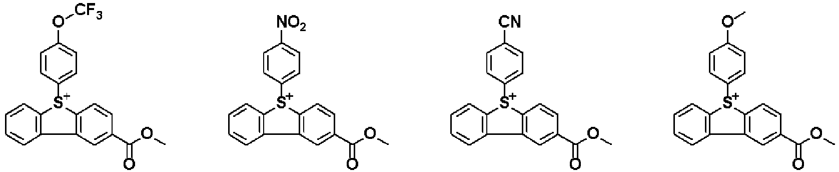

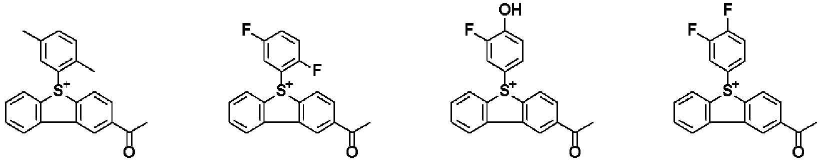

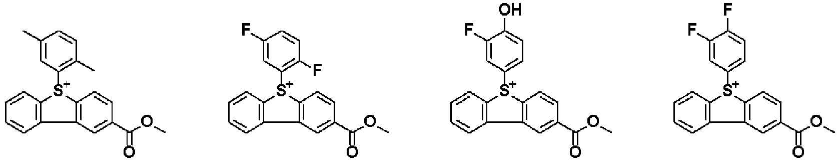

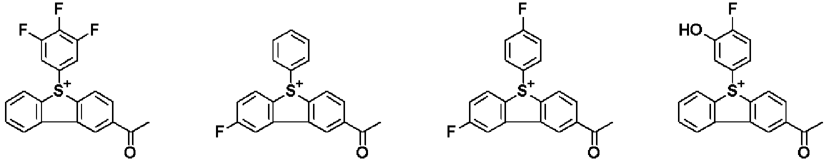

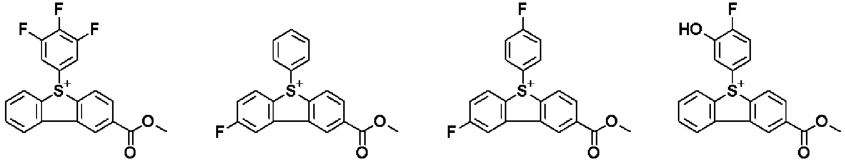

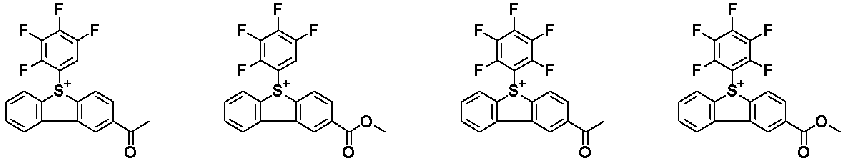

Specific examples of the iodonium cation represented by the above general formula (3) are shown below, but not limited thereto.

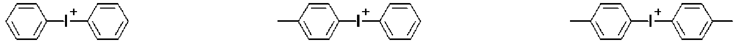

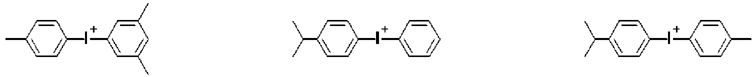

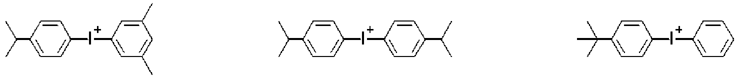

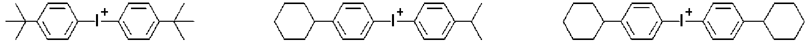

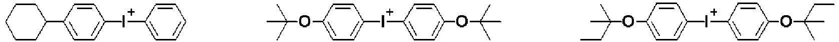

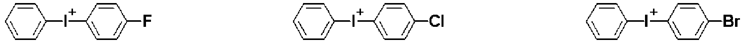

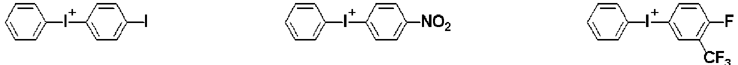

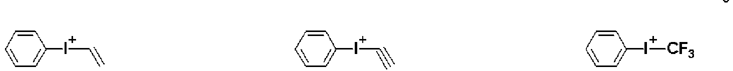

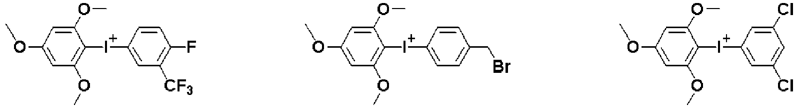

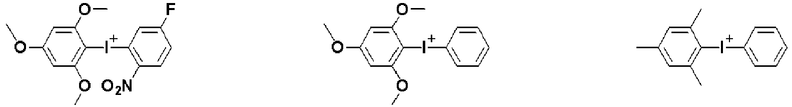

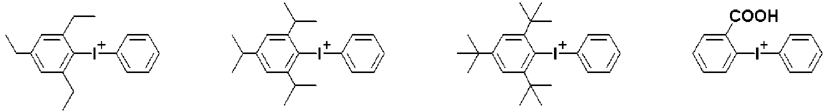

The structural unit having the above organic sulfonyl anion structure preferably contains an iodine atom. Due to high atomic absorption of EUV light in an iodine atom, a sensitization effect on EUV light can be obtained, which improves removal of a residue at a bottom of a pattern as well as pattern roughness.

A proportion of the repeating unit represented by the above general formula (1) is preferably 70 mol% or more and 99.9 mol% or less relative to whole repeating units in the above resin (A).

Moreover, the proportion of the repeating unit represented by the above general formula (1) is more preferably 80 mol% or more and 99.9 mol% or less, further preferably 80 mol% or more and 99 mol% or less, relative to whole repeating units in the above resin (A), but not limited thereto. As described above, the nitrogen-hydrogen bond of the repeating unit represented by the above general formula (1) contributes to the application performance and thus, the high content percentage thereof is preferable from the viewpoint of securing the application performance.

Moreover, a proportion of the repeating unit having the organic sulfonyl anion structure is preferably 0.1 mol% or more and 30 mol% or less, more preferably 0.1 mol% or more and 20 mol% or less, and further preferably 1 mol% or more and 20 mol% or less relative to whole repeating units in the above resin (A), but not limited thereto.

By controlling the proportion of the above organic sulfonyl anion structure in the repeating units of the resin (A), it is possible to impart appropriate patterning performance to be required for each process.

Note that when a total mole fraction of the repeating unit represented by the above general formula (1) and the repeating unit having the organic sulfonyl anion structure is not 100%, the resin (A) contains other structural units. In this case, existing ones can be suitably used as the other structural units. For example, any of structural units derived from the following can be used in combination, but the other structural units are not limited thereto: α,β-unsaturated carboxylic acid esters, such as other acrylates, other methacrylates, other acrylic acid amides, other methacrylamides, crotonates, maleates, and itaconates; α,β-unsaturated carboxylic acids, such as methacrylic acid, acrylic acid, maleic acid, and itaconic acid; acrylonitrile; methacrylonitrile; α,β-unsaturated lactones such as 5,5-dimethyl-3-methylene-2-oxotetrahydrofuran; cyclic olefins such as norbornene derivatives and tetracyclo[4.4.0.1^{2,5}.1^{7,10}]dodecene derivatives; α,β-unsaturated carboxylic acid anhydrides, such as maleic anhydride and itaconic anhydride; allyl ethers; vinyl ethers; vinyl esters; and vinyl silanes.

In a case of exposing a resist upper layer film to EUV light, it is preferable to contain an iodine atom in the other structural units. Due to high atomic absorption of EUV light in an iodine atom, a sensitization effect on EUV light can be obtained. Therefore, it is preferable from the viewpoints of removal of a residue at a bottom of a pattern and improvement of pattern roughness.

When it is desired to prevent collapse of a resist upper layer film, it is preferable to contain a phenolic hydroxy group in the other structural units. The phenolic hydroxy group forms a hydrogen bond with an upper layer resist composition, thereby contributing to preventing the collapse. Examples of the structural unit containing the phenolic hydroxy group include, but are not limited to, structural units contained in the resin described in paragraphs [0058] to [0059] in JP 2023-094359 A. Since the phenolic hydroxy group can also become a hydrogen bond donor, there is less adverse effect on the application performance even when such structural units are contained. Therefore, it is also preferable from the viewpoint of the application performance on a hydrophobic surface.

Moreover, the resin (A) preferably contains no epoxide structure or oxetane structure.

If an epoxide structure or oxetane structure which cannot become a hydrogen bond donor is contained in the resin, a hydrogen bond between an adhesive film derived from the composition for forming an adhesive film of the present invention and an underlayer film may be inhibited and an application error may easily occur. Therefore, these structures are preferably not contained in the resin from the viewpoint of securing the application performance on a hydrophobic surface.

Additionally, the above resin (A) preferably has a weight average molecular weight (Mw) of 1,000 to 70,000, more preferably 10,000 to 50,000. When Mw is 1,000 or more, excellent film formability can be imparted, and generation of a sublimate can be reduced during heat curing to prevent the sublimate from contaminating an apparatus. On the other hand, when Mw is 70,000 or less, poor application performance and occurrence of application defects due to insufficient solubility in an organic solvent can be prevented. Moreover, in the resin (A), a molecular weight distribution (Mw/Mn) is preferably 1.0 to 2.8, more preferably 1.0 to 2.5. Incidentally, Mw and the molecular weight distribution in the present invention are measured by gel permeation chromatography (GPC) in terms of polystyrene using tetrahydrofuran (THF) as a solvent. A measurement temperature in this event is set to 40°C.

By using the composition for forming an adhesive film including such resin to form a multilayer resist film which is applied to fine processing in a manufacturing process of a semiconductor apparatus and the like, it is possible to provide: a composition for forming an adhesive film that has favorable application performance even on a hydrophobic underlayer film and enables residue improvement at a bottom of a resist while maintaining favorable pattern roughness; a method for forming an adhesive film; and a patterning process.

The above resin (A) can be synthesized in a known manner, by polymerizing each monomer protected by a protective group as necessary, followed by a deprotection reaction as necessary. The polymerization reaction is not particularly limited, but preferably radical polymerization or anion polymerization. Regarding these methods, it is possible to refer to JP 2004-115630 A.

### [(B) Organic Solvent]

The organic solvent (B) included in the composition for forming an adhesive film of the present invention is not particularly limited as long as it can dissolve the above resin (A) and other additives (if included). The above organic solvent (B) is preferably a mixture of one or more kinds of organic solvents having a boiling point of lower than 150°C and one or more kinds of organic solvents having a boiling point of 150°C or higher and lower than 220°C. Specific examples of usable organic solvents include: ketones such as cyclohexanone, cyclopentanone, methyl-2-n-pentyl ketone, and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; lactones such as γ-butyrolactone; and the like, as described in paragraphs [0144] to [0145] of JP 2008-111103 A. Propylene glycol monomethyl ether acetate, propylene glycol monomethyl ether, propylene glycol monoethyl ether, cyclopentanone, and a mixture of one or more of them are preferably used as the organic solvent having a boiling point of lower than 150°C. Cyclohexanone, diacetone alcohol, ethyl lactate, γ-butyrolactone, and a mixture of one or more of them are preferably used as the organic solvent having a boiling point of 150°C or higher and lower than 220°C. Note that, the boiling point is a boiling point at normal pressure.

The organic solvent (B) is added in an amount of preferably 5,000 parts by mass or more, more preferably 8,000 parts by mass or more, relative to 100 parts by mass of the above resin (A).

### [Additives]

The composition for forming an adhesive film of the present invention can further include one or more selected from (C) a thermal acid generator, (D) a surfactant, and (E) a crosslinking agent, in addition to the above components (A) and (B). By adjusting the kinds and amounts of these additives, it is possible to optimize curing temperature and application performance of the composition for forming an adhesive film, as well as various kinds of performance including patterning performance. Hereinafter, each component will be described.

### [(C) Thermal Acid Generator]

The thermal acid generator (C) can be added to the composition for forming an adhesive film of the present invention in order to facilitate a heat-induced crosslinking reaction.

Examples of the thermal acid generator (C) usable in the composition for forming an adhesive film of the present invention include the one represented by the following general formula (4), etc. 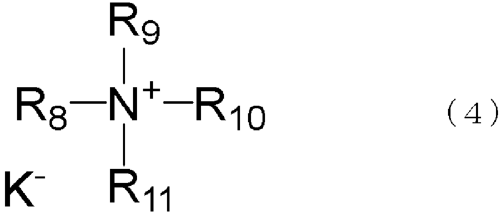 In the formula, K⁻ represents a non-nucleophilic counter ion; each of R₈, R₉, R₁₀, and R₁₁ represents a hydrogen atom, a linear, branched, or cyclic alkyl group or oxoalkyl group having 1 to 12 carbon atoms, a linear, branched, or cyclic alkenyl group or oxoalkenyl group having 2 to 12 carbon atoms, an aryl group having 6 to 20 carbon atoms, or an aralkyl group or aryloxoalkyl group having 7 to 12 carbon atoms, wherein some or all of hydrogen atoms in these groups are optionally substituted with an alkoxy group or the like; additionally, R₈ and R₉, or R₈, R₉, and R₁₀ optionally bond together to form a ring, and when they form a ring, R₈ and R₉, or R₈, R₉, and R₁₀ represent an alkylene group having 3 to 10 carbon atoms or a heteroaromatic ring having a nitrogen atom in the formula in the ring.

The above R₈, R₉, R₁₀, and R₁₁ may be the same or different from each other, and specific examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexenyl group, a cycloheptyl group, a cyclopropylmethyl group, a 4-methylcyclohexyl group, a cyclohexylmethyl group, a norbornyl group, an adamantyl group, and the like. Examples of the alkenyl group include a vinyl group, an allyl group, a propenyl group, a butenyl group, a hexenyl group, a cyclohexenyl group, and the like. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, and the like. Examples of the oxoalkenyl group include a 2-oxo-4-cyclohexenyl group, a 2-oxo-4-propenyl group, and the like. Examples of the aryl group include: a phenyl group, a naphthyl group, and the like; alkoxyphenyl groups such as a p-methoxyphenyl group, a m-methoxyphenyl group, an o-methoxyphenyl group, ethoxyphenyl group, a p-tert-butoxyphenyl group, and a m-tert-butoxyphenyl group; alkylphenyl groups such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups such as a methylnaphthyl group and an ethylnaphthyl group; alkoxynaphthyl groups such as a methoxynaphthyl group and an ethoxynaphthyl group; dialkylnaphthyl groups such as a dimethylnaphthyl group and a diethylnaphthyl group; dialkoxynaphthyl groups such as a dimethoxynaphthyl group and a diethoxynaphthyl group; and the like. Examples of the aralkyl group include a benzyl group, a phenylethyl group, a phenetyl group, and the like. Examples of the aryloxoalkyl group include 2-aryl-2-oxoethyl groups such as a 2-phenyl-2-oxoethyl group, a 2-(1-naphthyl)-2-oxoethyl group, and a 2-(2-naphthyl)-2-oxoethyl group, etc.

Furthermore, examples of the heteroaromatic ring having the nitrogen atom in the formula in the ring, which is formed by R₈ and R₉ or R₈, R₉, and R₁₀, include imidazole derivatives (for example, imidazole, 4-methylimidazole, 4-methyl-2-phenylimidazole, and the like), pyrazole derivatives, furazan derivatives, pyrroline derivatives (for example, pyrroline, 2-methyl-1-pyrroline, and the like), pyrrolidine derivatives (for example, pyrrolidine, N-methylpyrrolidine, pyrrolidinone, N-methylpyrrolidone, and the like), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, and the like), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, and the like), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, and the like.

Examples of the aforementioned non-nucleophilic counter ion of K⁻ include: halide ions such as chloride ion and bromide ion; fluoroalkylsulfonates such as triflate, 1,1,1-trifluoroethanesulfonate, and nonafluorobutanesulfonate; arylsulfonates such as tosylate, benzenesulfonate, 4-fluorobenzenesulfonate, and 1,2,3,4,5-pentafluorobenzenesulfonate; alkylsulfonates such as mesylate and butanesulfonate; imide acids such as bis(trifluoromethylsulfonyl)imide, bis(perfluoroethylsulfonyl)imide, and bis(perfluorobutylsulfonyl)imide; and methide acids such as tris(trifluoromethylsulfonyl)methide and tris(perfluoroethylsulfonyl)methide. Further examples thereof include a sulfonate with an α-position substituted with fluoro, represented by the following general formula (5), and a sulfonate with α- and β-positions substituted with fluoro, represented by the following general formula (6).

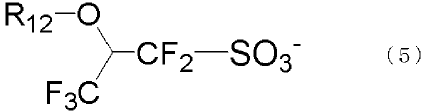

R₁₃-CF₂-CF₂-SO₃⁻ (6)

In the above general formula (5), R₁₂ represents a hydrogen atom, a linear, branched, or cyclic alkyl group having 1 to 20 carbon atoms, an acyl group or alkenyl group having 2 to 20 carbon atoms, or an aryl group or aryloxy group having 6 to 20 carbon atoms. In the above general formula (6), R₁₃ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the above thermal acid generator (C) are shown below.

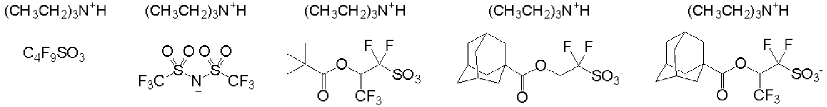

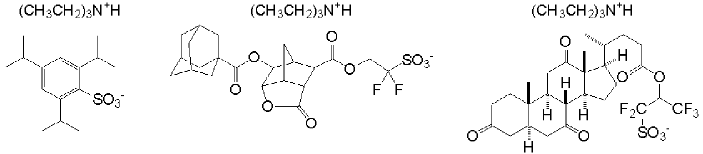

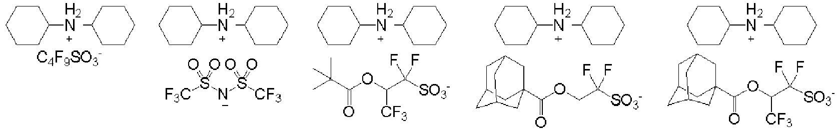

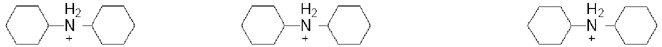

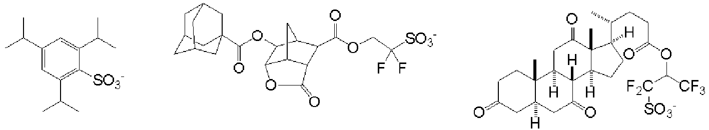

The thermal acid generator (C) included in the composition for forming an adhesive film of the present invention can be used alone or in combination of two or more kinds thereof. The thermal acid generator (C) is added preferably in an amount of 0.05 to 30 parts by mass, more preferably in an amount of 0.1 to 10 parts by mass, relative to 100 parts by mass of the above resin (A). When the amount is 0.05 parts by mass or more, a sufficient amount of acid is generated and a crosslinking reaction proceeds sufficiently. When the amount is 30 parts by mass or less, a mixing phenomenon due to acid migration to an upper layer resist will never occur.

### [(D) Surfactant]

The surfactant (D) can be added to the composition for forming an adhesive film of the present invention in order to enhance application performance by spin coating. The surfactant (D) can be used alone or in combination of two or more kinds thereof. As the surfactant (D), for example, those described in paragraphs [0142] to [0147] of JP 2009-269953 A can be used. An addition amount of the surfactant (D), if added, is preferably 0.001 to 20 parts by mass, more preferably 0.01 to 10 parts by mass, relative to 100 parts by mass of the above resin (A).

### [(E) Crosslinking Agent]

Furthermore, the crosslinking agent (E) can also be added to the composition for forming an adhesive film of the present invention in order to enhance a curing property and further prevent intermixing with a resist upper layer film. The crosslinking agent is not particularly limited, and various known types of crosslinking agents can widely be used. Examples thereof include melamine crosslinking agents, glycoluril crosslinking agents, benzoguanamine crosslinking agents, urea crosslinking agents, β-hydroxyalkylamide crosslinking agents, isocyanurate crosslinking agents, aziridine crosslinking agents, oxazoline crosslinking agents, epoxy crosslinking agents, and polynuclear phenolic crosslinking agents.

Specific examples of the melamine crosslinking agents include hexamethoxymethylated melamine, hexabutoxymethylated melamine, alkoxy- and/or hydroxy-substituted derivatives thereof, and partial self-condensates thereof.

Specific examples of the glycoluril crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea crosslinking agents include dimethoxymethylated dimethoxyethyleneurea, alkoxy- and/or hydroxy-substituted derivatives thereof, and partial self-condensates thereof.

A specific example of the β-hydroxyalkylamide crosslinking agents is N,N,N',N'-tetra(2-hydroxyethyl)adipic acid amide.

Specific examples of the isocyanurate crosslinking agents include triglycidyl isocyanurate and triallyl isocyanurate.

Specific examples of the aziridine crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline crosslinking agents include 2,2'-isopropylidenebis(4-benzyl-2-oxazoline), 2,2'-isopropylidenebis(4-phenyl-2-oxazoline), 2,2'-methylenebis(4,5-diphenyl-2-oxazoline), 2,2'-methylenebis(4-phenyl-2-oxazoline), 2,2'-methylenebis(4-tertbutyl-2-oxazoline), 2,2'-bis(2-oxazoline), 1,3-phenylenebis(2-oxazoline), 1,4-phenylenebis(2-oxazoline), and 2-isopropenyloxazoline copolymer.

Specific examples of the epoxy crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

A specific example of the polynuclear phenolic crosslinking agents is a compound represented by the following general formula (7).

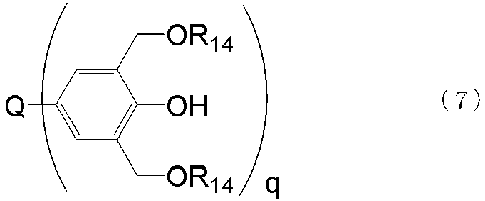

In the formula, Q represents a single bond or a q-valent hydrocarbon group having 1 to 20 carbon atoms; R₁₄ represents a hydrogen atom or an alkyl group having 1 to 20 carbon atoms; and "q" represents an integer of 1 to 5.

Q represents a single bond or a q-valent hydrocarbon group having 1 to 20 carbon atoms. "q" represents an integer of 1 to 5, more preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₁₄ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group, among which a hydrogen atom or a methyl group is preferred.

Specific examples of the compound represented by the above general formula (7) include the following compounds. Among them, hexamethoxymethylated forms of triphenolmethane, triphenolethane, 1,1,1-tris(4-hydroxyphenyl) ethane, and tris(4-hydroxyphenyl)-1-ethyl-4-isopropylbenzene are preferred from the viewpoint of enhancing a curing property and film thickness uniformity of an adhesive film.

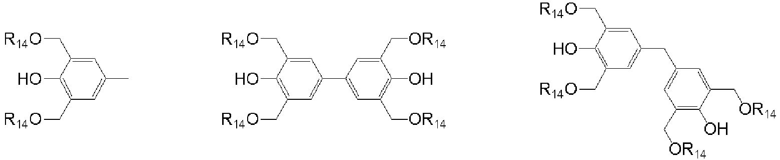

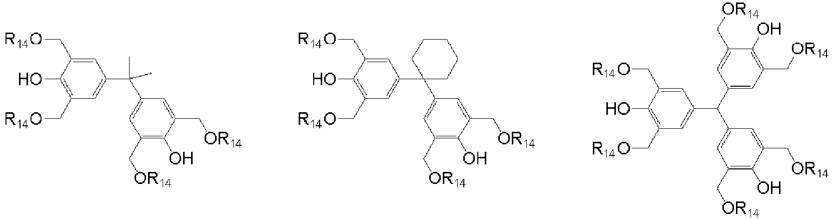

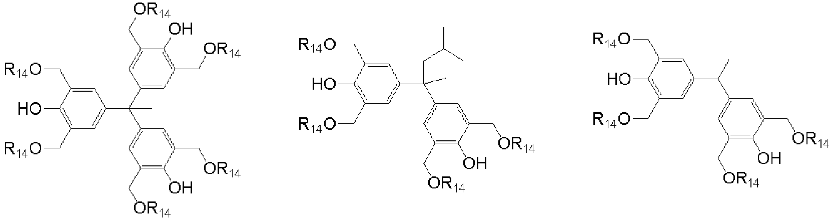

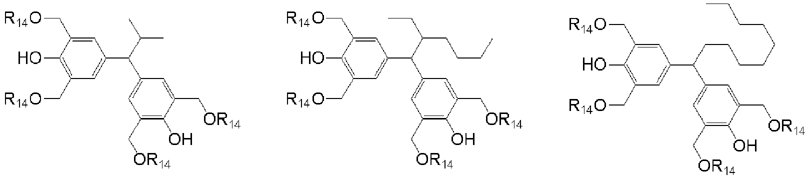

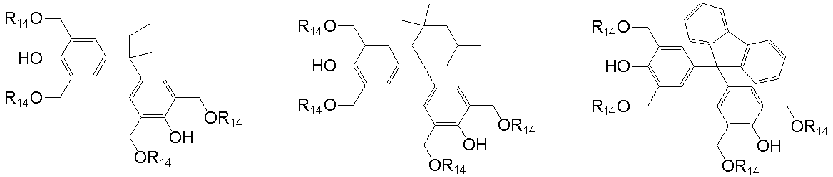

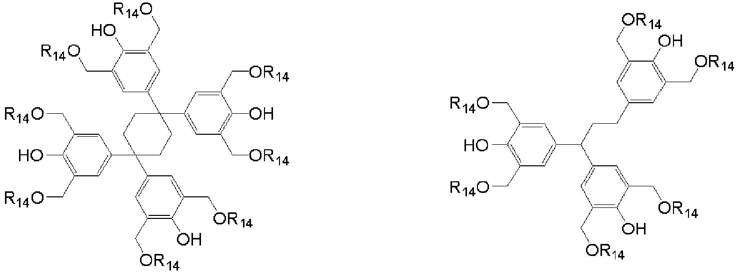

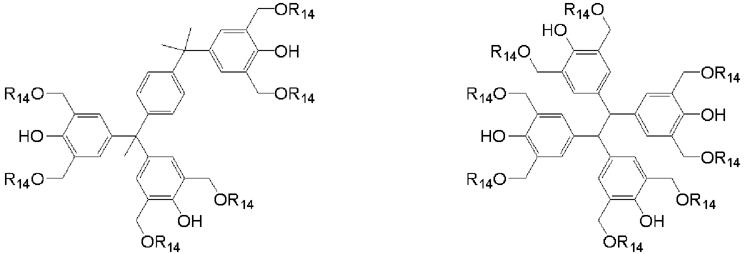

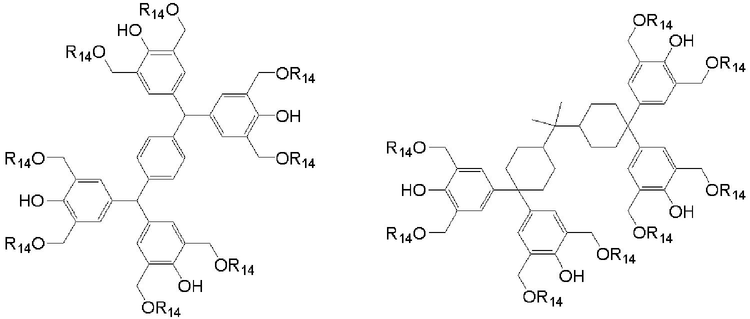

The above crosslinking agent (E) can be used alone or in combination of two or more kinds thereof. An addition amount of the crosslinking agent (E) is preferably 10 mass% to 50 mass%, more preferably 10 mass% to 30 mass%, relative to 100 parts by mass of the above resin (A). When the addition amount is 10 mass% or more, the sufficient curing property can be exhibited so as to prevent intermixing with a resist upper layer film. On the other hand, when the addition amount is 50 mass% or less, the proportion of the resin (A) in the composition is kept high, causing no deterioration in the application performance on a hydrophobic surface.

A thickness of a film formed from the composition for forming an adhesive film of the present invention is selected as appropriate, but preferably 2 to 100 nm, particularly preferably 5 to 20 nm.

Moreover, the composition for forming an adhesive film of the present invention is extremely useful as an adhesive film material for a multilayer resist process, such as a two-layer resist process, and a four-layer resist process using a resist underlayer film and a silicon-containing middle layer film.

The above silicon-containing middle layer film can be used as a silicon-containing resist middle layer film or an inorganic hard mask middle layer film according to a patterning process as described later. The above inorganic hard mask middle layer film is preferably selected from a silicon oxide film, a silicon nitride film, and a silicon oxynitride film.

Note that in the present invention, the film formed from the composition containing the components (A) and (B) is referred to as "adhesive film", but the film formed in the present invention may also be referred to as "underlayer film" or "middle layer film" in a multilayer resist method, as described above. Organic films obtained by heat treatment or the like for curing the film formed from the composition containing the components (A) and (B) are included in the scope of the present invention, regardless of their names.

### [Method for Forming Adhesive Film]

The present invention provides a method for forming an adhesive film. The method utilizes the above-described composition for forming an adhesive film, and forms an adhesive film that has favorable application performance even on a hydrophobic underlayer film and enables residue improvement at a bottom of a resist while keeping favorable pattern roughness in a fine patterning process of a multilayer resist method in a manufacturing process of a semiconductor apparatus.

In the method for forming an adhesive film of the present invention, the above-described composition for forming an adhesive film is coated on a substrate to be processed by a spin-coat method or the like. After the spin coating, baking (heat treatment) is performed to evaporate the organic solvent and facilitate a crosslinking reaction to prevent intermixing with a resist upper layer film or a silicon-containing middle layer film. The baking is preferably performed at 100°C or higher and 300°C or lower for 10 to 600 seconds, and more preferably performed at 200°C or higher and 250°C or lower for 10 to 300 seconds. Considering effects on adhesive film damage and deformation of a wafer, an upper limit of a heating temperature in a wafer process of lithography is preferably 300°C or lower and more preferably 250°C or lower.

Thus, the present invention provides a method for forming an adhesive film to be used in a manufacturing process of a semiconductor apparatus. The method includes: spin-coating a substrate to be processed with the above-described composition for forming an adhesive film; and forming an adhesive film by heating the substrate coated with the composition for forming an adhesive film at a temperature of 100°C or higher and 300°C or lower for 10 to 600 seconds.

Furthermore, in the method for forming an adhesive film of the present invention, it is also possible to form an adhesive film by coating the composition for forming an adhesive film of the present invention on a substrate to be processed by a spin coating method or the like in the same manner as described above, and baking and curing the composition for forming an adhesive film under an atmosphere with an oxygen concentration of 0.1% or more and 21% or less. By baking the composition for forming an adhesive film of the present invention under such oxygen atmosphere, a sufficiently cured adhesive film can be obtained. Moreover, the baking temperature, etc. can be the same as described above.

Thus, the present invention provides a method for forming an adhesive film to be used in a manufacturing process of a semiconductor apparatus. The method includes: spin-coating a substrate to be processed with the above-described composition for forming an adhesive film; and forming an adhesive film by heating the substrate coated with the composition for forming an adhesive film under an atmosphere with an oxygen concentration of 0.1% or more and 21% or less.

The atmosphere during the baking may be air, but also inert gas such as N₂, Ar, and He may be filled. In this event, the atmosphere can have an oxygen concentration of 0.0001% or more and less than 0.1%. Moreover, the baking temperature, etc. can be the same as described above. By baking the composition for forming an adhesive film of the present invention under such oxygen atmosphere, it is possible to facilitate a crosslinking reaction during forming the adhesive film without causing deterioration of the substrate to be processed, even when the substrate to be processed includes a material which becomes unstable during heating under an oxygen atmosphere.

Thus, the present invention provides a method for forming an adhesive film to be used in a manufacturing process of a semiconductor apparatus. The method includes: spin-coating a substrate to be processed with the above-described composition for forming an adhesive film; and forming an adhesive film by heating the substrate coated with the composition for forming an adhesive film under an atmosphere with an oxygen concentration of 0.0001% or more and less than 0.1%.

### [Patterning Process]

The present invention provides a patterning process for forming a pattern in a substrate to be processed, including the steps of:
(I-1) applying the above-described composition for forming an adhesive film on the substrate to be processed and thereafter performing heat treatment to form an adhesive film;
(I-2) forming a resist upper layer film on the adhesive film using a photoresist material;
(I-3) forming a circuit pattern in the resist upper layer film by developing the resist upper layer film using a developer after pattern exposure;
(I-4) transferring a pattern to the adhesive film by dry etching while using the resist upper layer film having the formed circuit pattern as a mask; and
(I-5) processing the substrate to be processed while using the resist upper layer film and/or the adhesive film having the formed pattern as a mask to form a pattern in the substrate to be processed.

The patterning process of the present invention will be described below by taking a four-layer resist process as an example, but not limited to this process. Firstly, provided is a patterning process for forming a pattern in a substrate to be processed. The method at least includes: forming a resist underlayer film on a substrate to be processed using an organic film material; forming a silicon-containing middle layer film (silicon-containing resist middle layer film) on the resist underlayer film using a resist middle layer film material containing silicon atoms; forming an adhesive film on the silicon-containing resist middle layer film using the composition for forming an adhesive film of the present invention; forming a resist upper layer film on the adhesive film using a resist upper layer film material consisting of a photoresist composition, thereby yielding a multilayer resist film; forming a resist upper layer film pattern in the resist upper layer film by exposing and then developing a pattern circuit area of the resist upper layer film using a developer; forming an adhesive film pattern by etching the adhesive film while using the obtained resist upper layer film pattern as an etching mask; forming a silicon-containing resist middle layer film pattern by etching the silicon-containing resist middle layer film while using the resist upper layer film pattern and/or the adhesive film pattern remaining after the previous etching as an etching mask; forming a resist underlayer film pattern by etching the resist underlayer film while using the obtained silicon-containing resist middle layer film pattern as an etching mask; and further forming a pattern in the substrate to be processed by etching the substrate to be processed while using the obtained resist underlayer film pattern as an etching mask.

Thus, the present invention provides a patterning process for forming a pattern in a substrate to be processed, including the steps of:
(II-1) forming a resist underlayer film on the substrate to be processed;
(II-2) forming a silicon-containing resist middle layer film on the resist underlayer film;
(II-3) applying the above-described composition for forming an adhesive film on the silicon-containing resist middle layer film and thereafter performing heat treatment to form an adhesive film;
(II-4) forming a resist upper layer film on the adhesive film using a photoresist material;
(II-5) forming a circuit pattern in the resist upper layer film by developing the resist upper layer film using a developer after pattern exposure;
(II-6) transferring a pattern to the adhesive film by dry etching while using the resist upper layer film having the formed circuit pattern as a mask;
(II-7) transferring a pattern to the silicon-containing resist middle layer film by dry etching while using the resist upper layer film and/or the adhesive film having the formed pattern as a mask;
(II-8) transferring a pattern to the resist underlayer film by dry etching while using the silicon-containing resist middle layer film having the transferred pattern as a mask; and
(II-9) processing the substrate to be processed while using the resist underlayer film having the transferred pattern as a mask to form a pattern in the substrate to be processed.

As the silicon-containing resist middle layer film in the above four-layer resist process, a polysilsesquioxane-based middle layer film is also preferable for use. By providing the silicon-containing resist middle layer film with an antireflection effect, it is possible to suppress reflection. When a material containing many aromatic groups and having high substrate etching resistance is used as the resist underlayer film especially for exposure at 193 nm, the k-value and thus the substrate reflection increase. However, suppression of the reflection by the silicon-containing resist middle layer film can reduce the substrate reflection to 0.5% or less. Preferably used as the silicon-containing resist middle layer film having the antireflection effect is polysilsesquioxane having a pendant anthracene for exposure at 248 nm or 157 nm, or a pendant phenyl group or a pendant light-absorbing group having a silicon-silicon bond for exposure at 193 nm, where the polysilsesquioxane is cross-linked by acid or heat.

In this case, it is simpler and more cost advantageous to form the silicon-containing resist middle layer film by a spin coat method, rather than a CVD method.

Moreover, an inorganic hard mask middle layer film may be formed as the silicon-containing middle layer film. In this case, it is at least possible to: form a resist underlayer film on a substrate to be processed using an organic film material; form an inorganic hard mask middle layer film selected from a silicon oxide film, a silicon nitride film, and a silicon oxynitride film on the resist underlayer film; form an adhesive film on the inorganic hard mask middle layer film using the composition for forming an adhesive film of the present invention; form a resist upper layer film on the adhesive film using a resist upper layer film material consisting of a photoresist composition, and expose and then develop a pattern circuit area of the resist upper layer film using a developer to form a resist upper layer film pattern in the resist upper layer film; form an adhesive film pattern by etching the adhesive film while using the obtained resist upper layer film pattern as an etching mask; form an inorganic hard mask middle layer film pattern by etching the inorganic hard mask middle layer film while using the obtained adhesive film pattern as an etching mask; form a resist underlayer film pattern by etching the resist underlayer film while using the obtained inorganic hard mask middle layer film pattern as an etching mask; and further form a pattern in the substrate to be processed by etching the substrate to be processed while using the obtained resist underlayer film pattern as an etching mask.

Thus, the present invention provides a patterning process for forming a pattern in a substrate to be processed, including the steps of:
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the above-described composition for forming an adhesive film on the inorganic hard mask middle layer film and thereafter performing heat treatment to form an adhesive film;
(III-4) forming a resist upper layer film on the adhesive film using a photoresist material;
(III-5) forming a circuit pattern in the resist upper layer film by developing the resist upper layer film using a developer after pattern exposure;
(III-6) transferring a pattern to the adhesive film by dry etching while using the resist upper layer film having the formed circuit pattern as a mask;
(III-7) transferring a pattern to the inorganic hard mask middle layer film by dry etching while using the resist upper layer film and/or the adhesive film having the formed pattern as a mask;
(III-8) transferring a pattern to the resist underlayer film by dry etching while using the inorganic hard mask middle layer film having the transferred pattern as a mask; and
(III-9) processing the substrate to be processed while using the resist underlayer film having the transferred pattern as a mask to form a pattern in the substrate to be processed.

As described above, in the case of forming the inorganic hard mask middle layer film on the resist underlayer film, a silicon oxide film, a silicon nitride film, and a silicon oxynitride film (SiON film) can be formed by a CVD, ALD, or other methods. In other words, the inorganic hard mask middle layer film is preferably formed by a CVD or ALD method. For example, a method for forming a silicon nitride film is described in JP 2002-334869 A and WO 2004/066377 A1. The inorganic hard mask middle layer film has a film thickness of preferably 5 to 200 nm, more preferably 10 to 100 nm. Additionally, a SiON film, which is highly effective as an antireflective film, is the most preferable for use as the inorganic hard mask middle layer film. Since a substrate temperature during forming the SiON film becomes 300 to 500°C, the resist underlayer film should withstand the temperature of 300 to 500°C.

In the above four-layer resist process, the resist upper layer film may be either a positive or negative type, and a photoresist composition same as those typically used as a photoresist material can be used therefor. Additionally, the photoresist material preferably contains at least an organometallic compound and a solvent, where the organometallic compound more preferably contains at least one selected from titanium, cobalt, copper, zinc, zirconium, lead, indium, tin, antimony, and hafnium, but the photoresist material is not limited thereto. After spin-coating the photoresist composition, prebaking is performed preferably at 60 to 180°C for 10 to 300 seconds. Thereafter, exposure is performed according to a usual manner, followed by post exposure bake (PEB) and development, thereby obtaining the resist upper layer film pattern. Note that a thickness of the resist upper layer film is not particularly limited, but preferably 30 to 500 nm and particularly preferably 50 to 400 nm.

When the photoresist material is the composition containing at least the organometallic compound and a solvent, it is possible to impart a collapse prevention effect on a fine pattern and appropriately adjust a pattern profile, exposure sensitivity, etc. of the resist upper layer film. At the same time, in the case of using the photoresist material containing the organometallic compound and a solvent, it is possible to prevent the metallic compound from contaminating the substrate to be processed.

The circuit pattern (resist upper layer film pattern) is formed in the resist upper layer film. As a method for forming the circuit pattern in the resist upper layer film, photolithography with a wavelength of 10 nm or more and 300 nm or less, direct drawing using an electron beam, nanoimprinting, or a combination thereof is preferably used.

Note that exposure light includes high-energy ray having a wavelength of 300 nm or less. Specific examples thereof include far ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) with 3 to 20 nm, electron beam (EB), ion beam, X-ray, and the like.

Additionally, a development method of the circuit pattern is preferably alkaline development or development using an organic solvent.

Next, etching is performed by using the obtained resist upper layer film pattern as a mask. The etching of the adhesive film in the four-layer resist process is performed with an oxygen gas while the resist upper layer film pattern is used as a mask. In this manner, the adhesive film pattern is formed.

Next, the resist upper layer film pattern and/or the adhesive film pattern remaining after the previous etching is used as a mask to perform etching. The etching of the silicon-containing resist middle layer film and the inorganic hard mask middle layer film is performed with a chlorofluorocarbon gas while the resist upper layer film pattern and/or the adhesive film pattern remaining after the previous etching is used as a mask. In this manner, the silicon-containing resist middle layer film pattern and the inorganic hard mask middle layer film pattern are formed.

The etching of the adhesive film may be performed consecutively prior to the etching of the silicon-containing middle layer film, or an etching apparatus can be changed after performing only the etching of the adhesive film, and then the etching of the silicon-containing middle layer film can be performed.

Next, the obtained silicon-containing resist middle layer film pattern or the inorganic hard mask middle layer film pattern is used as a mask to perform etching of the resist underlayer film.

Subsequent etching of the substrate to be processed can also be performed in a usual manner. For example, when the substrate to be processed is a SiO₂, SiN, or silica low-dielectric insulating film, etching is performed mainly using a chlorofluorocarbon gas. When the substrate to be processed is made of p-Si, Al, or W, etching is performed mainly using a chlorine or bromine gas. When the substrate is processed by etching with a chlorofluorocarbon gas, the silicon-containing middle layer film pattern in the three-layer resist process is debonded simultaneously with the processing of the substrate. When the substrate is processed by etching with a chlorine or bromine gas, the silicon-containing middle layer film pattern should be separately debonded by dry etching with a chlorofluorocarbon gas after processing of the substrate.

Note that the substrate to be processed is not particularly limited. A semiconductor apparatus substrate or the semiconductor apparatus substrate coated with any of a metal film, a metal carbide film, a metal oxide film, a metal nitride film, a metal oxycarbide film, and a metal oxynitride film can be used. Usable as the metal is silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Specifically, a substrate made of Si, α-Si, p-Si, SiO₂, SiN, SiON, W, TiN, Al, or the like, or the substrate on which a layer to be processed is deposited, etc., is used. As the layer to be processed, various Low-k films such as those made of Si, SiO₂, SiON, SiN, p-Si, α-Si, W, W-Si, Al, Cu, or Al-Si, and a stopper film thereof are used, which can be formed to have a thickness of typically 50 to 10,000 nm and particularly 100 to 5,000 nm. Note that in the case of depositing the layer to be processed, the substrate and the layer to be processed for use are made of different materials.

An example of the four-layer resist process will be specifically described below with reference to FIG. 1. In the case of the four-layer resist process, as illustrated in FIG. 1(A), a resist underlayer film 3 is formed on a layer to be processed 2, which is laminated on a substrate 1, using an organic film material. Thereafter, a silicon-containing middle layer film 4 is formed, an adhesive film 5 is formed thereon using the composition for forming an adhesive film of the present invention, and a resist upper layer film 6 is formed thereon.

Next, as illustrated in FIG. 1(B), an exposed portion 7 of the resist upper layer film is exposed and subjected to PEB and development to form a resist upper layer film pattern 6a (FIG. 1(C)). The adhesive film 5 is processed by etching with O₂ gas while using the obtained resist upper layer film pattern 6a as a mask, thereby forming an adhesive film pattern 5a (FIG. 1(D)). The silicon-containing middle layer film 4 is processed by etching with CF gas while using the obtained adhesive film pattern 5a as a mask, thereby forming a silicon-containing middle layer film pattern 4a (FIG. 1(E)). After removing the adhesive film pattern 5a, the resist underlayer film 3 is processed by etching with O₂ gas while using the obtained silicon-containing middle layer film pattern 4a as a mask, thereby forming a resist underlayer film pattern 3a (FIG. 1(F)). Further, after removing the silicon-containing middle layer film pattern 4a, the layer to be processed 2 is processed by etching while using the resist underlayer film pattern 3a as a mask, thereby forming a pattern 2a (FIG. 1(G)).

In this manner, with the patterning process of the present invention, it is possible to form a fine pattern in a substrate to be processed with high precision in a multilayer resist process.

### EXAMPLE

Hereinafter, the present invention will be more specifically described with reference to Synthesis Examples, Comparative Synthesis Examples, Examples, and Comparative Examples. However, the present invention is not limited thereto. Incidentally, a molecular weight was measured by gel permeation chromatography (GPC) using tetrahydrofuran (THF) or N,N-dimethylformamide (DMF) as an eluent, and a dispersity (Mw/Mn) was determined based on a weight average molecular weight (Mw) and a number average molecular weight (Mn) in terms of polystyrene. The measurement temperature was 40°C.

Monomers (B1) to (B21) shown below were used for synthesis of polymers (A1) to (A24) and comparative polymers (R1) to (R5), which were used as the resin (A) in an adhesive film formation material.

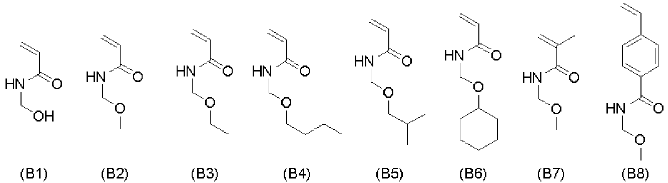

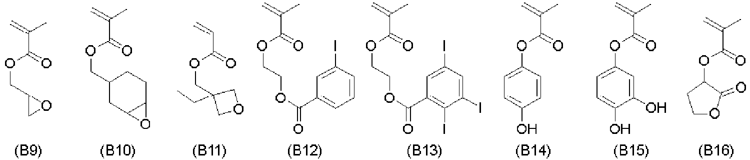

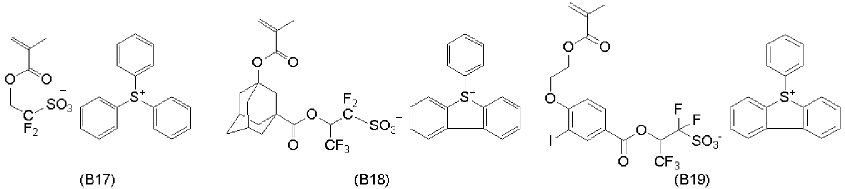

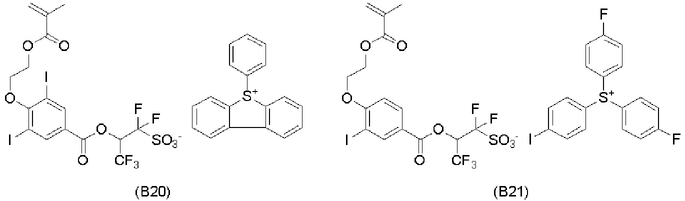

### [Synthesis Example 1] Synthesis of Polymer (A1)

Under a nitrogen atmosphere, 64.9 g of the monomer (B1), 35.1 g of the monomer (B17), 4.13 g of V-601 (dimethyl 2,2'-azobis(isobutyrate), produced by Wako Pure Chemical Corporation), and 340 g of DAA (diacetone alcohol) were measured into a 1 L flask and then degassed under stirring, thereby preparing a monomer-polymerization initiator solution. 60 g of DAA was measured into another 1 L flask under a nitrogen atmosphere, degassed under stirring, and thereafter heated till an internal temperature reached 80°C. The monomer-polymerization initiator solution was added thereto dropwise over 4 hours. Subsequently, the polymerization solution was continuously stirred for 16 hours while the temperature thereof was kept at 80°C, and then cooled to room temperature. The polymerization solution thus obtained was added dropwise to 1,500 g of vigorously stirred hexane, and a precipitated polymer was separated by filtration. Further, the obtained polymer was washed twice with 600 g of hexane, and then dried under vacuum at 50°C for 20 hours to obtain the white powdered polymer (A1) (yield 98.4 g, 95%). The average polymer molecular weight (Mw) and dispersity (Mw/Mn) of the polymer (A1) were determined by GPC as follows: Mw=27,900 and Mw/Mn=1.92.

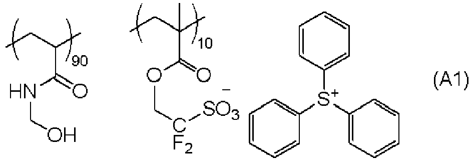

### [Synthesis Examples 2 to 24, Comparative Synthesis Examples 1 to 2] Synthesis of Polymers (A2) to (A24) and Comparative Polymers (R1) to (R2)

The polymers (A2) to (A24) and the comparative polymers (R1) to (R2) were obtained as products through reaction and postprocessing under the same conditions as in Synthesis Example 1, except that the monomers and polymerization initiators shown in Table 1 were used. Furthermore, the weight average molecular weight (Mw) and dispersity (Mw/Mn) determined by GPC are shown together with the polymer (A1).

**[Table 1]**

| | Polymer | Monomer 1 | Weight of Monomer 1 (g) | Monomer 2 | Weight of Monomer 2 (g) | Monomer 3 | Weight of Monomer 3 (g) | Monomer 4 | Weight of Monomer 4 (g) | Weight of V-601 | Molecular weight (Mw) | Dispersity (Mw/Mn) |
|---|---|---|---|---|---|---|---|---|---|---|---|---|
| Synthesis Ex.1 | (A1) | (B1) | 64.9 | (B17) | 35.1 | | | | | 4.13 | 27900 | 1.92 |
| Synthesis Ex.2 | (A2) | (B2) | 67.8 | (B17) | 32.2 | | | | | 3.77 | 28500 | 1.88 |
| Synthesis Ex.3 | (A3) | (B2) | 67.8 | (B17) | 32.2 | | | | | 9.03 | 8000 | 1.86 |
| Synthesis Ex.4 | (A4) | (B2) | 67.8 | (B17) | 32.2 | | | | | 3.01 | 45000 | 1.95 |
| Synthesis Ex.5 | (A5) | (B2) | 81.6 | (B17) | 18.4 | | | | | 4.30 | 25500 | 1.93 |
| Synthesis Ex.6 | (A6) | (B2) | 48.3 | (B17) | 51.7 | | | | | 4.23 | 26100 | 1.98 |
| Synthesis Ex.7 | (A7) | (B2) | 35.3 | (B17) | 64.7 | | | | | 4.03 | 25100 | 1.94 |
| Synthesis Ex.8 | (A8) | (B3) | 70.2 | (B17) | 30.0 | | | | | 4.17 | 27000 | 1.95 |
| Synthesis Ex.9 | (A9) | (B4) | 74.2 | (B17) | 25.8 | | | | | 4.22 | 28700 | 1.90 |
| Synthesis Ex.10 | (A10) | (B5) | 74.2 | (B17) | 25.8 | | | | | 4.23 | 28100 | 1.96 |
| Synthesis Ex.11 | (A11) | (B6) | 77.0 | (B17) | 23.0 | | | | | 3.76 | 30200 | 2.01 |
| Synthesis Ex.12 | (A12) | (B7) | 70.2 | (B17) | 29.8 | | | | | 4.17 | 27700 | 1.91 |
| Synthesis Ex.13 | (A13) | (B8) | 77.7 | (B17) | 22.3 | | | | | 4.16 | 28400 | 1.93 |
| Synthesis Ex.14 | (A14) | (B4) | 65.8 | (B18) | 34.2 | | | | | 4.28 | 27300 | 1.92 |
| Synthesis Ex.15 | (A15) | (B4) | 62.5 | (B19) | 37.5 | | | | | 4.07 | 27800 | 1.98 |
| Synthesis Ex.16 | (A16) | (B4) | 59.2 | (B20) | 40.8 | | | | | 3.85 | 26400 | 1.95 |
| Synthesis Ex.17 | (A17) | (B4) | 58.3 | (B21) | 41.7 | | | | | 3.74 | 28900 | 1.95 |
| Synthesis Ex.18 | (A18) | (B4) | 58.9 | (B9) | 6.65 | (B18) | 34.5 | | | 4.31 | 26700 | 1.92 |
| Synthesis Ex.19 | (A19) | (B4) | 53.4 | (B12) | 15.3 | (B18) | 31.3 | | | 3.91 | 27200 | 1.93 |
| Synthesis Ex.20 | (A20) | (B4) | 48.3 | (B13) | 23.5 | (B18) | 28.3 | | | 3.98 | 28000 | 1.90 |
| Synthesis Ex.21 | (A21) | (B4) | 57.9 | (B14) | 8.20 | (B18) | 33.9 | | | 4.23 | 28300 | 1.89 |
| Synthesis Ex.22 | (A22) | (B4) | 57.5 | (B15) | 8.87 | (B18) | 33.7 | | | 4.21 | 28800 | 1.97 |
| Synthesis Ex.23 | (A23) | (B4) | 52.5 | (B13) | 12.8 | (B15) | 4.05 | (B18) | 30.7 | 3.84 | 27500 | 1.96 |
| Synthesis Ex.24 | (A24) | (B2) | 74.4 | (B9) | 5.74 | (B17) | 19.9 | | | 3.71 | 29200 | 1.91 |
| Synthesis Comp.Ex.1 | (R1) | (B2) | 100 | | | | | | | 1.00 | 25600 | 2.03 |
| Synthesis Comp.Ex.2 | (R2) | (B2) | 62.9 | (B13) | 37.1 | | | | | 4.19 | 27300 | 1.94 |

### [Comparative Synthesis Example 3] Synthesis of Comparative Polymer (R3)

Under a nitrogen atmosphere, 62.8 g of the monomer (B9), 37.2 g of the monomer (B10), 1.45 g of V-601, and 340 g of PGMEA were measured into a 1 L flask and then degassed under stirring, thereby preparing a monomer-polymerization initiator solution. 60 g of PGMEA was measured into another 1 L flask under a nitrogen atmosphere, degassed under stirring, and thereafter heated till an internal temperature reached 80°C. The monomer-polymerization initiator solution was added thereto dropwise over 4 hours. Subsequently, the polymerization solution was continuously stirred for 16 hours while the temperature thereof was kept at 80°C, and then cooled to room temperature. The polymerization solution thus obtained was added dropwise to 1,500 g of vigorously stirred hexane, and a precipitated polymer was separated by filtration. Further, the obtained polymer was washed twice with 600 g of hexane, and then dried under vacuum at 50°C for 20 hours to obtain the white powdered comparative polymer (R3) (yield 97.5 g, 96%). The average polymer molecular weight (Mw) and dispersity (Mw/Mn) of the polymer (R3) were determined by GPC as follows: Mw=33,500 and Mw/Mn=1.88.

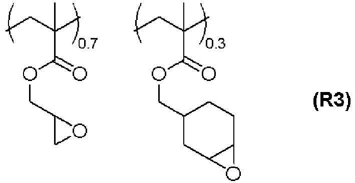

### [Comparative Synthesis Example 4] Synthesis of Comparative Polymer (R4)

Under a nitrogen atmosphere, 64.3 g of the monomer (B9), 35.7 g of the monomer (B11), 1.49 g of V-601, and 340 g of PGMEA were measured into a 1 L flask and then degassed under stirring, thereby preparing a monomer-polymerization initiator solution. 60 g of PGMEA was measured into another 1 L flask under a nitrogen atmosphere, degassed under stirring, and thereafter heated till an internal temperature reached 80°C. The monomer-polymerization initiator solution was added thereto dropwise over 4 hours. Subsequently, the polymerization solution was continuously stirred for 16 hours while the temperature thereof was kept at 80°C, and then cooled to room temperature. The polymerization solution thus obtained was added dropwise to 1,500 g of vigorously stirred hexane, and a precipitated polymer was separated by filtration. Further, the obtained polymer was washed twice with 600 g of hexane, and then dried under vacuum at 50°C for 20 hours to obtain the white powdered comparative polymer (R4) (yield 96.5 g, 95%). The average polymer molecular weight (Mw) and dispersity (Mw/Mn) of the polymer (R4) were determined by GPC as follows: Mw=32,200 and Mw/Mn=1.80.

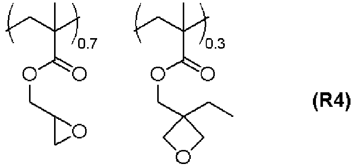

### [Comparative Synthesis Example 5] Synthesis of Comparative Polymer (R5)

Under a nitrogen atmosphere, 66.1 g of the monomer (B9), 33.9 g of the monomer (B16), 1.49 g of V-601, and 340 g of PGMEA were measured into a 1 L flask and then degassed under stirring, thereby preparing a monomer-polymerization initiator solution. 60 g of PGMEA was measured into another 1 L flask under a nitrogen atmosphere, degassed under stirring, and thereafter heated till an internal temperature reached 80°C. The monomer-polymerization initiator solution was added thereto dropwise over 4 hours. Subsequently, the polymerization solution was continuously stirred for 16 hours while the temperature thereof was kept at 80°C, and then cooled to room temperature. The polymerization solution thus obtained was added dropwise to 1,500 g of vigorously stirred hexane, and a precipitated polymer was separated by filtration. Further, the obtained polymer was washed twice with 600 g of hexane, and then dried under vacuum at 50°C for 20 hours to obtain the white powdered comparative polymer (R5) (yield 97.0 g, 96%). The average polymer molecular weight (Mw) and dispersity (Mw/Mn) of the polymer (R5) were determined by GPC as follows: Mw=31,200 and Mw/Mn=1.82.

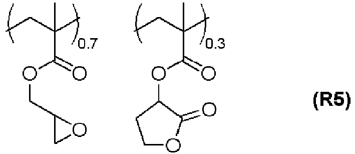

### [Comparative Synthesis Example 6] Synthesis of Comparative Polymer (R6)

The comparative polymer (R6) was synthesized according to the method described in paragraph [0136] of Patent Document 6.

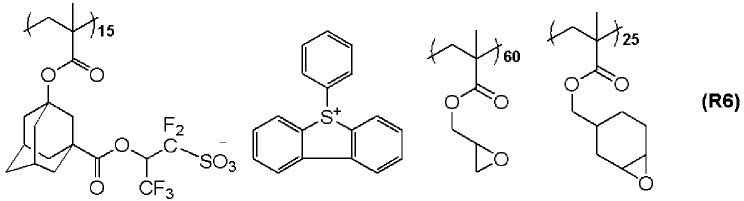

### [Comparative Synthesis Example 7] Synthesis of Comparative Polymer (R7)

The comparative polymer (R7) was synthesized according to the method described in paragraph [0155] of Patent Document 7.

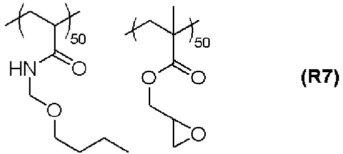

### Preparation of Adhesive Film Material (AL-1 to 33, Comparative AL-1 to 7)

The above-described polymers (A1) to (A24) and comparative polymers (R1) to (R7), and additives (AD1) to (AD7) as described below were dissolved using propylene glycol monomethyl ether acetate (PGMEA) containing 0.01 mass% of PF6320 (produced by OMNOVA Solutions Inc.), diacetone alcohol (DAA), or ethyl lactate (EL) in the proportions shown in Table 2, and thereafter filtered through a 0.1 µm filter made of a fluororesin, thereby respectively preparing adhesive film materials (AL-1 to 33, Comparative AL-1 to 7). Note that Comparative AL-7 was prepared to have the same composition as AL8 described in paragraph [0165] of Patent Document 7.

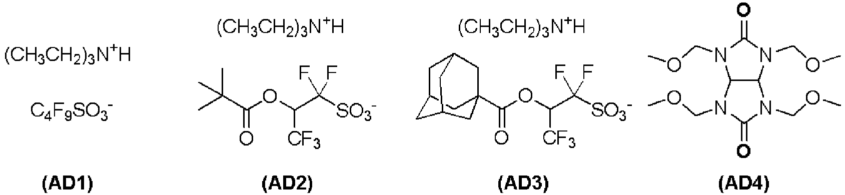

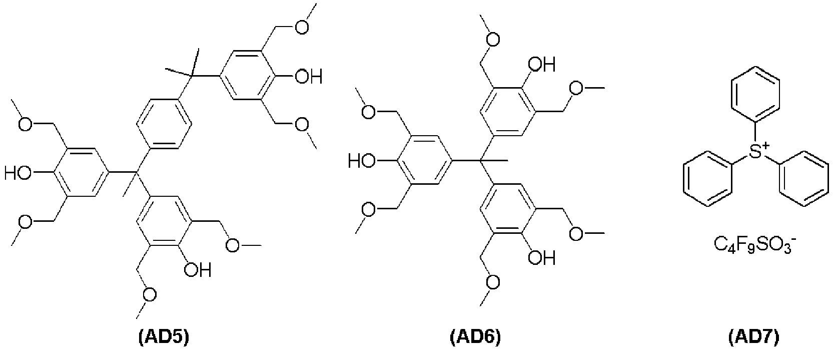

**[Table 2]**

| | Polymer | Additive 1 | Additive 2 | Solvent |
|---|---|---|---|---|
| AL-1 | (A1) [1.0] | (AD1) [0.01] | - | PGMEA[167],DAA[167] |
| AL-2 | (A1) [1.0] | (AD1) [0.01] | - | PGMEA[167],EL[167] |
| AL-3 | (A1) [1.0] | (AD1) [0.01] | - | PGMEA[40],DAA[40] |
| AL-4 | (A1) [1.0] | - | - | PGMEA[167],DAA[167] |
| AL-5 | (A1) [1.0] | (AD2) [0.01] | - | PGMEA[167],DAA[167] |
| AL-6 | (A1) [1.0] | (AD3) [0.01] | - | PGMEA[167],DAA[167] |
| AL-7 | (A1) [0.9] | (AD4) [0.1] | - | PGMEA[167],DAA[167] |
| AL-8 | (A1) [0.9] | (AD5) [0.1] | - | PGMEA[167],DAA[167] |
| AL-9 | (A1) [0.9] | (AD6) [0.1] | - | PGMEA[167],DAA[167] |
| AL-10 | (A1) [0.9] | (AD2) [0.01] | (AD6) [0.1] | PGMEA[167],DAA[167] |
| AL-11 | (A2) [1.0] | (AD3) [0.01] | - | PGMEA[167],DAA[167] |
| AL-12 | (A3) [1.0] | (AD3) [0.01] | - | PGMEA[167],DAA[167] |
| AL-13 | (A4) [1.0] | (AD3) [0.01] | - | PGMEA[167],DAA[167] |
| AL-14 | (A5) [1.0] | (AD3) [0.01] | - | PGMEA[167],DAA[167] |
| AL-15 | (A6) [1.0] | (AD3) [0.01] | - | PGMEA[167],DAA[167] |
| AL-16 | (A7) [1.0] | (AD3) [0.01] | - | PGMEA[167],DAA[167] |
| AL-17 | (A8) [1.0] | (AD3) [0.01] | - | PGMEA[167],DAA[167] |
| AL-18 | (A9) [1.0] | (AD3) [0.01] | - | PGMEA[167],DAA[167] |
| AL-19 | (A10) [1.0] | (AD3) [0.01] | - | PGMEA[167],DAA[167] |
| AL-20 | (A11) [1.0] | (AD3) [0.01] | - | PGMEA[167],DAA[167] |
| AL-21 | (A12) [1.0] | (AD3) [0.01] | - | PGMEA[167],DAA[167] |
| AL-22 | (A13) [1.0] | (AD3) [0.01] | - | PGMEA[167],DAA[167] |
| AL-23 | (A14) [1.0] | (AD3) [0.01] | - | PGMEA[167],DAA[167] |
| AL-24 | (A15) [1.0] | (AD3) [0.01] | - | PGMEA[167],DAA[167] |
| AL-25 | (A16) [1.0] | (AD3) [0.01] | - | PGMEA[167],DAA[167] |
| AL-26 | (A17) [1.0] | (AD3) [0.01] | - | PGMEA[167],DAA[167] |
| AL-27 | (A18) [1.0] | (AD3) [0.01] | - | PGMEA[167],DAA[167] |
| AL-28 | (A19) [1.0] | (AD3) [0.01] | - | PGMEA[167],DAA[167] |
| AL-29 | (A20) [1.0] | (AD3) [0.01] | - | PGMEA[167],DAA[167] |
| AL-30 | (A21) [1.0] | (AD3) [0.01] | - | PGMEA[167],DAA[167] |
| AL-31 | (A22) [1.0] | (AD3) [0.01] | - | PGMEA[167],DAA[167] |
| AL-32 | (A23) [1.0] | (AD3) [0.01] | - | PGMEA[167],DAA[167] |
| AL-33 | (A24) [1.0] | (AD3) [0.01] | - | PGMEA[167],DAA[167] |
| Comp.AL-1 | (R1) [1.0] | (AD3) [0.01] | - | PGMEA[167],DAA[167] |
| Comp.AL-2 | (R2) [1.0] | (AD3) [0.01] | - | PGMEA[167],DAA[167] |
| Comp.AL-3 | (R3) [1.0] | (AD3) [0.01] | - | PGMEA[167],DAA[167] |
| Comp.AL-4 | (R4) [1.0] | (AD3) [0.01] | - | PGMEA[167],DAA[167] |
| Comp.AL-5 | (R5) [1.0] | (AD3) [0.01] | - | PGMEA[167],DAA[167] |
| Comp.AL-6 | (R6) [1.0] | (AD3) [0.01] | - | PGMEA[167],DAA[167] |
| Comp.AL-7 | (R7) [1.0] | (AD1) [0.02] | (AD7) [0.04] | PGMEA[320] |

The respective components in Table 2 are as follows.

### Organic solvent:

PGMEA (propylene glycol monomethyl ether acetate)
DAA (diacetone alcohol)
EL (ethyl lactate)

### Example 1: Application Performance Test on Wafer with Various Films (Examples 1-1 to 1-33, Comparative Examples 1-1 to 1-7)

The above adhesive film materials (AL-1 to 33, Comparative AL-1 to 7) were respectively applied onto a substrate subjected to hexamethyldisilazane (HMDS) treatment at 120°C for 60 seconds, or a substrate on which a CVD-SiO₂, CVD-SiON, CVD-amorphous Si, CVD-amorphous carbon, or CVD-SiN film was formed, and baked at 250°C for 60 seconds to form an adhesive film having a film thickness of 5 nm (AL-1 to 2 and 4 to 33, Comparative AL-1 to 7) or a thickness of 20 nm (AL-3). Further, the film surface was then observed with an optical microscope to confirm presence/absence and the number of application errors. The results thereof are shown in Table 3. Incidentally, the notations in the table correspond to the following.
++: no abnormality
+: 1 to 5 pinhole-shaped application errors recognized
-: 6 to 10 pinhole-shaped application errors recognized
--: 11 or more pinhole-shaped application errors, or countless pinhole-shaped application errors occurred, making it impossible to form a film

**[Table 3]**

| | Material | HMDS-treated substrate | CVD-SiO₂ | CVD-SiON | CVD-SiN | CVD-amorphous Si | CVD-amorphous carbon |
|---|---|---|---|---|---|---|---|
| Ex.1-1 | AL-1 | ++ | ++ | ++ | ++ | ++ | ++ |
| Ex.1-2 | AL-2 | ++ | ++ | ++ | ++ | ++ | ++ |
| Ex.1-3 | AL-3 | ++ | ++ | ++ | ++ | ++ | ++ |
| Ex.1-4 | AL-4 | ++ | ++ | ++ | ++ | ++ | ++ |
| Ex.1-5 | AL-5 | ++ | ++ | ++ | ++ | ++ | ++ |
| Ex.1- 6 | AL-6 | ++ | ++ | ++ | ++ | ++ | ++ |
| Ex.1-7 | AL-7 | ++ | ++ | ++ | ++ | ++ | ++ |
| Ex.1-8 | AL-8 | ++ | ++ | ++ | ++ | ++ | ++ |
| Ex.1-9 | AL-9 | ++ | ++ | ++ | ++ | ++ | ++ |
| Ex.1-10 | AL-10 | ++ | ++ | ++ | ++ | ++ | ++ |
| Ex.1-11 | AL-11 | ++ | ++ | ++ | ++ | ++ | ++ |
| Ex.1-12 | AL-12 | ++ | ++ | ++ | ++ | ++ | ++ |
| Ex.1-13 | AL-13 | ++ | ++ | ++ | ++ | ++ | ++ |
| Ex.1-14 | AL-14 | ++ | ++ | ++ | ++ | ++ | ++ |
| Ex.1-15 | AL-15 | ++ | ++ | ++ | ++ | ++ | ++ |
| Ex.1-16 | AL-16 | ++ | ++ | + | + | ++ | + |
| Ex.1-17 | AL-17 | ++ | ++ | ++ | ++ | ++ | ++ |
| Ex.1-18 | AL-18 | ++ | ++ | ++ | ++ | ++ | ++ |
| Ex.1-19 | AL-19 | ++ | ++ | ++ | ++ | ++ | ++ |
| Ex.1-20 | AL-20 | ++ | ++ | ++ | ++ | ++ | ++ |
| Ex.1-21 | AL-21 | ++ | ++ | ++ | ++ | ++ | ++ |
| Ex.1-22 | AL-22 | ++ | ++ | ++ | ++ | ++ | ++ |
| Ex.1-23 | AL-23 | ++ | ++ | ++ | ++ | ++ | ++ |
| Ex.1-24 | AL-24 | ++ | ++ | ++ | ++ | ++ | ++ |
| Ex.1-25 | AL-25 | ++ | ++ | ++ | ++ | ++ | ++ |
| Ex.1-26 | AL-26 | ++ | ++ | ++ | ++ | ++ | ++ |
| Ex.1-27 | AL-27 | ++ | ++ | + | + | ++ | ++ |
| Ex.1-28 | AL-28 | ++ | ++ | ++ | ++ | ++ | ++ |
| Ex.1-29 | AL-29 | ++ | ++ | ++ | ++ | ++ | ++ |
| Ex.1-30 | AL-30 | ++ | ++ | ++ | ++ | ++ | ++ |
| Ex.1-31 | AL-31 | ++ | ++ | ++ | ++ | ++ | ++ |
| Ex.1-32 | AL-32 | ++ | ++ | ++ | ++ | ++ | ++ |
| Ex.1-33 | AL-33 | ++ | ++ | + | + | ++ | + |
| Comp.Ex. 1-1 | Comp. AL-1 | ++ | ++ | ++ | ++ | ++ | ++ |
| Comp.Ex. 1-2 | Comp. AL-2 | ++ | ++ | ++ | ++ | ++ | ++ |
| Comp.Ex. 1-3 | Comp. AL-3 | + | ++ | - | - | + | - |
| Comp.Ex. 1-4 | Comp. AL-4 | + | ++ | - | - | + | - |
| Comp.Ex. 1-5 | Comp. AL-5 | ++ | ++ | - | - | ++ | + |
| Comp.Ex. 1-6 | Comp. AL-6 | ++ | ++ | - | - | ++ | + |
| Comp.Ex. 1-7 | Comp. AL-7 | ++ | ++ | + | + | + | + |

As shown in Table 3, in Examples 1-1 to 1-33 respectively using the adhesive film materials (AL-1 to 33) as the composition for forming an adhesive film of the present invention, the results generally show the small number of pinhole-shaped application errors. In particular, it can be seen that those containing more structural units represented by the general formula (1) had especially excellent application performance. On the other hand, in Comparative Examples 1-3 to 1-6 respectively using Comparative AL-3 to 6 containing no structural unit represented by the general formula (1), the results show slightly poorer application performance than the others.

### Example 2: Application Performance Test on Silicon-Containing Resist Middle Layer Film (Examples 2-1 to 2-33, Comparative Examples 2-1 to 2-7)

SHB-A940 produced by Shin-Etsu Chemical Co., Ltd. as a silicon-containing resist middle layer film composition was applied onto a silicon wafer substrate and baked at 215°C for 60 seconds to form a silicon-containing resist middle layer film having a film thickness of 20 nm. Further, the above adhesive film materials (AL-1 to 33, Comparative AL-1 to 7) were respectively applied thereto and baked at 250°C for 60 seconds to form an adhesive film having a film thickness of 5 nm (AL-1 to 2 and 4 to 33, Comparative AL-1 to 7) or a thickness of 20 nm (AL-3). Thereafter, the film surface was observed with an optical microscope to confirm presence/absence and the number of application errors. The results thereof are shown in Table 4. Incidentally, the notations in the table correspond to the following.
++: no abnormality
+: 1 to 5 pinhole-shaped application errors recognized
-: 6 to 10 pinhole-shaped application errors recognized
--: 11 or more pinhole-shaped application errors, or countless pinhole-shaped application errors occurred, making it impossible to form a film

**[Table 4]**

| | Material | Application performance on SHB-A940 |
|---|---|---|
| Example 2-1 | AL-1 | ++ |
| Example 2-2 | AL-2 | ++ |
| Example 2-3 | AL-3 | ++ |
| Example 2-4 | AL-4 | ++ |
| Example 2-5 | AL-5 | ++ |
| Example 2-6 | AL-6 | ++ |
| Example 2-7 | AL-7 | ++ |
| Example 2-8 | AL-8 | ++ |
| Example 2-9 | AL-9 | ++ |
| Example 2-10 | AL-10 | ++ |
| Example 2-11 | AL-11 | ++ |
| Example 2-12 | AL-12 | ++ |
| Example 2-13 | AL-13 | ++ |
| Example 2-14 | AL-14 | ++ |
| Example 2-15 | AL-15 | ++ |
| Example 2-16 | AL-16 | + |
| Example 2-17 | AL-17 | ++ |
| Example 2-18 | AL-18 | ++ |
| Example 2-19 | AL-19 | ++ |
| Example 2-20 | AL-20 | ++ |
| Example 2-21 | AL-21 | ++ |
| Example 2-22 | AL-22 | ++ |
| Example 2-23 | AL-23 | ++ |
| Example 2-24 | AL-24 | ++ |
| Example 2-25 | AL-25 | ++ |
| Example 2-26 | AL-26 | ++ |
| Example 2-27 | AL-27 | + |
| Example 2-28 | AL-28 | ++ |
| Example 2-29 | AL-29 | ++ |
| Example 2-30 | AL-30 | ++ |
| Example 2-31 | AL-31 | ++ |
| Example 2-32 | AL-32 | ++ |
| Example 2-33 | AL-33 | + |
| Comparative Example 2-1 | Comparative AL-1 | ++ |
| Comparative Example 2-2 | Comparative AL-2 | ++ |
| Comparative Example 2-3 | Comparative AL-3 | -- |
| Comparative Example 2-4 | Comparative AL-4 | -- |
| Comparative Example 2-5 | Comparative AL-5 | - |
| Comparative Example 2-6 | Comparative AL-6 | - |
| Comparative Example 2-7 | Comparative AL-7 | + |

As shown in Table 4, Examples 2-1 to 2-33 respectively using the adhesive film materials (AL-1 to 33) as the composition for forming an adhesive film of the present invention exhibited good application performance even on the silicon-containing resist middle layer film. Moreover, in Comparative Examples 2-3 to 2-6 respectively using Comparative AL-3 to 6 containing no structure represented by the general formula (1), more application errors occurred as compared with other examples. Thus, it has been confirmed that introduction of this structural unit leads to improved application performance.

### Example 3: ArF Immersion Patterning Test (Examples 3-1 to 3-23, Comparative Examples 3-1 to 3-3)

Spin-on carbon ODL-301 (carbon content: 88 mass%) produced by Shin-Etsu Chemical Co., Ltd. was applied onto a silicon wafer substrate and baked at 350°C for 60 seconds to form a resist underlayer film having a film thickness of 200 nm. A CVD-SiON hard mask middle layer film was formed thereon, the above adhesive film materials (AL-1 to 6, 8, 10 to 16, 23 to 27, and 30 to 33, Comparative AL-1 to 2 and 7) were respectively further applied and baked at 250°C for 60 seconds to form an adhesive film having a film thickness of 5 nm (AL-1 to 2, 4 to 6, 8, 10 to 16, 23 to 27, and 30 to 33, Comparative AL-1 to 2 and 7) or a thickness of 20 nm (AL-3). A positive tone resist upper layer film material (single-layer resist for ArF) was applied thereto and baked at 105°C for 60 seconds to form a resist upper layer film having a film thickness of 100 nm. A liquid immersion topcoat material (TC-1) was applied onto the resist upper layer film and baked at 90°C for 60 seconds to form a topcoat having a film thickness of 50 nm.

The positive tone resist upper layer film material (single-layer resist for ArF) was prepared by dissolving a polymer (PRP-A1), an acid generator (PAG1), and a basic compound (Amine1) in a solvent containing 0.1 mass% of FC-430 (produced by Sumitomo 3M Limited) in the proportions shown in Table 5, and filtering the resultant through a 0.1 µm filter made of a fluororesin.

**[Table 5]**

| | Polymer (parts by mass) | Acid Generator (parts by mass) | Basic Compound (parts by mass) | Solvent (parts by mass) |
|---|---|---|---|---|
| Single-Layer Resist for ArF | PRP-A1 (100) | PAG1 (6.6) | Amine1 (0.8) | PGMEA (2500) |

### Polymer: PRP-A1

Molecular weight (Mw)=8,600
Dispersity (Mw/Mn)=1.88

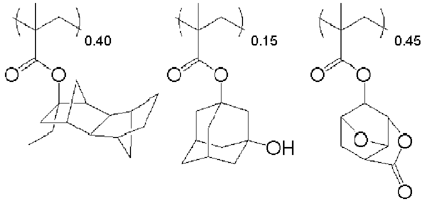

### Acid generator: PAG1

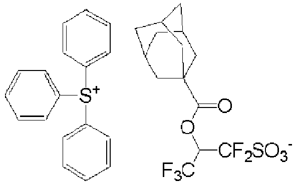

### Basic compound: Amine1

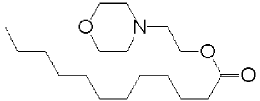

The liquid immersion topcoat material (TC-1) was prepared by dissolving a topcoat polymer (PP1) in an organic solvent in the proportions shown in Table 6 and filtering the resultant through a 0.1 µm filter made of a fluororesin.

**[Table 6]**

| | Topcoat Polymer (parts by mass) | Organic Solvent (parts by mass) |
|---|---|---|
| TC-1 | PP1 (100) | diisoamyl ether (2700) |
| | | 2-methyl-1-butanol (270) |

### Topcoat polymer: PP1

Molecular weight (Mw)=8,800
Dispersity (Mw/Mn)=1.69

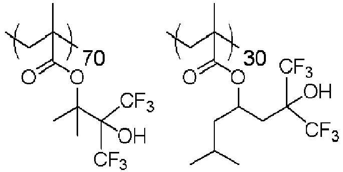

Next, the resist upper layer film was exposed using an ArF immersion lithography system (manufactured by Nikon Corporation; NSR-S610C, NA1.30, σ0.98/0.65, 35° s-polarized dipole illumination, 6% half-tone phase-shifting mask), baked (PEB) at 100°C for 60 seconds, and developed for 30 seconds using a 2.38 mass% tetramethylammonium hydroxide (TMAH) aqueous solution, thereby obtaining a 40 nm 1:1 line-and-space pattern. The cross section and roughness of this pattern were observed with an electron microscope. Furthermore, the minimum dimension at which the line would be resolved without collapsing was determined by increasing the exposure dose to narrow the line dimension, and reported as collapse limit (nm). The smaller value is preferable since it indicates higher collapse resistance.

The cross section and pattern roughness of the obtained pattern were evaluated respectively using an electron microscope (S-4700) manufactured by Hitachi Ltd. and an electron microscope (CG4000) manufactured by Hitachi High-Tech Corporation. The results thereof are shown in Table 7.

**[Table 7]**

| | Material | Pattern roughness (nm) | Collapse limit (nm) | Pattern cross section after development |
|---|---|---|---|---|
| Example 3-1 | AL-1 | 1.8 | 35 | Vertical profile |
| Example 3-2 | AL-2 | 1.8 | 36 | Vertical profile |
| Example 3-3 | AL-3 | 1.7 | 36 | Vertical profile |
| Example 3-4 | AL-4 | 1.6 | 35 | Vertical profile |
| Example 3-5 | AL-5 | 1.7 | 36 | Vertical profile |
| Example 3-6 | AL-6 | 1.6 | 35 | Vertical profile |
| Example 3-7 | AL-8 | 1.7 | 35 | Vertical profile |
| Example 3-8 | AL-10 | 1.9 | 36 | Vertical profile |
| Example 3-9 | AL-11 | 1.8 | 35 | Vertical profile |
| Example 3-10 | AL-12 | 1.7 | 36 | Vertical profile |
| Example 3-11 | AL-13 | 1.6 | 37 | Vertical profile |
| Example 3-12 | AL-14 | 1.7 | 35 | Vertical profile |
| Example 3-13 | AL-15 | 1.8 | 36 | Vertical profile |
| Example 3-14 | AL-16 | 1.8 | 35 | Vertical profile |
| Example 3-15 | AL-23 | 1.7 | 34 | Vertical profile |
| Example 3-16 | AL-24 | 1.6 | 36 | Vertical profile |
| Example 3-17 | AL-25 | 1.7 | 37 | Vertical profile |
| Example 3-18 | AL-26 | 1.7 | 37 | Vertical profile |
| Example 3-19 | AL-27 | 1.7 | 35 | Vertical profile |
| Example 3-20 | AL-30 | 1.8 | 34 | Vertical profile |
| Example 3-21 | AL-31 | 1.7 | 34 | Vertical profile |
| Example 3-22 | AL-32 | 1.6 | 35 | Vertical profile |
| Example 3-23 | AL-33 | 1.8 | 35 | Vertical profile |
| Comparative Example 3-1 | Comparative AL-1 | 2.1 | 35 | Footing profile |
| Comparative Example 3-2 | Comparative AL-2 | 2.0 | 36 | Footing profile |
| Comparative Example 3-3 | Comparative AL-7 | 1.9 | 35 | Vertical profile |

As shown in Table 7, in Examples 3-1 to 3-23 respectively using the adhesive film materials (AL-1 to 6, 8, 10 to 16, 23 to 27, and 30 to 33) as the composition for forming an adhesive film of the present invention, smaller pattern roughness and better pattern profile can be observed as compared with Comparative Examples. By focusing on the collapse limit, improvement can be observed in Examples 3-18 to 3-19 using the structural unit containing the phenolic hydroxy group, demonstrating contribution of this structure to collapse prevention performance.

### Example 4: EUV Exposure Patterning Test with Positive Tone Resist (Examples 4-1 to 4-15, Comparative Examples 4-1 to 4-4)

Spin-on carbon ODL-301 (carbon content: 88 mass%) produced by Shin-Etsu Chemical Co., Ltd. was applied onto a silicon wafer substrate and baked at 350°C for 60 seconds to form a resist underlayer film having a film thickness of 100 nm. A silicon-containing spin-on hard mask SHB-A940 (silicon content: 43 mass%) produced by Shin-Etsu Chemical Co., Ltd. was applied thereto, and baked at 215°C for 60 seconds to form a silicon-containing middle layer film having a film thickness of 15 nm. Further, the above adhesive film materials (AL-4, 5, 8, 10, 14 to 16, 23 to 29, and 32, Comparative AL-1, 2, and 7) were respectively applied and baked at 250°C for 60 seconds to form an adhesive film having a film thickness of 5 nm. A composition for forming a positive tone resist upper layer film (single-layer resist for EUV) was applied thereto and baked at 100°C for 60 seconds to form a resist upper layer film having a film thickness of 40 nm. Furthermore, a silicon-containing middle layer film was formed in the same manner as described above, and thereafter the composition for forming a positive tone resist upper layer film (single-layer resist for EUV) was also applied directly on the silicon-containing middle layer film without forming an adhesive film.

The composition for forming a positive tone resist upper layer film (single-layer resist for EUV) was prepared by dissolving a polymer compound PRP1 and a quencher Q1 in a solvent containing 0.1 mass% of FC-4430 (produced by Sumitomo 3M Limited) in the proportions shown in Table 8, and filtering the resultant through a 0.1 µm filter made of a fluororesin.

**[Table 8]**

| | Polymer compound (parts by mass) | Quencher (parts by mass) | Organic solvent (parts by mass) |
|---|---|---|---|
| Single-Layer Resist for EUV | PRP1 (100) | Q1 (0.25) | PGMEA/DAA (3,000/1,000) |

### Polymer compound: PRP1

Molecular weight (Mw)=9,200
Dispersity (Mw/Mn)=1.8

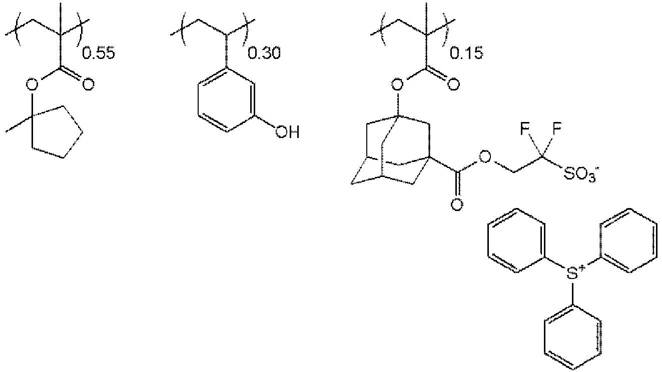

### Quencher: Q1

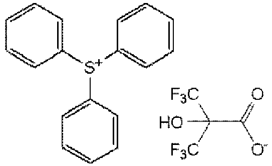

Next, the resist upper layer film was exposed using an EUV exposure system (EUV scanner NXE3400 manufactured by ASML Holdings N.V., NA0.33, σ0.9, 90° dipole illumination) to yield an 18 nm 1:1 line-and-space (LS) pattern, which was baked (PEB) at 90°C for 60 seconds and developed for 30 seconds with a 2.38 mass% tetramethylammonium hydroxide (TMAH) aqueous solution to obtain a line-and-space pattern with a space width of 18 nm and a pitch of 36 nm. The cross section and roughness of this pattern were observed with an electron microscope. Furthermore, collapse limit (nm) was defined as the minimum dimension at which the line would be resolved without collapsing. The minimum dimension was determined by gradually increasing the exposure dose from the exposure dose which results in formation of the above line-and-space pattern, and narrowing the line dimension. The smaller value is preferable since it indicates higher collapse resistance.

The cross section and pattern roughness of the obtained pattern were evaluated respectively using an electron microscope (S-4700) manufactured by Hitachi Ltd. and an electron microscope (CG6300) manufactured by Hitachi High-Tech Corporation. The results thereof are shown in Table 9. Note that in Comparative Example 4-4, patterning results are shown, which was performed by forming the silicon-containing middle layer film and thereafter applying the composition for forming a positive tone resist upper layer film (single-layer resist for EUV) directly onto the silicon-containing middle layer film without forming an adhesive film.

**[Table 9]**

| | Material | Pattern roughness (nm) | Collapse limit (nm) | Pattern cross section after development |
|---|---|---|---|---|
| Example 4-1 | AL-4 | 1.8 | 15 | Vertical profile |
| Example 4-2 | AL-5 | 1.9 | 16 | Vertical profile |
| Example 4-3 | AL-8 | 1.8 | 15 | Vertical profile |
| Example 4-4 | AL-10 | 1.9 | 15 | Vertical profile |
| Example 4-5 | AL-14 | 1.8 | 14 | Vertical profile |
| Example 4-6 | AL-15 | 1.8 | 16 | Vertical profile |
| Example 4-7 | AL-16 | 1.9 | 17 | Vertical profile |
| Example 4-8 | AL-23 | 1.9 | 15 | Vertical profile |
| Example 4-9 | AL-24 | 1.7 | 15 | Vertical profile |
| Example 4-10 | AL-25 | 1.7 | 16 | Vertical profile |
| Example 4-11 | AL-26 | 1.7 | 15 | Vertical profile |
| Example 4-12 | AL-27 | 1.8 | 16 | Vertical profile |
| Example 4-13 | AL-28 | 1.7 | 16 | Vertical profile |
| Example 4-14 | AL-29 | 1.7 | 15 | Vertical profile |
| Example 4-15 | AL-32 | 1.8 | 14 | Vertical profile |
| Comparative Example 4-1 | Comparative AL-1 | 2.5 | 16 | Footing profile |
| Comparative Example 4-2 | Comparative AL-2 | 2.2 | 16 | Slightly footing profile |
| Comparative Example 4-3 | Comparative AL-7 | 1.8 | 15 | Vertical profile |
| Comparative Example 4-4 | None | 2.4 | 17 | Slightly footing profile |

As shown in Table 9, in Examples 4-1 to 4-15 respectively using the adhesive film materials (AL-4, 5, 8, 10, 14 to 16, 23 to 29, and 32) as the composition for forming an adhesive film of the present invention, smaller pattern roughness and better pattern profile can be observed as compared with Comparative Examples. In Examples 4-9 to 4-11 respectively using AL-24 to 26 that contained an iodine atom in the structural unit containing the organic sulfonyl anion structure, and Examples 4-13 to 4-14 respectively using AL-28 to 29 in which the structural unit containing iodine was introduced, particularly small pattern roughness can be observed. Regarding Comparative Examples, Comparative Example 4-3 using Comparative AL-7 as the composition described in Patent Document 7 showed favorable results, while in Comparative Examples 4-1 and 4-2 respectively using Comparative AL-1 and 2 containing no organic sulfonyl anion structure, a footing profile of the pattern and also degraded pattern roughness were recognized. Moreover, in Comparative Example 4-4 where patterning was performed by applying the composition for forming a positive tone resist upper layer film (single-layer resist for EUV) directly onto the silicon-containing middle layer film, slight footing in the pattern profile and also high pattern roughness were recognized. Therefore, it has been confirmed that the four-layer resist process, to which the composition for forming an adhesive film of the present invention is applied, has improved patterning performance as compared with the three-layer resist process not using the composition.

### Example 5: EUV Exposure Patterning Test 2 with Positive Tone Resist (Examples 5-1 to 5-12, Comparative Examples 5-1 to 5-4)

Spin-on carbon ODL-301 (carbon content: 88 mass%) produced by Shin-Etsu Chemical Co., Ltd. was applied onto a silicon wafer substrate and baked at 350°C for 60 seconds to form a resist underlayer film having a film thickness of 100 nm. A silicon-containing spin-on hard mask SHB-A940 (silicon content: 43 mass%) produced by Shin-Etsu Chemical Co., Ltd. was applied thereto, and baked at 215°C for 60 seconds to form a silicon-containing middle layer film having a film thickness of 15 nm. Further, the above adhesive film materials (AL-14 to 16, 23 to 29, 32, and 33, Comparative AL-1, 2, and 7) were respectively applied and baked at 250°C for 60 seconds to form an adhesive film having a film thickness of 5 nm. A composition-(2) for forming a positive tone resist upper layer film was applied thereto and baked at 105°C for 60 seconds to form a resist upper layer film having a film thickness of 50 nm. Furthermore, a silicon-containing middle layer film was formed in the same manner as described above, and thereafter the composition-(2) for forming a positive tone resist upper layer film was also applied directly onto the silicon-containing middle layer film without forming an adhesive film.

The composition-(2) for forming a positive tone resist upper layer film (single-layer resist for EUV) was prepared by dissolving a polymer compound PRP2, a thermal acid generator PAG2, and a quencher Q2 in propylene glycol monomethyl ether acetate (PGMEA) containing 0.01 mass% of PF636 (produced by OMNOVA Solutions Inc.) and a diacetone alcohol (DAA) solvent in the proportions shown in Table 10, and filtering the resultant through a 0.1 µm filter made of a fluororesin.

**[Table 10]**

| | Polymer compound (parts by mass) | Thermal Acid Generator (parts by mass) | Quencher (parts by mass) | Organic solvent (parts by mass) |
|---|---|---|---|---|
| Composition-(2) for forming a positive tone resist upper layer film | PRP2 (10) | PAG2 (2.57) | Q2 (0.458) | PGMEA(200) |
| | | | | DAA(50) |

### Polymer compound: PRP2

Molecular weight (Mw)=5,200
Dispersity (Mw/Mn)=1.45

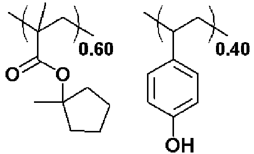

### Thermal acid generator: PAG2

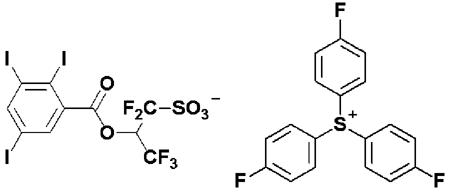

### Quencher: Q2

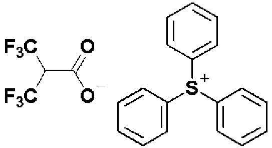

Next, the resist upper layer film was exposed using an EUV scanner NXE3400 (NA 0.33, σ0.9/0.6, quadrupole illumination, a hole pattern mask at a pitch 44 nm on-wafer size and +20% bias) manufactured by ASML Holdings N.V., subjected to PEB on a hot plate at 80°C for 60 seconds, and developed for 30 seconds using a 2.38 mass% TMAH aqueous solution, thereby forming a hole pattern with a size of 20 nm. The cross section and CDU of this pattern were observed with an electron microscope. Note that at the exposure dose resulting in hole formation with a size of 20 nm, the size of 50 holes was measured, and based on the results thereof, three times (3σ) the standard deviation (σ) was calculated and reported as CDU.

The cross section and CDU of the obtained pattern were evaluated respectively using an electron microscope (S-4700) manufactured by Hitachi Ltd. and an electron microscope (CG6300) manufactured by Hitachi High-Tech Corporation. The results thereof are shown in Table 11.

**[Table 11]**

| | Material | CDU (nm) | Pattern cross section after development |
|---|---|---|---|
| Example 5-1 | AL-14 | 3.5 | Vertical profile |
| Example 5-2 | AL-15 | 3.5 | Vertical profile |
| Example 5-3 | AL-16 | 3.4 | Vertical profile |
| Example 5-4 | AL-23 | 3.5 | Vertical profile |
| Example 5-5 | AL-24 | 3.3 | Vertical profile |
| Example 5-6 | AL-25 | 3.2 | Vertical profile |
| Example 5-7 | AL-26 | 3.2 | Vertical profile |
| Example 5-8 | AL-27 | 3.5 | Vertical profile |
| Example 5-9 | AL-28 | 3.3 | Vertical profile |
| Example 5-10 | AL-29 | 3.3 | Vertical profile |
| Example 5-11 | AL-32 | 3.4 | Vertical profile |
| Example 5-12 | AL-33 | 3.5 | Vertical profile |
| Comparative Example 5-1 | Comparative AL-1 | 4.4 | Footing profile |
| Comparative Example 5-2 | Comparative AL-2 | 3.8 | Footing profile |
| Comparative Example 5-3 | Comparative AL-7 | 3.9 | Footing profile |
| Comparative Example 5-4 | None | 4.0 | Footing profile |

As shown in Table 11, in Examples 5-1 to 5-12 respectively using the adhesive film materials (AL-14 to 16, 23 to 29, 32, and 33) as the composition for forming an adhesive film of the present invention, smaller CDU and better pattern profile can be observed as compared with Comparative Examples. In Examples 5-5 to 5-7 respectively using AL-24 to 26 that contained an iodine atom in the structural unit containing the organic sulfonyl anion structure, and Examples 5-9 to 5-10 respectively using AL-28 to 29 in which the structural unit containing iodine was introduced, particularly small CDU can be observed. Regarding Comparative Examples, also in Comparative Example 5-3 using Comparative AL-7, which was the composition described in Patent Document 7 and showed good results in Comparative Example 4-3, footing profile of the pattern was recognized. Thus, it has been confirmed that the organic sulfonyl anion structure is effective for improving the footing profile of the pattern. Moreover, in Comparative Example 5-4 where patterning was performed by applying the composition for forming a positive tone resist upper layer film directly onto the silicon-containing middle layer film, the pattern had a footing profile and CDU was also large. Thus, it has been confirmed that the four-layer resist process, to which the composition for forming an adhesive film of the present invention is applied, has greatly improved patterning performance as compared with the three-layer resist process not using the composition.

### Example 6: Electron Beam Patterning Test (Examples 6-1 to 6-12, Comparative Examples 6-1 to 6-3)

The above adhesive film materials (AL-14 to 16, 23 to 29, 32, and 33, Comparative AL-1, 6, and 7) were respectively applied onto a silicon wafer substrate and baked at 250°C for 60 seconds to form an adhesive film having a film thickness of 5 nm. A resist upper layer film material (metal-containing resist) was applied thereto and baked at 180°C for 60 seconds to form a resist upper layer film having a film thickness of 50 nm.

The resist upper layer film material (metal-containing resist) was prepared by dissolving a titanium-containing compound (AM-1) and a metal salt sensitizer (S-1) in 4-methyl-2-pentanol (MIBC) containing 0.1 mass% of FC-4430 (produced by Sumitomo 3M Ltd.) in the proportions shown in Table 12, and filtering the resultant through a 0.1 µm filter made of a fluororesin.

**[Table 12]**

| | Titanium-containing compound (parts by mass) | Metal salt sensitizer (parts by mass) | Organic solvent (parts by mass) |
|---|---|---|---|
| Metal-containing resist | AM-1 (10) | S-1 (0.1) | MIBC (250) |

### Synthesis of Titanium-Containing Compound (AM-1)

To a solution of 284 g of titanium tetraisopropoxide (available from Tokyo Chemical Industry Co., Ltd.) in 500 g of 2-propanol (IPA), a solution of 27 g of deionized water in 500 g of IPA was dropped in while stirring at room temperature over 2 hours. To the obtained solution, 180 g of 2,4-dimethyl-2,4-octanediol was added, and this was stirred at room temperature for 30 minutes. This solution was concentrated at 30°C under reduced pressure, then was further heated to 60°C, and kept heated under reduced pressure until a distillate was no longer obtained. When the distillate was no longer observed, 1,200 g of 4-methyl-2-pentanol (MIBC) was added, and this was heated at 40°C under reduced pressure until the IPA distillate was no longer obtained to afford 1,000 g (compound concentration: 25 mass%) of a solution of a titanium-containing compound AM-1 in MIBC. The molecular weight of the solution was measured in terms of polystyrene to find that Mw = 1,200.

### Metal salt sensitizer: S-1

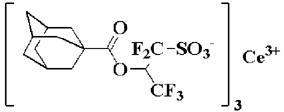

Next, drawing was performed in a vacuum chamber at an acceleration voltage of 50 kV by using JBX-9000MV (manufactured by JEOL Ltd.). Immediately after the drawing, baking (PEB) was performed at 200°C for 60 seconds, and puddle development was performed with butyl acetate for 20 seconds to obtain a negative pattern.

The obtained negative pattern was evaluated as follows. The exposure dose available for resolution of a 100 nm 1:1 line-and-space (LS) was defined as the sensitivity. The collapse limit (nm) was defined as the minimum dimension at which the line would be resolved without collapsing at the exposure dose. The smaller value is preferable since it indicates higher collapse resistance. The results thereof are shown in Table 13.

**[Table 13]**

| | Material | Collapse limit (nm) |
|---|---|---|
| Example 6-1 | AL-14 | 40 |
| Example 6-2 | AL-15 | 39 |
| Example 6-3 | AL-16 | 40 |
| Example 6-4 | AL-23 | 40 |
| Example 6-5 | AL-24 | 38 |
| Example 6-6 | AL-25 | 40 |
| Example 6-7 | AL-26 | 39 |
| Example 6-8 | AL-27 | 40 |
| Example 6-9 | AL-28 | 40 |
| Example 6-10 | AL-29 | 39 |
| Example 6-11 | AL-32 | 38 |
| Example 6-12 | AL-33 | 40 |
| Comparative Example 6-1 | Comparative AL-1 | 50 |
| Comparative Example 6-2 | Comparative AL-6 | 45 |
| Comparative Example 6-3 | Comparative AL-7 | 43 |

As shown in Table 13, Examples 6-1 to 6-12 respectively using the adhesive film materials (AL-14 to 16, 23 to 29, 32, and 33) as the composition for forming an adhesive film of the present invention had smaller collapse limit values as compared with Comparative Examples 6-1 to 6-3 respectively using Comparative AL-1, 6, and 7. This is considered to result from interaction between the nitrogen-hydrogen bond in the structure represented by the general formula (1) and the metal oxide in the metal-containing resist pattern. Accordingly, it has been confirmed that the present invention can suitably be used also in a lithography process of a metal-containing resist.

Accordingly, the composition for forming an adhesive film of the present invention exhibits favorable application performance even on a hydrophobic underlayer film, and at the same time, can form an adhesive film having favorable pattern collapse prevention performance and ability to remove a residual resist at a bottom of a pattern. Therefore, the composition for forming an adhesive film of the present invention is extremely useful as a composition for forming an adhesive film to be used for a multilayer resist method. Moreover, the patterning process of the present invention using the composition is capable of forming a fine pattern in a substrate to be processed with high precision.

The present description includes the following embodiments.
[1]: A composition for forming an adhesive film, comprising:
   (A) a resin containing a repeating unit represented by the following general formula (1) and a repeating unit having an organic sulfonyl anion structure; and
   (B) an organic solvent, 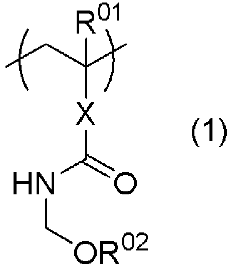 wherein X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.
[2]: The composition for forming an adhesive film according to the above [1], wherein a proportion of the repeating unit represented by the general formula (1) is 70 mol% or more and 99.9 mol% or less relative to whole repeating units in the resin (A).
[3]: The composition for forming an adhesive film according to the above [1] or [2], wherein a proportion of the repeating unit having the organic sulfonyl anion structure is 0.1 mol% or more and 30 mol% or less relative to whole repeating units in the resin (A).
[4]: The composition for forming an adhesive film according to any one of the above [1] to [3], wherein the resin (A) has a weight average molecular weight of 1,000 to 70,000.
[5]: The composition for forming an adhesive film according to any one of the above [1] to [4], wherein the organic solvent (B) is a mixture of one or more kinds of organic solvents having a boiling point of lower than 150°C and one or more kinds of organic solvents having a boiling point of 150°C or higher and lower than 220°C.
[6]: The composition for forming an adhesive film according to any one of the above [1] to [5], further comprising at least one or more selected from (C) a thermal acid generator, (D) a surfactant, and (E) a crosslinking agent.
[7]: A patterning process for forming a pattern in a substrate to be processed, comprising the steps of:
   (I-1) applying the composition for forming an adhesive film according to any one of the above [1] to [6] on the substrate to be processed and thereafter performing heat treatment to form an adhesive film;
   (I-2) forming a resist upper layer film on the adhesive film using a photoresist material;
   (I-3) forming a circuit pattern in the resist upper layer film by developing the resist upper layer film using a developer after pattern exposure;
   (I-4) transferring a pattern to the adhesive film by dry etching while using the resist upper layer film having the formed circuit pattern as a mask; and
   (I-5) processing the substrate to be processed while using the resist upper layer film and/or the adhesive film having the formed pattern as a mask to form a pattern in the substrate to be processed.
[8]: A patterning process for forming a pattern in a substrate to be processed, comprising the steps of:
   (II-1) forming a resist underlayer film on the substrate to be processed;
   (II-2) forming a silicon-containing resist middle layer film on the resist underlayer film;
   (II-3) applying the composition for forming an adhesive film according to any one of the above [1] to [6] on the silicon-containing resist middle layer film and thereafter performing heat treatment to form an adhesive film;
   (II-4) forming a resist upper layer film on the adhesive film using a photoresist material;
   (II-5) forming a circuit pattern in the resist upper layer film by developing the resist upper layer film using a developer after pattern exposure;
   (II-6) transferring a pattern to the adhesive film by dry etching while using the resist upper layer film having the formed circuit pattern as a mask;
   (II-7) transferring a pattern to the silicon-containing resist middle layer film by dry etching while using the resist upper layer film and/or the adhesive film having the formed pattern as a mask;
   (II-8) transferring a pattern to the resist underlayer film by dry etching while using the silicon-containing resist middle layer film having the transferred pattern as a mask; and
   (II-9) processing the substrate to be processed while using the resist underlayer film having the transferred pattern as a mask to form a pattern in the substrate to be processed.
[9]: A patterning process for forming a pattern in a substrate to be processed, comprising the steps of:
   (III-1) forming a resist underlayer film on the substrate to be processed;
   (III-2) forming an inorganic hard mask middle layer film selected from a silicon oxide film, a silicon nitride film, and a silicon oxynitride film on the resist underlayer film;
   (III-3) applying the composition for forming an adhesive film according to any one of the above [1] to [6] on the inorganic hard mask middle layer film and thereafter performing heat treatment to form an adhesive film;
   (III-4) forming a resist upper layer film on the adhesive film using a photoresist material;
   (III-5) forming a circuit pattern in the resist upper layer film by developing the resist upper layer film using a developer after pattern exposure;
   (III-6) transferring a pattern to the adhesive film by dry etching while using the resist upper layer film having the formed circuit pattern as a mask;
   (III-7) transferring a pattern to the inorganic hard mask middle layer film by dry etching while using the resist upper layer film and/or the adhesive film having the formed pattern as a mask;
   (III-8) transferring a pattern to the resist underlayer film by dry etching while using the inorganic hard mask middle layer film having the transferred pattern as a mask; and
   (III-9) processing the substrate to be processed while using the resist underlayer film having the transferred pattern as a mask to form a pattern in the substrate to be processed.
[10]: The patterning process according to the above [9], wherein the inorganic hard mask middle layer film is formed by a CVD or ALD method.
[11]: The patterning process according to any one of the above [7] to [10], wherein the circuit pattern is formed in the resist upper layer film by using photolithography with a wavelength of 10 nm or more and 300 nm or less, direct drawing using an electron beam, nanoimprinting, or a combination thereof.
[12]: The patterning process according to any one of the above [7] to [11], wherein the photoresist material contains at least an organometallic compound and a solvent.
[13]: The patterning process according to any one of the above [7] to [12], wherein the developing is performed by alkaline development or development with an organic solvent.
[14]: The patterning process according to any one of the above [7] to [13], wherein the substrate to be processed is a semiconductor apparatus substrate or the semiconductor apparatus substrate coated with any of a metal film, a metal carbide film, a metal oxide film, a metal nitride film, a metal oxycarbide film, and a metal oxynitride film.
[15]: The patterning process according to the above [14], wherein the metal is silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.
[16]: A method for forming an adhesive film to be used in a manufacturing process of a semiconductor apparatus, the method comprising: spin-coating a substrate to be processed with the composition for forming an adhesive film according to any one of the above [1] to [6]; and forming an adhesive film by heating the substrate coated with the composition for forming an adhesive film at a temperature of 100°C or higher and 300°C or lower for 10 to 600 seconds.
[17]: A method for forming an adhesive film to be used in a manufacturing process of a semiconductor apparatus, the method comprising: spin-coating a substrate to be processed with the composition for forming an adhesive film according to any one of the above [1] to [6]; and forming an adhesive film by heating the substrate coated with the composition for forming an adhesive film under an atmosphere with an oxygen concentration of 0.1% or more and 21% or less.
[18]: A method for forming an adhesive film to be used in a manufacturing process of a semiconductor apparatus, the method comprising: spin-coating a substrate to be processed with the composition for forming an adhesive film according to any one of the above [1] to [6]; and forming an adhesive film by heating the substrate coated with the composition for forming an adhesive film under an atmosphere with an oxygen concentration of 0.0001% or more and less than 0.1%.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming an adhesive film, comprising:
(A) a resin containing a repeating unit represented by the following general formula (1) and a repeating unit having an organic sulfonyl anion structure; and
(B) an organic solvent, 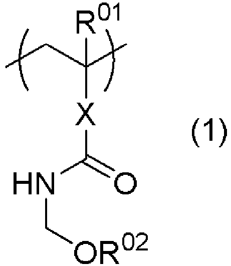 wherein X represents a single bond or an aromatic ring having 20 or less carbon atoms; R⁰¹ represents a hydrogen atom or a methyl group; R⁰² represents a hydrogen atom or a monovalent alkyl group having 1 to 10 carbon atoms, and when R⁰² represents an alkyl group, a hydrogen atom constituting the alkyl group is optionally substituted with a hydroxy group.

2. The composition for forming an adhesive film according to claim 1,
wherein a proportion of the repeating unit represented by the general formula (1) is 70 mol% or more and 99.9 mol% or less relative to whole repeating units in the resin (A); and/or
wherein a proportion of the repeating unit having the organic sulfonyl anion structure is 0.1 mol% or more and 30 mol% or less relative to whole repeating units in the resin (A); and/or
wherein the resin (A) has a weight average molecular weight of 1,000 to 70,000; and/or
wherein the organic solvent (B) is a mixture of one or more kinds of organic solvents having a boiling point of lower than 150°C and one or more kinds of organic solvents having a boiling point of 150°C or higher and lower than 220°C.

3. The composition for forming an adhesive film according to claim 1 or 2, further comprising at least one or more selected from (C) a thermal acid generator, (D) a surfactant, and (E) a crosslinking agent.

4. A patterning process for forming a pattern in a substrate to be processed, comprising the steps of:
(I-1) applying the composition for forming an adhesive film according to any one of claims 1 to 3 on the substrate to be processed and thereafter performing heat treatment to form an adhesive film;
(I-2) forming a resist upper layer film on the adhesive film using a photoresist material;
(I-3) forming a circuit pattern in the resist upper layer film by developing the resist upper layer film using a developer after pattern exposure;
(I-4) transferring a pattern to the adhesive film by dry etching while using the resist upper layer film having the formed circuit pattern as a mask; and
(I-5) processing the substrate to be processed while using the resist upper layer film and/or the adhesive film having the formed pattern as a mask to form a pattern in the substrate to be processed.

5. A patterning process for forming a pattern in a substrate to be processed, comprising the steps of:
(II-1) forming a resist underlayer film on the substrate to be processed;
(II-2) forming a silicon-containing resist middle layer film on the resist underlayer film;
(II-3) applying the composition for forming an adhesive film according to any one of claims 1 to 3 on the silicon-containing resist middle layer film and thereafter performing heat treatment to form an adhesive film;
(II-4) forming a resist upper layer film on the adhesive film using a photoresist material;
(II-5) forming a circuit pattern in the resist upper layer film by developing the resist upper layer film using a developer after pattern exposure;
(II-6) transferring a pattern to the adhesive film by dry etching while using the resist upper layer film having the formed circuit pattern as a mask;
(II-7) transferring a pattern to the silicon-containing resist middle layer film by dry etching while using the resist upper layer film and/or the adhesive film having the formed pattern as a mask;
(II-8) transferring a pattern to the resist underlayer film by dry etching while using the silicon-containing resist middle layer film having the transferred pattern as a mask; and
(II-9) processing the substrate to be processed while using the resist underlayer film having the transferred pattern as a mask to form a pattern in the substrate to be processed.

6. A patterning process for forming a pattern in a substrate to be processed, comprising the steps of:
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the composition for forming an adhesive film according to any one of claims 1 to 3 on the inorganic hard mask middle layer film and thereafter performing heat treatment to form an adhesive film;
(III-4) forming a resist upper layer film on the adhesive film using a photoresist material;
(III-5) forming a circuit pattern in the resist upper layer film by developing the resist upper layer film using a developer after pattern exposure;
(III-6) transferring a pattern to the adhesive film by dry etching while using the resist upper layer film having the formed circuit pattern as a mask;
(III-7) transferring a pattern to the inorganic hard mask middle layer film by dry etching while using the resist upper layer film and/or the adhesive film having the formed pattern as a mask;
(III-8) transferring a pattern to the resist underlayer film by dry etching while using the inorganic hard mask middle layer film having the transferred pattern as a mask; and
(III-9) processing the substrate to be processed while using the resist underlayer film having the transferred pattern as a mask to form a pattern in the substrate to be processed.

7. The patterning process according to claim 6, wherein the inorganic hard mask middle layer film is formed by a CVD or ALD method.

8. The patterning process according to any one of claims 4 to 7, wherein the circuit pattern is formed in the resist upper layer film by using photolithography with a wavelength of 10 nm or more and 300 nm or less, direct drawing using an electron beam, nanoimprinting, or a combination thereof.

9. The patterning process according to any one of claims 4 to 8, wherein the photoresist material contains at least an organometallic compound and a solvent.

10. The patterning process according to any one of claims 4 to 9, wherein the developing is performed by alkaline development or development with an organic solvent.

11. The patterning process according to any one of claims 4 to 10, wherein the substrate to be processed is a semiconductor apparatus substrate or the semiconductor apparatus substrate coated with any of a metal film, a metal carbide film, a metal oxide film, a metal nitride film, a metal oxycarbide film, and a metal oxynitride film.

12. The patterning process according to claim 11, wherein the metal is silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

13. A method for forming an adhesive film to be used in a manufacturing process of a semiconductor apparatus, the method comprising: spin-coating a substrate to be processed with the composition for forming an adhesive film according to any one of claims 1 to 3; and forming an adhesive film by heating the substrate coated with the composition for forming an adhesive film at a temperature of 100°C or higher and 300°C or lower for 10 to 600 seconds.

14. A method for forming an adhesive film to be used in a manufacturing process of a semiconductor apparatus, the method comprising: spin-coating a substrate to be processed with the composition for forming an adhesive film according to any one of claims 1 to 3; and forming an adhesive film by heating the substrate coated with the composition for forming an adhesive film under an atmosphere with an oxygen concentration of 0.1% or more and 21% or less.

15. A method for forming an adhesive film to be used in a manufacturing process of a semiconductor apparatus, the method comprising: spin-coating a substrate to be processed with the composition for forming an adhesive film according to any one of claims 1 to 3; and forming an adhesive film by heating the substrate coated with the composition for forming an adhesive film under an atmosphere with an oxygen concentration of 0.0001% or more and less than 0.1%.
